(19) Europäisches Patentamt
European Patent Office
Office européen des brevets

(11) EP 3 396 487 B1

(12) **EUROPEAN PATENT SPECIFICATION**

(45) Date of publication and mention of the grant of the patent:
**13.03.2019 Bulletin 2019/11**

(51) Int Cl.:
***G05D 1/08*** *(2006.01)* ***G01M 9/08*** *(2006.01)*
***G06F 17/50*** *(2006.01)* ***B64C 17/00*** *(2006.01)*

(21) Application number: **17382226.3**

(22) Date of filing: **27.04.2017**

(54) **COMPUTER-IMPLEMENTED METHOD AND SYSTEM FOR MODELLING PERFORMANCE OF A FIXED-WING AERIAL VEHICLE WITH SIX DEGREES OF FREEDOM**

COMPUTER-IMPLEMENTIERTES VERFAHREN UND SYSTEM ZUR MODELLIERUNG DER LEISTUNG EINES STARRFLÜGELLUFTFAHRZEUGS MIT SECHS FREIHEITSGRADEN

PROCÉDÉ ET SYSTÈME MIS EN OEUVRE PAR ORDINATEUR PERMETTANT DE MODÉLISER LES PERFORMANCES D'UN VÉHICULE AÉRIEN À AILES FIXES AYANT SIX DEGRÉS DE LIBERTÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**31.10.2018 Bulletin 2018/44**

(73) Proprietor: **The Boeing Company**
**Chicago, IL 60606-2016 (US)**

(72) Inventors:
- **GALLO, EDUARDO**
**28042 MADRID (ES)**
- **NAVARRO, FRANCISCO**
**28042 MADRID (ES)**

(74) Representative: **Carvajal y Urquijo, Isabel et al**
**Clarke, Modet & Co.**
**Suero de Quiñones, 34-36**
**28002 Madrid (ES)**

(56) References cited:
**EP-A1- 2 040 137**
**CN-A- 102 592 007**
**CN-B- 102 393 200**
**IL-A- 163 541**
**US-A1- 2015 203 215**
**US-A1- 2016 238 481**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

### FIELD

The present disclosure relates to improvements in aircraft performance models (APMs) used by aircraft trajectory predictors and air traffic simulators in Air Traffic Management (ATM).

### BACKGROUND

An Aircraft Performance Model (APM) is a mathematical representation of the aerodynamic and propulsive forces and moments as well as the fuel consumption produced by an aircraft during flight. According to the degrees of freedom (DOF) there are 3DOF APMs that provide only the aerodynamic and propulsive forces and 6DOF APMs that add the moments around its center of gravity. Although both of them may be valid for trajectory prediction, the former implicitly assume certain simplifications, such as symmetric flight and average control surface positions, and hence result in less accurate results.

Proper APMs should take into account atmospheric conditions, airspeed, aircraft attitude, aircraft mass and its inertia tensor. Advanced trajectory modelling flight planning, mission control and traffic simulation capabilities rely on APMs. Therefore, it is of great importance to have an accurate APM for recreate aircraft flight and the environment in which an aircraft may fly.

Research, design and development of aircrafts and components may also benefit from high fidelity APMs to ensure an adequate match between the structure (load capability, deformation under stress), the aerodynamic and propulsive loads (forces and moments modeled by the APM), and the aircraft stability, maneuverability, and control. In addition, a very accurate APM has been identified as a potential aid to the aircraft control and navigation systems that can significantly improve their performances. However, generation of an accurate six degrees of freedom (6DOF) APM is an intensive process in terms of time, costs and physical facilities.

Regarding low SWaP (Size, Weight, and Power) aircrafts, it is often beneficial for the manufacturer to avoid or at least simplify on the APM at the expense of a less optimized aircraft overall design and less accurate flight simulation capabilities. Particularly, for the above reasons, there are few suitable APMs for low SWaP Unmanned Air Systems (UAS). Employing generic models is an alternative but results in a significant reduction of accuracy simulation or trajectory prediction activities that poses a significant impediment to be used in civil airspace.

### SUMMARY

In view of the above shortcomings, there is a need for a solution to provide an accurate and cost-efficient APM. The present disclosure aims at a method and a system for modelling performance with six degrees of freedom of a fixed-wing aerial vehicle (AV) capable of reproducing real world effects. In particular, how a fixed-wing AV may respond to certain flight controls or may reacts to external factors.

Generally speaking, the present disclosure concerns steps for performing maneuvers and steps for efficiently collecting data from said maneuvers. Also, there are steps for making appropriate assumptions and calculating APM features. Additionally, there may be steps for confirming whether a certain APM feature is sufficiently well modeled or requires further maneuvers.

A value of this disclosure lays on an improved accuracy and a proper coverage of the flight envelope, which paves the way into enabling advanced control approaches such as model-predictive control (MPC). MPC exploits accurate knowledge of the AV performance to optimally design the control response.

Aside from that value, the APM obtained by using the present teachings may potentially be used not only for high-fidelity simulation and trajectory prediction supporting operational decision making, but also to support the actual trajectory execution (flight control) process.

Another aspect of the present teachings is that they significantly improve accuracy while saving time and costs.

Further objects and advantages of the present invention will be apparent from the following detailed description, reference being made to the accompanying drawings wherein preferred embodiments are clearly illustrated.

### BRIEF DESCRIPTION OF THE DRAWINGS

A series of drawings which aid in better understanding the disclosure and which are presented as non-limiting examples and are very briefly described below.

FIG. 1 illustrates a three-dimensional system used to define the orientation of an aircraft.
FIG. 2 illustrates a flow diagram depicting one embodiment of the disclosed method.

FIG. 3 illustrates a block system according to an embodiment of the disclosed system.

## DETAILED DESCRIPTION

For the purposes of explanation, specific details are set forth in order to provide a thorough understanding of the present disclosure. However, it is apparent to one skilled in the art that the present disclosure may be practiced without these specific details or with equivalent arrangements.

**FIG. 1** illustrates the body fixed system (BFS) of a fixed-wing aerial vehicle (AV) 100. A three-dimensional coordinate system is defined through the center of gravity (CoG) with each axis of this coordinate system perpendicular to the other two axes. The AV **100** typically includes a body or fuselage **102**, fixed wings **104** that are coupled to the fuselage **102** and a tail **105** that includes a horizontal stabilizer **106** and a vertical stabilizer **108**. The AV **100** can rotate about three axes, namely, a longitudinal x-axis **110**, a lateral y-axis **112**, and a vertical or directional z-axis **114**. Roll, pitch and yaw refer to rotations of the AV **100** about the respective axes **110**, **112**, **114**. Pitch refers to the rotation (nose up or down) of the AV **100** about the lateral y-axis **112**, roll refers to the rotation of the **AV 100** about the longitudinal x-axis **110**, and yaw refers to the rotation of the **AV 100** about the vertical or directional z-axis **114.**

An AV **100** typically include four controls, namely throttle, elevator **116**, ailerons **124**, and vertical rudder **118**. Throttle is used to operate the engines **134** and generate a forward force. Control surfaces: elevator **116**, ailerons **124** and vertical rudder **118** allow to aerodynamically control the AV **100** for a stable flight.

Elevator **116** is used to raise or lower the nose of the AV **100.** Ailerons **124** are located on the outside of the wings **104** and are used to rotate AV **100.** The ailerons **124** move anti-symmetrically (i.e. one goes up, the one on the opposite side low). Vertical rudder **118** is used so that the aircraft does not skid.

It is assumed that the AV **100** is equipped with an aircraft flight control system. The AV **100** may be commanded with the flight control system to automatically perform certain maneuvers and collect data (via telemetry) in real time that serve to generate an APM. At least some of these tasks may be coded in a computer program. Some of these computer program instructions, when running, may steer the AV **100** to perform modelling maneuvers. Said maneuvers advantageously provide data that can be collected and used to generate APM features in a sequence of different steps to arrive at an accurate APM that reproduces the behavior of the AV **100.**

**FIG. 2** illustrates several steps of an embodiment according to the present disclosure to generate an APM for a particular fixed-wings AV. Generally, the model determined in a step serves for determining another model in a subsequent step.

A first step of fuel consumption model determination **210** is based on fuel consumption measures **212** performed under different conditions of air density, outside air temperature (OAT) and throttle level ($\varepsilon T$).

A second step of thrust model determination **220** is based on thrust modelling maneuvers **222** performed under conditions of coordinated flight (a flight without sideslip), constant barometric altitude for a plurality of AV mass variations, a plurality throttle levels and a plurality of angle of attack (AOA) values for different air densities, OAT and throttle levels.

A third step of aerodynamic forces model determination **230** is based on data collected from aerodynamic forces modelling maneuvers **232** like AOA-on-elevator, AOS-on-rudder (angle of sideslip) and speed-on-elevator.

A fourth step of propulsive moments and inertia matrix determination **240** is based on data collected from propulsive moments modelling maneuvers **242** from control loops of AOS-on-rudder and bank-on-ailerons. Optionally, maneuvers **242** may be performed under conditions of coordinated flight or actuating the elevator.

Inertia matrix moments modelling maneuvers **243** may be performed under conditions of lateral perturbation via rudder actuation for several AV mass variations.

A fifth step of aerodynamic moments determination **250** is based on data collected from performing maneuvers under certain conditions **252** like AOS-on-rudder, bank-on-ailerons and q-on-elevator.

Once this sequence of steps is performed for the considered fixed-wings AV, its corresponding APM can be obtained.

**FIG. 3** shows an embodiment of a system to generate an APM according to the present disclosure. As to instrumentation and data acquisition, the AV **100** is assumed to be equipped with a state estimator **320** an air data system **310**. The state estimator **320** may fusion GPS **322**, IMU **325** (e.g. solid-state accelerometers **329** and gyros **324**), magnetometer **328**, wind vanes **326** (providing direct observation of angle-of-attack and angle-of-sideslip). The air data system **310** provides observations of true airspeed, pressure and temperature to produce an estimate (e.g. in the sense of the Extended Kalman Filter).

The aircraft flight control system of the AV **100** includes a processing unit **340** that may instruct operating mechanisms that actuate control surfaces to modify direction in flight. The processing unit **340** also may manage throttle that controls engines to modify speed.

Several actions can be performed as outlined in FIG. 2, including flight modelling maneuvers **212**, **232**, **242**, **243** and **252** and associated measures for collecting data in order to sequentially build an APM for the AV **100.** At least some of them may be automated and implemented in flight via processing unit **340** to reduce complexity and facilitate computations to generate a realistic APM. Main maneuvers of assistance to generate the APM are:

- AOS-on-rudder
- Altitude-on-bank
- Speed-on-elevator
- AOA-on-elevator
- Pitch rate-on-elevator

These will be evidenced in the following example expressed with a more detailed mathematical formulation.

FORMAL EXAMPLE OF APM IDENTIFICATION

The present example mathematically demonstrates how a series of modelling maneuvers and measures under particular conditions are used to generate data to be collected in order to determine parameters of each particular model by means of least squares (LS).

Position (WGS84):

$\{\lambda, \varphi, h\}$ Geodetic coordinates

Linear speed (LLS):

| | |
|---|---|
| $u$ | Absolute horizontal speed |
| $\chi$ | True bearing |
| $w$ | Absolute vertical speed |
| $v$ | Module of the absolute speed |
| $\gamma$ | Absolute (geometric) path angle |
| $\mu$ | Absolute bank angle |
| $u_{TAS}$ | Horizontal component of the true airspeed |
| $\chi_{TAS}$ | Bearing of the true airspeed |
| $w_{TAS}$ | Vertical component of the true airspeed |
| $v_{TAS}$ | Module of the true airspeed $v_{TAS} = \sqrt{{u_{TAS}}^2 + {w_{TAS}}^2}$ |
| $\gamma_{TAS}$ | Aerodynamic path angle |
| $\mu_{TAS}$ | Aerodynamic bank angle |
| $u_{WIND}$ | Horizontal component of the wind speed |
| $\chi_{WIND}$ | Bearing of the wind speed |
| $w_{WIND}$ | Vertical component of the wind speed |
| $v_{WIND}$ | Module of the wind speed $v_{WIND} = \sqrt{{u_{WIND}}^2 + {w_{WIND}}^2}$ |

Linear acceleration (BFS):

$\begin{bmatrix} a_1^{BFS} \\ a_2^{BFS} \\ a_3^{BFS} \end{bmatrix}$ BFS components of the non-gravitational accelerations (likewise sensed by a 3-axis accelerometer)

Attitude (BFS):

$\{\xi, \vartheta, \psi\}$ Euler angles
$\alpha$ Angle-of-attach (AOA)
$\beta$ Angle-of-sideslip (AOS)

Angular speed (BFS):

$\begin{bmatrix} p \\ q \\ r \end{bmatrix}$ BFS components of the angular speed of the AV with respect to LLS $\begin{bmatrix} \dot{\alpha} \\ \dot{\beta} \end{bmatrix}$ Derivatives of AOA and AOS

Angular acceleration (BFS): [angular acceleration not typically a native observable in low-cost IMUs, which implies numerical derivation]

$\begin{bmatrix} \dot{p} \\ \dot{q} \\ \dot{r} \end{bmatrix}$ BFS components of the angular acceleration of the AV with respect to LLS

The accelerometer measures $\{a_1^{BFS}, a_2^{BFS}, a_3^{BFS}\}$ provide the means to split the 3 equations that govern the linear dynamics (i.e. the motion of the AV's gravity center) in two systems where either non-gravitational only forces (i.e. aerodynamic and propulsive) or gravitational-only forces (i.e. weight and Coriolis inertia force) appear. The first system, represented by expression [1] (with further details in expression [2]) is the one off interest to our purpose:

$$[1]\quad \begin{bmatrix} Tt_1 - D \\ Tt_2 - Q \\ Tt_3 - L \end{bmatrix} = m \begin{bmatrix} a_1^{BFS}\cos\alpha\cos\beta + a_2^{BFS}\sin\beta + a_3^{BFS}\sin\alpha\cos\beta \\ -a_1^{BFS}\cos\alpha\sin\beta + a_2^{BFS}\cos\beta - a_3^{BFS}\sin\alpha\sin\beta \\ -a_1^{BFS}\sin\alpha + a_3^{BFS}\cos\alpha \end{bmatrix}$$

$$[2]\quad \begin{aligned} t_1(\alpha,\beta,\upsilon,\varepsilon) &= \cos\alpha\cos\beta\cos\upsilon\cos\varepsilon - \sin\beta\sin\upsilon\cos\varepsilon - \sin\alpha\cos\beta\sin\varepsilon \\ t_2(\alpha,\beta,\upsilon,\varepsilon) &= -(\cos\alpha\sin\beta\cos\upsilon\cos\varepsilon + \cos\beta\sin\upsilon\cos\varepsilon - \sin\alpha\sin\beta\sin\varepsilon) \\ t_3(\alpha,\upsilon,\varepsilon) &= -(\sin\alpha\cos\upsilon\cos\varepsilon + \cos\alpha\sin\varepsilon) \end{aligned}$$

The variables that take part of expression [1] can be classified as follows:

- $a_1^{BFS}$, $a_2^{BFS}$, $a_3^{BFS}$, $\alpha$, $\beta$ are observable aspects of the AV state at any time, provided by the estate estimator
- $\upsilon$,$\varepsilon$ define the direction of the thrust force with respect to BFS; they are unknowns, in principle, but small constant angles (i.e., $\upsilon$ << 1 and $\varepsilon$ << 1)
- *m* (the actual mass) is a slowly varying variable
- *L*,*Q*,*D*,*T* respectively represent the aerodynamic lift, side and drag forces and the thrust force

In the quasi-steady state assumption ($\dot{\alpha} \cong \dot{\beta} \cong 0$), aerodynamic and propulsive forces can be expressed as:

$$[3]\quad L = \frac{1}{2}\kappa p_0 \delta M^2 S C_L(\alpha,\beta,M,\hat{p},\hat{q},\hat{r},\varepsilon_h,\varepsilon_a,\varepsilon_r,\varepsilon_e)$$

$$[4]\quad Q = \frac{1}{2}\kappa p_0 \delta M^2 S C_Q(\alpha,\beta,M,\hat{p},\hat{q},\hat{r},\varepsilon_h,\varepsilon_a,\varepsilon_r,\varepsilon_e)$$

$$[5]\quad D = \frac{1}{2}\kappa p_0 \delta M^2 S C_D(\alpha,\beta,M,\hat{p},\hat{q},\hat{r},\varepsilon_h,\varepsilon_a,\varepsilon_r,\varepsilon_e)$$

$$[6]\quad T = W_{MTOW}\delta C_T(\delta, \theta, M, \varepsilon_T)$$

$$[7]\quad \hat{p} = \frac{pb_w}{2v_{TAS}}$$

$b_w$ is the wingspan

$$[8]\quad \hat{q} = \frac{qc_w}{2v_{TAS}}$$

$c_w$ is the wing mean aerodynamic chord

$$[9]\quad \hat{r} = \frac{rb_w}{2v_{TAS}}$$

With typical symmetry assumptions:

$$[10]\quad L = \frac{1}{2}\kappa p_0 \delta M^2 S C_L(\alpha, \beta, M, \hat{q}, \varepsilon_h, \varepsilon_e)$$

$$[11]\quad Q = \frac{1}{2}\kappa p_0 \delta M^2 S C_Q(\alpha, \beta, M, \hat{p}, \hat{r}, \varepsilon_a, \varepsilon_r)$$

$$[12]\quad D = \frac{1}{2}\kappa p_0 \delta M^2 S C_D(\alpha, \beta, M, \hat{q}, \varepsilon_h, \varepsilon_e)$$

Step **210** for determination of a fuel consumption model

The APM identification process starts with fuel consumption modelling measures **212** as a bench test intended to identify instantaneous fuel consumption as a function of air density, temperature and throttle level:

$$[13]\quad \dot{m} = -F$$

$$[14]\quad m = m_0 - \int_{t_0}^{t} F dt$$

$$[15]\quad F = \frac{W_{MTOW} a_0 \delta \sqrt{\theta}}{L_{HV}} C_F(\delta, \theta, \varepsilon_T)$$

In effect, $C_F(\delta,\theta,\varepsilon_T)$ can be identified for the air pressure $\delta$ and temperature $\theta$ conditions existing at the moment of conducting the bench test, which shall measure mass variation at different levels of $\varepsilon_T$ within its range [0,1], fixed during a time interval wide enough to accurately measure fuel consumption. Alternatively (or complementarily) a direct measure of $F$ can be obtained through a precise caudalimeter. Ideally, the bench tests should be repeated for significantly different temperature and pressure conditions in order to capture its dependence with such variables.

Once the fuel consumption model $C_F(\delta,\theta,\varepsilon_T)$ is identified, expression [14] allows the calculation of the instantaneous mass at any time, as a function of the variation of $\delta$, $\theta$ and $\varepsilon_T$ recorded over the time elapsed from the initial time $t_0$ where the initial mass was $m_0$.

Step **220** for determination of a thrust model

Lateral aerodynamic force $Q$ is symmetric with respect to its dependency with AOS or, in other words, $Q$ is null for *coordinated flight*, i.e.:

$$[16]\quad \beta \equiv 0 \Rightarrow Q \equiv 0$$

Thus, if a basic control loop *AOS-on-rudder* is implemented to maintain coordinated flight for any value of $\varepsilon_a$, expression [1] turns into the much simpler form:

$$[17]\quad \begin{bmatrix} Tt_1 - \frac{1}{2}\kappa p_0 \delta M^2 S C_D \\ Tt_2 \\ Tt_3 - \frac{1}{2}\kappa p_0 \delta M^2 S C_L \end{bmatrix} = m \begin{bmatrix} a_1^{BFS}\cos\alpha + a_3^{BFS}\sin\alpha \\ a_2^{BFS} \\ -a_1^{BFS}\sin\alpha + a_3^{BFS}\cos\alpha \end{bmatrix}$$

For AVs that fly at moderate speeds, i.e. at Mach numbers that allow neglecting compressibility effects, the dependency of $C_L$, $C_Q$ and $C_D$ with the Mach number $M$ can be neglected. Furthermore, for coordinated flights (null AOS), linear aerodynamics theory shows that at moderate AOA, $C_D$ depends quadratically with the AOA while $C_L$ depends linearly with the AOA, which enables relating both coefficients through the classical parabolic *drag polar* (first order approach):

$$[18]\quad C_D = C_{D,0} + C_{D,2}{C_L}^2$$

Such model can be extended to cope with compressibility effects to certain extent by tailoring the coefficients to a given Mach. Thus, for coordinated level flight at given Mach Mand trim condition $\varepsilon_h$:

$$[19]\quad C_D(\alpha, 0, M, 0, \varepsilon_h, 0) = C_{D,0} + K\alpha^2$$

$$[20]\quad C_L(\alpha, 0, M, 0, \varepsilon_h, 0) = C_{L,1}\alpha$$

$$[21]\quad K(\alpha, 0, M, 0, \varepsilon_h, 0) = C_{D,2}{C_{L,1}}^2$$

with $C_{D,0}$, $K$, $C_{L,1}$ and $C_{D,2}$ depending on the selected speed $M$ and trim condition $\varepsilon_h$

$$[22]\quad \begin{bmatrix} T(\cos\alpha\cos\upsilon\cos\varepsilon - \sin\alpha\sin\varepsilon) - \frac{1}{2}\kappa p_0 \delta M^2 S\left(C_{D,0} + K\alpha^2\right) \\ -T\sin\upsilon\cos\varepsilon \\ -T(\sin\alpha\cos\upsilon\cos\varepsilon + \cos\alpha\sin\varepsilon) - \frac{1}{2}\kappa p_0 \delta M^2 S C_{L,1}\alpha \end{bmatrix} = m \begin{bmatrix} a_1^{BFS}\cos\alpha + a_3^{BFS}\sin\alpha \\ a_2^{BFS} \\ -a_1^{BFS}\sin\alpha + a_3^{BFS}\cos\alpha \end{bmatrix}$$

$$[23]\quad \begin{bmatrix} T\cos\upsilon\cos\varepsilon\cos\alpha - T\sin\varepsilon\sin\alpha - \frac{1}{2}\kappa p_0 \delta M^2 S\left(C_{D,0} + K\alpha^2\right) \\ -T\sin\upsilon\cos\varepsilon \\ -T\cos\upsilon\cos\varepsilon\sin\alpha - T\sin\varepsilon\cos\alpha - \frac{1}{2}\kappa p_0 \delta M^2 S C_{L,1}\alpha \end{bmatrix} = m \begin{bmatrix} a_1^{BFS}\cos\alpha + a_3^{BFS}\sin\alpha \\ a_2^{BFS} \\ -a_1^{BFS}\sin\alpha + a_3^{BFS}\cos\alpha \end{bmatrix}$$

$$[24]\quad \begin{bmatrix} W_{MTOW}\delta\cos\alpha & -W_{MTOW}\delta\sin\alpha & 0 & -\frac{1}{2}\kappa p_0\delta M^2 S & 0 & -\frac{1}{2}\kappa p_0\delta M^2 S\alpha^2 \\ 0 & 0 & -W_{MTOW}\delta & 0 & 0 & 0 \\ -W_{MTOW}\delta\sin\alpha & -W_{MTOW}\delta\cos\alpha & 0 & 0 & -\frac{1}{2}\kappa p_0\delta M^2 S\alpha & 0 \end{bmatrix} \begin{bmatrix} a \\ b \\ c \\ C_{D,0} \\ C_{L,1} \\ K \end{bmatrix} = $$

$$= m \begin{bmatrix} a_1^{BFS}\cos\alpha + a_3^{BFS}\sin\alpha \\ a_2^{BFS} \\ -a_1^{BFS}\sin\alpha + a_3^{BFS}\cos\alpha \end{bmatrix}$$

where:

$$[25]\quad \begin{aligned} a &= C_T\cos\upsilon\cos\varepsilon \\ b &= C_T\sin\varepsilon \\ c &= C_T\sin\upsilon\cos\varepsilon \end{aligned}$$

The linear observation problem represented by expression [24] is underdetermined, as there are only 3 equations for 6 unknowns. Furthermore, while $C_{D,0}$, $C_{L,1}$ and $K$ depend on the Mach number Mand trim condition $\varepsilon_h$, the unknowns *a*, *b* and *c* depend on the same variables as $C_T$, i.e. $\{\delta,\theta,M,\varepsilon_T\}$. The thrust model determination step **220** may be performed through flight testing when the flight is controlled so the mentioned variables are held constant, which can be achieved by performing thrust modelling maneuvers **222**:

- $\delta$ and $\theta$ can be held almost constant by holding barometric altitude *H* through an *altitude-on-bank* control loop (as pressure varies relatively slowly with altitude, it is reserved the elevator to control speed through AOA); both positive and negative banks should be used to prevent asymmetry issues. Holding barometric altitude makes $\dot{\alpha} \cong \dot{\beta} \cong q \cong 0$.
- The throttle level $\varepsilon_T$ is held constant
- For the selected throttle level, *M* is held constant through a *speed-on-elevator* control loop; the value of *M* is chosen so that level flight requires adopting a bank angle that leaves the altitude-on-bank loop room for altitude control through slightly increasing or decreasing bank angle as needed

Given the actual mass *m* there is a unique pair of values of $\alpha$ and trim condition $\varepsilon_h$ that make the flight condition described possible. Thus, in order to render the linear observation system of [24] determined or, preferably, overdetermined, $k > 2$ different samples of AOA (ranging from low to high, but avoiding stall) and corresponding actual mass need to be considered, which add more observation equations without adding more unknowns. The idea is to perform a sequence of cases (ideally within the same flight test to avoid variations in the relationship between $\delta$ and $\theta$), for different values of $\{\delta,\theta,M,\varepsilon_T\}$, which shall be repeated several times once the mass has experienced a significant change due to fuel consumption so the dataset collected ends up containing enough samples ($i$ = 1,...,$k$) of the same cases ($j$ = 1,...,$l$) for significantly different actual masses (and, thus, AOA values). In order to capture the variation of $C_T$ with $\delta$ and $\theta$ independently, the tasks should be repeated under different OAT (Outside Air Temperature) conditions with sufficient variation among each other covering the desired operational range (e.g. early in the morning vs. noon or selecting cold vs. hot days).

$$[26]\quad \boldsymbol{H}_{ij} =$$

$$\begin{bmatrix} W_{MTOW}\delta_j\cos\alpha_i & -W_{MTOW}\delta_j\cos\alpha_i & 0 & -\frac{1}{2}\kappa p_0\delta_j {M_j}^2 S & 0 & -\frac{1}{2}\kappa p_0\delta_j {M_j}^2 S{\alpha_i}^2 \\ 0 & 0 & -W_{MTOW}\delta_j & 0 & 0 & 0 \\ -W_{MTOW}\delta_j\sin\alpha_i & -W_{MTOW}\delta_j\cos\alpha_i & 0 & 0 & -\frac{1}{2}\kappa p_0\delta_j {M_j}^2 S\alpha_i & 0 \end{bmatrix}$$

Observation matrix for sample *i* of case *j*

$$[27]\quad \boldsymbol{z}_j = \begin{bmatrix} a_j \\ b_j \\ c_j \\ C_{D,0,j} \\ C_{L,1,j} \\ K_j \end{bmatrix}$$

vector of unknowns for case *j*

$$[28]\quad \boldsymbol{O}_{ij} = m_i \begin{bmatrix} a_{1,ij}^{BFS} \cos\alpha_i + a_{3,ij}^{BFS} \sin\alpha_i \\ a_{1,ij}^{BFS} \\ -a_{1,ij}^{BFS} \sin\alpha_i + a_{3,ij}^{BFS} \cos\alpha_i \end{bmatrix}$$

vector of observations for sample *i* of case *j*

By combining all samples (for *i* = 1,...,*k*) of case *j*, the overdetermined linear observation system below is obtained:

$$[29]\quad \boldsymbol{H}_{ij} = \boldsymbol{f}(\delta_j, \theta_j, M_j, \alpha_i)$$

$$[30]\quad \boldsymbol{O}_{ij} = \boldsymbol{f}(m_i, \alpha_i, a_{1,ij}^{BFS}, a_{1,ij}^{BFS}, a_{3,ij}^{BFS})$$

$$[31]\quad \boldsymbol{H}_j = \begin{bmatrix} \boldsymbol{H}_{1j} \\ \boldsymbol{H}_{2j} \\ \vdots \\ \boldsymbol{H}_{kj} \end{bmatrix}$$

$$[32]\quad \boldsymbol{O}_j = \begin{bmatrix} \boldsymbol{O}_{1j} \\ \boldsymbol{O}_{2j} \\ \vdots \\ \boldsymbol{O}_{kj} \end{bmatrix}$$

$$[33]\quad \boldsymbol{H}_j \boldsymbol{z}_j = \boldsymbol{O}_j$$

The best estimation of $\boldsymbol{z}_j$ in the least-squares sense is given by the expression:

$$[34]\quad \boldsymbol{z}_j = (\boldsymbol{H}_j{}^T \boldsymbol{H}_j)^{-1} \boldsymbol{H}_j{}^T \boldsymbol{O}_j \qquad \text{for } j = 1, \dots, l$$

The LS solution obtained also provides a model of the aerodynamic drag and lift coefficients as a function of AOA and Mach valid for null AOS conditions.

To identify $\varepsilon$ and $\upsilon$ (constant for all the cases) and $C_T(\delta,\theta,M,\varepsilon_T)$ for each particular case further processing is required. In effect, expression [25] can then be used to obtain a linear observation system from [25], assuming that $\varepsilon$ and $\upsilon$ are very small angles, the following approximation may be made:

$$[35]\quad \begin{aligned} a &= C_T \\ b &= C_T \varepsilon \\ c &= C_T \upsilon \end{aligned}$$

and take logarithms in both sides of the equations:

[36] $$\begin{aligned} \ln a &= \ln C_T \\ \ln b &= \ln C_T + \ln \varepsilon \\ \ln c &= \ln C_T + \ln \upsilon \end{aligned}$$

Considering all the cases identified above, an overall linear observation system for $\varepsilon$ and $\upsilon$ and $C_{T,j}$ for $j$ = 1,...,$l$ can be composed as follows:

[37] $$\boldsymbol{H} = \begin{bmatrix} 0 & 0 & 1 & 0 & \dots & 0 \\ 1 & 0 & 1 & 0 & \dots & 0 \\ 0 & 1 & 1 & 0 & \dots & 0 \\ 0 & 0 & 0 & 1 & \dots & 0 \\ 1 & 0 & 0 & 1 & \dots & 0 \\ 0 & 1 & 0 & 1 & \dots & 0 \\ \vdots & \vdots & \vdots & \vdots & & \vdots \\ 0 & 0 & 0 & 0 & \dots & 1 \\ 1 & 0 & 0 & 0 & \dots & 1 \\ 0 & 1 & 0 & 0 & \dots & 1 \end{bmatrix} \qquad \dim(\boldsymbol{H}) = 3l \times (2 + l)$$

[38] $$\boldsymbol{O} = \begin{bmatrix} \ln a_1 \\ \ln b_1 \\ \ln c_1 \\ \ln a_2 \\ \ln b_2 \\ \ln c_2 \\ \vdots \\ \ln a_l \\ \ln b_l \\ \ln c_l \end{bmatrix} \qquad \dim(\boldsymbol{O}) = 3l \times (2 + l)$$

[39] $$\boldsymbol{z} = \begin{bmatrix} \ln \varepsilon \\ \ln \upsilon \\ \ln C_{T,1} \\ \ln C_{T,2} \\ \vdots \\ \ln C_{T,l} \end{bmatrix} \qquad \dim(\boldsymbol{z}) = (2 + l) \times 1$$

The LS solution is then obtained as:

[40] $$\boldsymbol{z} = (\boldsymbol{H}^T \boldsymbol{H})^{-1} \boldsymbol{H}^T \boldsymbol{O}$$

which finally renders:

[41] $$\begin{aligned} \varepsilon &= \exp(\boldsymbol{z}[1]) \\ \upsilon &= \exp(\boldsymbol{z}[2]) \end{aligned}$$

Thrust orientation parameters

$$[42]\quad \begin{aligned} C_{T,1} &= C_T(\delta_1,\theta_1,M_1,\varepsilon_{T,1}) = \exp(\boldsymbol{z}[2+1]) \\ C_{T,2} &= C_T(\delta_2,\theta_2,M_2,\varepsilon_{T,2}) = \exp(\boldsymbol{z}[2+2]) \\ &\ldots \\ C_{T,l} &= C_T(\delta_l,\theta_l,M_l,\varepsilon_{T,l}) = \exp(\boldsymbol{z}[2+l]) \end{aligned}$$

cases performed

Thrust coefficients identified for all the test

The thrust model determination step **220** described above has a limitation associated to the fact that all these test cases are performed at constant altitudes. In the experimental conditions defined, the thrust model derived cannot capture thrust levels below the minimum required to hold altitude in level flight with minimum actual mass at the speed that renders maximum aerodynamic efficiency (i.e. the minimum thrust to sustain level flight with minimum mass). Thus, no thrust information can be obtained for throttle levels that deliver a thrust lower than that one, for which it is needed an alternative approach that involves lower throttle levels.

A possible approach to identify the low throttle part of the thrust model may consist on performing decelerations at constant altitude to avoid variations of $\delta$ and $\theta$. Starting from a flight condition at high speed ($M$) and high bank angle should give enough time to record speed variations in between the time when the engine transient (after having set and held a low throttle level) is over and the moment where level flight can no longer be sustained. Another approach may consist on performing descents holding low throttle level and, e.g speed ($M$), and record data at the altitudes of interest. In both cases, the thrust can be estimated through the following expression:

$$[43]\quad W_{MTOW}\delta\begin{bmatrix}\cos\alpha\cos\upsilon\cos\varepsilon-\sin\alpha\sin\varepsilon\\ -\sin\upsilon\cos\varepsilon\\ -(\sin\alpha\cos\upsilon\cos\varepsilon+\cos\alpha\sin\varepsilon)\end{bmatrix}C_T = m\begin{bmatrix}a_1^{BFS}\cos\alpha+a_3^{BFS}\sin\alpha\\ a_2^{BFS}\\ -a_1^{BFS}\sin\alpha+a_3^{BFS}\cos\alpha\end{bmatrix}+ \frac{1}{2}\kappa p_0\delta M^2 S\begin{bmatrix}(C_{D,0}+K\alpha^2)\\ 0\\ C_{L,1}\alpha\end{bmatrix}$$

with $\varepsilon$, $\upsilon$, $C_{D,0}$, $K$ and $C_{L,1}$ already known, which already makes expression [43] an overdetermined linear observation system for $C_T$. In principle, no special provisions and or control for $\delta$, $\alpha$, $m$ or $M$ are required as all these variables are observables, however, for practical reasons, it might be of interest to set up/control then and/or record data to fit the same cases identified for higher throttle levels.

In effect, to identify $C_T(\delta_j,\theta_j,M_j,\varepsilon_{T,j})$ following the first approach, $\delta_j$ and be set and held for the same cases as in high throttle and $C_T$ estimated when $M$ matches the Mach $M_j$ associated to those cases. If the second approach is followed, $M_j$ can be set and held and then estimate $C_T$ when $\delta_j$ matches the cases identified for high throttle levels. The dependency of thrust with $\theta$ is less than an issue for low level throttle. Notice that regardless the approach, this identification problem does only require controlling 2 control DOFs of the AV motion, namely, the throttle level and either altitude (in the first approach) or Mach (in the second approach), which allows using the remaining 3rd DOF to change AOA or bank angle to increase redundancy in the observation and, thus, achieve more robust estimations of $C_T$. Alternatively, redundancy of observations in this problem can be, again, increased by repeating the test cases for different masses and corresponding AOAs, analogously to what has been done in the high throttle cases.

Expression [43] can be employed in general to further identify thrust model cases or refine them regardless the level of throttle, once $\varepsilon$, $\upsilon$, $C_{D,0}$, $K$ and $C_{L,1}$ are well known, as long as AOS is held null.

Step **230** for determination of aerodynamic forces model

Once the thrust model parameters have been identified, expression [1] can be used again, this time as a direct observer for the aerodynamic force coefficients as follows:

$$[44]\quad \frac{1}{2}\kappa p_0\delta M^2 S\begin{bmatrix}C_D\\ C_Q\\ C_L\end{bmatrix} = \begin{bmatrix}Tt_1\\ Tt_2\\ Tt_3\end{bmatrix} - m\begin{bmatrix}a_1^{BFS}\cos\alpha\cos\beta+a_2^{BFS}\sin\beta+a_3^{BFS}\sin\alpha\cos\beta\\ -a_1^{BFS}\cos\alpha\sin\beta+a_2^{BFS}\cos\beta-a_3^{BFS}\sin\alpha\sin\beta\\ -a_1^{BFS}\sin\alpha+a_3^{BFS}\cos\alpha\end{bmatrix}$$

with $T$ given by expression [6], where the thrust model $C_T(\delta,\theta,M,\varepsilon_T)$ is already known from previous step.

Expression [44] allows the direct estimation of the aerodynamic force coefficients $C_D$, $C_Q$ and $C_L$ in terms of their dependency variables through flight testing, for which the respective domains have to be swept, which can be done manually and or with the help of control loops such as AOA-on-elevator and AOS-on-rudder and speed-on-elevator. If the mentioned control loops are available, an alternative approach to the identification of the aerodynamic force coefficients could take advantage of the two remaining control degrees of freedom (i.e. ailerons and throttle) and variables such as $\delta$, $M$ and $\theta$ to produce an overdetermined linear observation system, which would, expectedly, bring a best estimate where errors are further compensated.

Another validation that can be done is to check how well $C_D$ and $C_L$ fit the parabolic drag polar coefficients as a function of Mach identified in Step **220** for the case of null AOS.

Once the thrust model is known, expression [44] can still be used, if necessary, to estimate aerodynamic coefficients in the most general form:

$$[45] \quad C_L = C_L\left(\alpha,\beta,M,\hat{\dot{\alpha}},\hat{\dot{\beta}},\hat{p},\hat{q},\hat{r},\varepsilon_h,\varepsilon_a,\varepsilon_r,\varepsilon_e\right)$$

$$[46] \quad C_Q = C_Q\left(\alpha,\beta,M,\hat{\dot{\alpha}},\hat{\dot{\beta}},\hat{p},\hat{q},\hat{r},\varepsilon_h,\varepsilon_a,\varepsilon_r,\varepsilon_e\right)$$

$$[47] \quad C_D = C_D\left(\alpha,\beta,M,\hat{\dot{\alpha}},\hat{\dot{\beta}},\hat{p},\hat{q},\hat{r},\varepsilon_h,\varepsilon_a,\varepsilon_r,\varepsilon_e\right)$$

where:

$$[48] \quad \hat{\dot{\alpha}} = \frac{\dot{\alpha} c_w}{2 v_{TAS}}$$

$$[49] \quad \hat{\dot{\beta}} = \frac{\dot{\beta} b_w}{2 v_{TAS}}$$

However, for uncompressible aerodynamics and small AOS the main dependencies of the aerodynamics coefficients under the quasi-steady state and typical symmetry assumptions get simpler:

$$[50] \quad C_L = C_L(\alpha,\hat{q},\varepsilon_h,\varepsilon_e)$$

$$[51] \quad C_Q = C_Q(\beta,\hat{p},\hat{r},\varepsilon_a,\varepsilon_r)$$

$$[52] \quad C_D = C_D(\alpha,\hat{q},\varepsilon_h,\varepsilon_e)$$

Step **240** for determination of inertia properties and propulsive moments

The 2nd Newton law applied to angular dynamics renders the following expression for the balance of moments:

$$[53] \quad \begin{bmatrix} R_A \\ P_A \\ Y_A \end{bmatrix} = \begin{bmatrix} I_{xx} & 0 & -I_{xz} \\ 0 & I_{yy} & 0 \\ -I_{xz} & 0 & I_{zz} \end{bmatrix} \begin{bmatrix} \dot{p} - D_9 pq + D_{10} qr \\ \dot{q} + D_{11}(p^2 - r^2) + D_{12} pr \\ \dot{r} - D_{13} pq + D_{14} qr \end{bmatrix} - T \begin{bmatrix} E_1 \\ E_2 \\ E_3 \end{bmatrix} - M_T \begin{bmatrix} \cos\upsilon\cos\varepsilon \\ -\sin\upsilon\cos\varepsilon \\ -\sin\varepsilon \end{bmatrix}$$

Where:

[54] $$\begin{aligned} D_9 &= D_7 I_{xz} - D_3 D_8 \\ D_{10} &= D_1 D_7 + D_8 I_{xz} \\ D_{11} &= D_6 I_{xz} \\ D_{12} &= D_2 D_6 \\ D_{13} &= D_8 I_{xz} - D_3 D_5 \\ D_{14} &= D_1 D_8 + D_5 I_{xz} \end{aligned}$$

[55] $$\begin{aligned} D_1 &= I_{zz} - I_{yy} \\ D_2 &= I_{xx} - I_{zz} \\ D_3 &= I_{yy} - I_{xx} \end{aligned}$$

[56] $$\begin{aligned} D_4 &= \frac{I_{xx} I_{zz} - {I_{xz}}^2}{I_{yy}} \\ D_5 &= \frac{I_{xx}}{I_{yy} D_4} = \frac{I_{xx}}{I_{xx} I_{zz} - {I_{xz}}^2} \\ D_6 &= \frac{1}{I_{yy}} \end{aligned}$$

[57] $$\begin{aligned} D_7 &= \frac{I_{zz}}{I_{yy} D_4} = \frac{I_{zz}}{I_{xx} I_{zz} - {I_{xz}}^2} \\ D_8 &= \frac{I_{xz}}{I_{yy} D_4} = \frac{I_{xz}}{I_{xx} I_{zz} - {I_{xz}}^2} \end{aligned}$$

[58] $$I_{xx}, I_{yy}, I_{zz}, I_{xz} = f(m)$$

[59] $$\begin{aligned} E_1 &= -y_{O_T}^{BFS} \sin\varepsilon + z_{O_T}^{BFS} \sin\upsilon \cos\varepsilon \\ E_2 &= x_{O_T}^{BFS} \sin\varepsilon + z_{O_T}^{BFS} \cos\upsilon \cos\varepsilon \\ E_3 &= -x_{O_T}^{BFS} \sin\upsilon \cos\varepsilon - y_{O_T}^{BFS} \cos\upsilon \cos\varepsilon \end{aligned}$$

[60] $$\begin{bmatrix} R_T \\ P_T \\ Y_T \end{bmatrix} = T \begin{bmatrix} E_1 \\ E_2 \\ E_3 \end{bmatrix} + M_T \begin{bmatrix} \cos\upsilon \cos\varepsilon \\ -\sin\upsilon \cos\varepsilon \\ -\sin\varepsilon \end{bmatrix}$$

Propulsive or thrust-related moments

In the general case, aerodynamic moments can be expressed as:

[61] $$R_A = \frac{1}{2} \kappa p_0 \delta M^2 S b_w C_R \left(\alpha, \beta, M, \hat{\dot{\alpha}}, \hat{\dot{\beta}}, \hat{p}, \hat{q}, \hat{r}, \varepsilon_h, \varepsilon_a, \varepsilon_r, \varepsilon_e\right)$$

Aerodynamic roll moment

[62] $$P_A = \frac{1}{2} \kappa p_0 \delta M^2 S c_w C_P \left(\alpha, \beta, M, \hat{\dot{\alpha}}, \hat{\dot{\beta}}, \hat{p}, \hat{q}, \hat{r}, \varepsilon_h, \varepsilon_a, \varepsilon_r, \varepsilon_e\right)$$

Aerodynamic pitch moment

[63] $$Y_A = \frac{1}{2} \kappa p_0 \delta M^2 S b_w C_Y \left(\alpha, \beta, M, \hat{\dot{\alpha}}, \hat{\dot{\beta}}, \hat{p}, \hat{q}, \hat{r}, \varepsilon_h, \varepsilon_a, \varepsilon_r, \varepsilon_e\right)$$

Aerodynamic yaw moment

$$[64]\quad M_T = m_{MTOW} {b_w}^2 {N_s}^2 C_{M_T}$$

Reactive torque due to rotating engine parts & propeller, where the rotating speed $N_S$ is assumed to be observable

With the assumption that $\varepsilon$ and $\upsilon$ are small angles:

$$[65]\quad M_T \begin{bmatrix} 1 \\ -\upsilon \\ -\varepsilon \end{bmatrix}$$

$$[66]\quad \begin{aligned} E_1 &= -y_{O_T}^{BFS}\varepsilon + z_{O_T}^{BFS}\upsilon \\ E_2 &= x_{O_T}^{BFS}\varepsilon + z_{O_T}^{BFS} \\ E_3 &= -x_{O_T}^{BFS}\upsilon - y_{O_T}^{BFS} \end{aligned}$$

$$[67]\quad \begin{bmatrix} R_A \\ P_A \\ Y_A \end{bmatrix} = \begin{bmatrix} I_{xx} & 0 & -I_{xz} \\ 0 & I_{yy} & 0 \\ -I_{xz} & 0 & I_{zz} \end{bmatrix} \begin{bmatrix} \dot{p} - D_9 pq + D_{10} qr \\ \dot{q} + D_{11}(p^2 - r^2) + D_{12} pr \\ \dot{r} - D_{13} pq + D_{14} qr \end{bmatrix} - T \begin{bmatrix} E_1 \\ E_2 \\ E_3 \end{bmatrix} - M_T \begin{bmatrix} 1 \\ -\upsilon \\ -\varepsilon \end{bmatrix}$$

$$[68]\quad \frac{1}{2}\kappa p_0 \delta M^2 S b_w C_R\left(\alpha, \beta, M, \hat{\dot{\alpha}}, \hat{\dot{\beta}}, \hat{p}, \hat{q}, \hat{r}, \varepsilon_h, \varepsilon_a, \varepsilon_r, \varepsilon_e\right) = I_{xx}(m)(\dot{p} - D_9 pq + D_{10} qr) - I_{xz}(m)(\dot{r} - D_{13} pq + D_{14} qr) - TE_1 - M_T$$

$$[69]\quad \frac{1}{2}\kappa p_0 \delta M^2 S c_w C_P\left(\alpha, \beta, M, \hat{\dot{\alpha}}, \hat{\dot{\beta}}, \hat{p}, \hat{q}, \hat{r}, \varepsilon_h, \varepsilon_a, \varepsilon_r, \varepsilon_e\right) = I_{yy}(m)(\dot{q} + D_{11}(p^2 - r^2) + D_{12} pr) - TE_2 + M_T \upsilon$$

$$[70]\quad \frac{1}{2}\kappa p_0 \delta M^2 S b_w C_Y\left(\alpha, \beta, M, \hat{\dot{\alpha}}, \hat{\dot{\beta}}, \hat{p}, \hat{q}, \hat{r}, \varepsilon_h, \varepsilon_a, \varepsilon_r, \varepsilon_e\right) = -I_{xz}(m)(\dot{p} - D_9 pq + D_{10} qr) + I_{zz}(m)(\dot{r} - D_{13} pq + D_{14} qr) - TE_3 + M_T \varepsilon$$

To isolate longitudinal dynamics, it is assumed that AOS-on-rudder and bank-on-ailerons control loops are active to maintain the condition:

$$[71]\quad \dot{\beta} \equiv \beta \equiv 0$$

$$[72]\quad p \equiv r \equiv 0$$

If a steady coordinated level flight is held at given altitude $\delta$, Mach $M_0$ and actual mass $m_0$, which requires certain known AOA $\alpha_0$ ($q \equiv \dot{\alpha} \equiv 0$) and trim level $\varepsilon_{h,0}$, then expression [69] further reduces to:

$$[73]\quad \frac{1}{2}\kappa p_0 \delta {M_0}^2 S c_w C_{P,0} = -T_0 E_2 + M_{T,0}\upsilon = -W_{MTOW}\delta C_{T,0} E_2 + m_{MTOW} {b_w}^2 {N_{s,0}}^2 C_{M_T}\upsilon$$

where:

$$[74]\quad C_{P,0} = C_P\left(\alpha_0, 0, M_0, 0,0,0,0,0, \varepsilon_{h,0}, 0,0,0\right)$$

$$[75]\quad C_{T,0} = C_{T,0}\left(\delta, \theta, M_0, \varepsilon_{T,0}\right)$$

If the elevator is actuated, an aerodynamic pitch moment appears, which breaks the balance and results in pitch acceleration; the expression that governs the longitudinal motion (after returning the elevator to the null position) reduces to:

$$[76]\quad \frac{1}{2}\kappa p_0 \delta M^2 S c_w C_P\left(\alpha, 0, M, \hat{\dot{\alpha}}, 0,0, \hat{q}, 0, \varepsilon_{h,0}, 0, \varepsilon_r, 0\right) = I_{yy}(m)\dot{q} - TE_2 + M_T \upsilon = I_{yy}(m)\dot{q} - W_{MTOW}\delta C_T(\delta, \theta, M, \varepsilon_T)E_2 + m_{MTOW} {b_w}^2 {N_s}^2 C_{M_T}\upsilon$$

Close enough to the balanced level flight condition and, as long as the flight is kept coordinated, $\varepsilon_e$ is held null and $\varepsilon_{h,0}$ is held constant, the aerodynamic pitch moment and thrust coefficients can be approximated by a Taylor expansion in the form (first order approach):

$$[77]\quad C_P\left(\alpha, 0, M, \hat{\dot{\alpha}}, 0,0, \hat{q}, 0, \varepsilon_{h,0}, 0, \varepsilon_r, 0\right) = C_{P,0} + C_{P,\alpha}\Delta\alpha + C_{P_A,M}\Delta M + C_{P,\hat{\dot{\alpha}}}\hat{\dot{\alpha}} + C_{P,\hat{q}}\hat{q} + C_{P,\varepsilon_r}\varepsilon_r$$

$$[78]\quad C_T\left(\delta, \theta, M, \varepsilon_{T,0}\right) = C_{T,0}\left(\delta, \theta, M_0, \varepsilon_{T,0}\right) + C_{T,M}\left(\delta, \theta, M_0, \varepsilon_{T,0}\right)\Delta M$$

with:

$$[79]\quad \Delta\alpha = \alpha - \alpha_0$$

$$[80]\quad \Delta M = M - M_0$$

$$[81]\quad C_{P,\hat{\dot{\alpha}}}\hat{\dot{\alpha}} = C_{P,\hat{\dot{\alpha}}}\frac{\dot{\alpha}c_w}{2v_{TAS}} = C_{P,\hat{\dot{\alpha}}}\frac{c_w}{2a_0}\frac{\dot{\alpha}}{M} = C_{P,\dot{\alpha}}\frac{\dot{\alpha}}{M} \qquad C_{P,\dot{\alpha}} = C_{P,\hat{\dot{\alpha}}}\frac{c_w}{2a_0}$$

$$[82]\quad C_{P,\hat{q}}\hat{q} = C_{P,\hat{q}}\frac{qc_w}{2v_{TAS}} = C_{P,\hat{q}}\frac{c_w}{2a_0}\frac{q}{M} = C_{P,q}\frac{q}{M} \qquad C_{P,q} = C_{P,\hat{q}}\frac{c_w}{2a_0}$$

Assuming that the steady flight condition is perturbed with a longitudinal command (typically a so-called *doublet*) by means of the elevator and then return the elevator back to and hold it at the null position, without changing the throttle level ($\varepsilon_{T,0}$ is held unchanged, thus, $N_{S,0}$ does not change either), so the amplitude of the resulting oscillatory motion (the combination of the so-called *short-term* and the *phugoid* response modes) is small enough to allow approximating $C_P$ and $C_T$ by, respectively, expressions [77] and [78]:

$$[83]\quad \frac{1}{2}\kappa p_0 \delta M^2 S c_w \left(C_{P,0} + C_{P,\alpha}\Delta\alpha + C_{P_A,M}\Delta M + C_{P,\dot{\alpha}}\frac{\dot{\alpha}}{M} + C_{P,q}\frac{q}{M} + C_{P,\varepsilon_r}\varepsilon_r\right) = I_{yy}(m)\dot{q} - W_{MTOW}\delta\left(C_{T,0} + C_{T,M}\Delta M\right)E_2 + m_{MTOW}{b_w}^2 {N_{s,0}}^2 C_{M_T}\upsilon$$

$$[84]\quad M^2 = (M_0 + \Delta M)^2 = {M_0}^2 + 2M_0\Delta M + \Delta M^2 = {M_0}^2\left[1 + 2\frac{\Delta M}{M_0} + \left(\frac{\Delta M}{M_0}\right)^2\right]$$

$$[85]\quad \frac{\Delta M}{M_0} \ll 1$$

$$[86]\quad M^2 \approx {M_0}^2\left(1+2\frac{\Delta M}{M_0}\right)$$

$$[87]\quad \frac{1}{2}\kappa p_0\delta\left({M_0}^2+2M_0\Delta M\right)Sc_wC_{P,0}+\frac{1}{2}\kappa p_0\delta M^2Sc_w\left(C_{P,\alpha}\Delta\alpha+C_{P_A,M}\Delta M+C_{P,\dot{\alpha}}\frac{\dot{\alpha}}{M}+C_{P,q}\frac{q}{M}+C_{P,\varepsilon_r}\varepsilon_r\right)=I_{yy}(m)\dot{q}-W_{MTOW}\delta\left(C_{T,0}+C_{T,M}\Delta M\right)E_2+m_{MTOW}{b_w}^2{N_{s,0}}^2C_{M_T}\upsilon$$

Bearing in mind expression [73], the longitudinal moments balance yields:

$$[88]\quad \kappa p_0\delta Sc_wM_0\Delta MC_{P,0}+\frac{1}{2}\kappa p_0\delta M^2Sc_w\left(C_{P,\alpha}\Delta\alpha+C_{P_A,M}\Delta M+C_{P,\dot{\alpha}}\frac{\dot{\alpha}}{M}+C_{P,q}\frac{q}{M}+C_{P,\varepsilon_r}\varepsilon_r\right)=I_{yy}(m)\dot{q}-W_{MTOW}\delta C_{T,M}\Delta ME_2$$

$$[89]\quad \kappa p_0\delta Sc_wM_0C_{P,0}\Delta M+\frac{1}{2}\kappa p_0\delta Sc_w\left(M^2C_{P,\alpha}\Delta\alpha+M^2C_{P_A,M}\Delta M+MC_{P,\dot{\alpha}}\dot{\alpha}+MC_{P,q}q+M^2C_{P,\varepsilon_r}\varepsilon_r\right)=I_{yy}(m)\dot{q}-W_{MTOW}\delta C_{T,M}\Delta ME_2$$

$$[90]\quad M^2\Delta M=(M_0+\Delta M)^2\Delta M=\left({M_0}^2+2M_0\Delta M+\Delta M^2\right)\Delta M={M_0}^2\left[1+2\frac{\Delta M}{M_0}+\left(\frac{\Delta M}{M_0}\right)^2\right]\Delta M\approx {M_0}^2\left(1+2\frac{\Delta M}{M_0}\right)\Delta M$$

$$[91]\quad \frac{1}{2}\kappa p_0\delta Sc_w\left(2M_0C_{P,0}+\frac{W_{MTOW}C_{T,M}E_2}{\frac{1}{2}\kappa p_0Sc_w}\right)\Delta M+\frac{1}{2}\kappa p_0\delta Sc_w\left[M^2C_{P,\alpha}\Delta\alpha+{M_0}^2\left(1+2\frac{\Delta M}{M_0}\right)C_{P_A,M}\Delta M+MC_{P,\dot{\alpha}}\dot{\alpha}+MC_{P,q}q+M^2C_{P,\varepsilon_r}\varepsilon_r\right]=I_{yy}(m)\dot{q}$$

$$[92]\quad C_{P,M}=2\frac{C_{P,0}}{M_0}+C_{P_A,M}+\frac{W_{MTOW}C_{T,M}E_2}{\frac{1}{2}\kappa p_0Sc_w{M_0}^2}$$

$$[93]\quad \frac{1}{2}\kappa p_0\delta Sc_w\left({M_0}^2C_{P,M}\Delta M+M^2C_{P,\alpha}\Delta\alpha+2M_0C_{P_A,M}\Delta M^2+MC_{P,\dot{\alpha}}\dot{\alpha}+MC_{P,q}q+M^2C_{P,\varepsilon_r}\varepsilon_r\right)=I_{yy}(m)\dot{q}$$

$$[94]\quad \frac{1}{2}\kappa p_0\delta Sc_w\left[{M_0}^2C_{P,M}\Delta M+{M_0}^2\left(1+2\frac{\Delta M}{M_0}\right)C_{P,\alpha}\Delta\alpha+2M_0C_{P_A,M}\Delta M^2+(M_0+\Delta M)C_{P,\dot{\alpha}}\dot{\alpha}+(M_0+\Delta M)C_{P,q}q+{M_0}^2\left(1+2\frac{\Delta M}{M_0}\right)C_{P,\varepsilon_r}\varepsilon_r\right]=I_{yy}(m)\dot{q}$$

$$[95]\quad \frac{1}{2}\kappa p_0\delta Sc_w\left[{M_0}^2C_{P,M}\Delta M+{M_0}^2C_{P,\alpha}\Delta\alpha+2M_0C_{P,\alpha}\Delta\alpha\Delta M+2M_0C_{P_A,M}\Delta M^2+M_0C_{P,\dot{\alpha}}\dot{\alpha}+C_{P,\dot{\alpha}}\dot{\alpha}\Delta M+M_0C_{P,q}q+C_{P,q}q\Delta M+{M_0}^2C_{P,\varepsilon_r}\varepsilon_r+2M_0C_{P,\varepsilon_r}\varepsilon_r\Delta M\right]=I_{yy}(m)\dot{q}$$

[96] $\frac{1}{2}\kappa p_0 \delta S c_w M_0{}^2 \Big[ C_{P,\alpha}\Delta\alpha + C_{P,M}\Delta M + \frac{C_{P,\dot{\alpha}}}{M_0}\dot{\alpha} + \frac{C_{P,q}}{M_0} q + C_{P,\varepsilon_r}\varepsilon_r + \Big(2\frac{C_{P,\alpha}}{M_0}\Delta\alpha + 2\frac{C_{P_A,M}}{M_0}\Delta M + \frac{C_{P,\dot{\alpha}}}{M_0{}^2}\dot{\alpha} + \frac{C_{P,q}}{M_0{}^2} q + 2\frac{C_{P,\varepsilon r}}{M_0}\varepsilon_r\Big)\Delta M\Big] = I_{yy}(m)\dot{q}$

Expression [93] is a linear observer for the unknowns $\{C_{P,M}, C_{P,\alpha}, C_{P_A,M}, C_{P,\dot{\alpha}}, C_{P,q}, C_{P,\varepsilon_r}\}$ and $I_{yy}(m)$ valid for any Mach and actual mass. However, pitch acceleration $\dot{q}$ and the derivative of the AOA, $\dot{\alpha}$ are not typically native observables, which means numerical derivation should be required. To avoid the deriving noisy signals, a better idea is to integrate the known signals in [93] over time.

One possibility consists of neglecting the influence of $\dot{\alpha}$, which yields:

[97] $\frac{1}{2}\kappa p_0 \delta S c_w \big(M_0{}^2 C_{P,M}\Delta M + M^2 C_{P,\alpha}\Delta\alpha + 2M_0 C_{P_A,M}\Delta M^2 + M C_{P,q} q + M^2 C_{P,\varepsilon_r}\varepsilon_r\big) = I_{yy}(m)\dot{q}$

[98]
$$f^1 = \int \Delta M dt$$
$$f^2 = \int M^2 \Delta\alpha dt$$
$$f^3 = \int \Delta M^2 dt$$
$$f^4 = \int M q dt$$
$$f^r = \int M^2 \varepsilon_r dt$$

[99] $\frac{1}{2}\kappa p_0 \delta S c_w \big(M_0{}^2 C_{P,M} f^1 + C_{P,\alpha} f^2 + 2M_0 C_{P_A,M} f^3 + C_{P,q} f^4 + C_{P,\varepsilon_r} f^r\big) = I_{yy}(m) q + B$

Expression [99] is a linear observer for the unknowns $\{C_{P,M}, C_{P,\alpha}, C_{P_A,M}, C_{P,q}, C_{P,\varepsilon_r}, B\}$ and $I_{yy}(m)$ valid for any Mach and actual mass, where *B* is an integration constant.

A second possibility consists on computing $\int M\dot{\alpha}$ in [93] as:

[100] $\int M\dot{\alpha} = \int M\alpha - \int \dot{M}\alpha$ [Expression for $\dot{M}$ TBD]

The third possibility consists of eliminating the dependency with $\dot{\alpha}$ in [93] through, substituting expression [286] obtained from the linearization of the equations of linear motion, i.e.:

[101] $\frac{1}{2}\kappa p_0 \delta S c_w \Big[M_0{}^2 C_{P,M}\Delta M + M^2 C_{P,\alpha}\Delta\alpha + 2M_0 C_{P_A,M}\Delta M^2 + \frac{C_{P,\dot{\alpha}}}{F_4}\big(M_0{}^2 F_1 \Delta M + M^2 F_2 \Delta\alpha + M F_3 q\big) + M C_{P,q} q + M^2 C_{P,\varepsilon_r}\varepsilon_r\Big] = I_{yy}(m)\dot{q} + m_0 c_w \frac{C_{P,\dot{\alpha}}}{F_4}\big(F_5 \Delta a_1^{BFS} + F_6 \Delta a_3^{BFS}\big)$

[102] $\frac{1}{2}\kappa p_0 \delta S c_w \Big[M_0{}^2\Big(C_{P,M} + C_{P,\dot{\alpha}}\frac{F_1}{F_4}\Big)\Delta M + \Big(C_{P,\alpha} + C_{P,\dot{\alpha}}\frac{F_2}{F_4}\Big)M^2\Delta\alpha + 2M_0 C_{P_A,M}\Delta M^2 + \Big(C_{P,q} + C_{P,\dot{\alpha}}\frac{F_3}{F_4}\Big)M q + C_{P,\varepsilon_r} M^2 \varepsilon_r\Big] = I_{yy}(m)\dot{q} + m_0\Big(C_{P,\dot{\alpha}}\frac{F_5}{F_4} c_w \Delta a_1^{BFS} + C_{P,\dot{\alpha}}\frac{F_6}{F_4} c_w \Delta a_3^{BFS}\Big)$

[103]
$$G_1 = C_{P,M} + C_{P,\dot{\alpha}}\frac{F_1}{F_4}$$
$$G_2 = C_{P,\alpha} + C_{P,\dot{\alpha}}\frac{F_2}{F_4}$$
$$G_3 = 2C_{P_A,M}$$
$$G_4 = C_{P,q} + C_{P,\dot{\alpha}}\frac{F_3}{F_4}$$
$$G_5 = C_{P,\dot{\alpha}}\frac{F_5}{F_4}c_w$$
$$G_6 = C_{P,\dot{\alpha}}\frac{F_6}{F_4}c_w$$

[104] $$\frac{1}{2}\kappa p_0 \delta S c_w\left[{M_0}^2 G_1 \Delta M + G_2 M^2 \Delta\alpha + M_0 G_3 \Delta M^2 + G_4 M q + C_{P,\varepsilon_r} M^2 \varepsilon_r\right] = I_{yy}(m)\dot{q} + m_0\left(G_5 \Delta a_1^{BFS} + G_6 \Delta a_3^{BFS}\right)$$

[105]
$$f^5 = \int \Delta a_1^{BFS} dt$$
$$f^6 = \int \Delta a_3^{BFS} dt$$

which allows rewriting expression [93] as:

[106] $$\frac{1}{2}\kappa p_0 \delta S c_w\left[{M_0}^2 G_1 f^1 + G_2 f^2 + M_0 G_3 f^3 + G_4 f^4 + C_{P,\varepsilon_r} f^r\right] = I_{yy}(m) q + m_0(G_5 f^5 + G_6 f^6) + B$$

where *B* is an integration constant

Expression [106] is a linear observer for the unknowns $\{G_1, G_2, G_3, G_4, C_{P,\varepsilon_r}, G_5, G_6, B\}$ and $I_{yy}(m)$ valid for any Mach and actual mass. Thus by performing maneuvers for different cases of Mach at the trim condition and actual mass, an overdetermined linear observation system is obtained that allows estimating the mentioned unknowns. In effect, a case may be considered for the identification of $I_{yy}(m)$ for the combination $\{m_i, M_j\}$, i.e., at the trim condition at Mach $M_j$ ($j$ = 1,...,$l_j$) with actual mass $m_i$ ($i$ = 1,...,$k$). For each case of $M_j$, $n_j$ samples of the response to a lateral perturbation are recorded. Thus:

[107] $$\boldsymbol{H}_{ij} = \begin{bmatrix} -\frac{q_{j1}}{\frac{1}{2}\kappa p_0 \delta S c_w} & {M_j}^2 f_{j1}^1 & f_{j1}^2 & M_j f_{j1}^3 & f_{j1}^4 & f_{j1}^r & -\frac{m_i f_{j1}^5}{\frac{1}{2}\kappa p_0 \delta S c_w} & -\frac{m_i f_{j1}^6}{\frac{1}{2}\kappa p_0 \delta S c_w} & -\frac{1}{\frac{1}{2}\kappa p_0 \delta S c_w} \\ -\frac{q_{j2}}{\frac{1}{2}\kappa p_0 \delta S c_w} & {M_j}^2 f_{j2}^1 & f_{j2}^2 & M_j f_{j2}^3 & f_{j2}^4 & f_{j2}^r & -\frac{m_i f_{j2}^5}{\frac{1}{2}\kappa p_0 \delta S c_w} & -\frac{m_i f_{j2}^6}{\frac{1}{2}\kappa p_0 \delta S c_w} & -\frac{1}{\frac{1}{2}\kappa p_0 \delta S c_w} \\ \vdots & \vdots & \vdots & \vdots & \vdots & \vdots & \vdots & \vdots & \vdots \\ -\frac{q_{jn_j}}{\frac{1}{2}\kappa p_0 \delta S c_w} & {M_j}^2 f_{jn_j}^1 & f_{jn_j}^2 & M_j f_{jn_j}^3 & f_{jn_j}^4 & f_{jn_j}^r & -\frac{m_i f_{jn_j}^5}{\frac{1}{2}\kappa p_0 \delta S c_w} & -\frac{m_i f_{jn_j}^6}{\frac{1}{2}\kappa p_0 \delta S c_w} & -\frac{1}{\frac{1}{2}\kappa p_0 \delta S c_w} \end{bmatrix}$$

[108] $$\boldsymbol{z}_{ij} = \begin{bmatrix} I_{yy}(m_i) \\ G_1(\alpha_{ij}, M_j, \varepsilon_{h,ij}) \\ G_2(\alpha_{ij}, M_j, \varepsilon_{h,ij}) \\ G_3(\alpha_{ij}, M_j, \varepsilon_{h,ij}) \\ G_4(\alpha_{ij}, M_j, \varepsilon_{h,ij}) \\ C_{P,\varepsilon_r}(\alpha_{ij}, M_j, \varepsilon_{h,ij}) \\ G_5(\alpha_{ij}, M_j, \varepsilon_{h,ij}) \\ G_6(\alpha_{ij}, M_j, \varepsilon_{h,ij}) \\ B_{ij} \end{bmatrix}$$

[109] $$\boldsymbol{O}_{ij} = \begin{bmatrix} 0 \\ 0 \\ \vdots \\ 0 \end{bmatrix}$$

For the sake of robustness, $I_{yy}(m_i)$ is obtained considering all the $l_i$ samples as follows:

[110] $$\boldsymbol{F}_{ij} = \begin{bmatrix} {M_j}^2 f_{j1}^1 & f_{j1}^2 & M_j f_{j1}^3 & f_{j1}^4 & f_{j1}^r & -\frac{m_i f_{j1}^5}{\frac{1}{2}\kappa p_0 \delta S c_w} & -\frac{m_i f_{j1}^6}{\frac{1}{2}\kappa p_0 \delta S c_w} & -\frac{1}{\frac{1}{2}\kappa p_0 \delta S c_w} \\ {M_j}^2 f_{j2}^1 & f_{j2}^2 & M_j f_{j2}^3 & f_{j2}^4 & f_{j2}^r & -\frac{m_i f_{j2}^5}{\frac{1}{2}\kappa p_0 \delta S c_w} & -\frac{m_i f_{j2}^6}{\frac{1}{2}\kappa p_0 \delta S c_w} & -\frac{1}{\frac{1}{2}\kappa p_0 \delta S c_w} \\ \vdots & \vdots & \vdots & \vdots & \vdots & \vdots & \vdots & \vdots \\ {M_j}^2 f_{jn_j}^1 & f_{jn_j}^2 & M_j f_{jn_j}^3 & f_{jn_j}^4 & f_{jn_j}^r & -\frac{m_i f_{jn_j}^5}{\frac{1}{2}\kappa p_0 \delta S c_w} & -\frac{m_i f_{jn_j}^6}{\frac{1}{2}\kappa p_0 \delta S c_w} & -\frac{1}{\frac{1}{2}\kappa p_0 \delta S c_w} \end{bmatrix}$$

[111] $$\boldsymbol{G}_{ij} = -\frac{\mathbf{1}}{\frac{1}{2}\kappa p_0 \delta S c_w} \begin{bmatrix} q_{j1} \\ q_{j2} \\ \vdots \\ q_{jn_j} \end{bmatrix}$$

[112] $$\boldsymbol{C}_{\boldsymbol{P},ij} = \begin{bmatrix} G_1(\alpha_{ij}, M_j, \varepsilon_{h,ij}) \\ G_2(\alpha_{ij}, M_j, \varepsilon_{h,ij}) \\ G_3(\alpha_{ij}, M_j, \varepsilon_{h,ij}) \\ G_4(\alpha_{ij}, M_j, \varepsilon_{h,ij}) \\ C_{P,\varepsilon_r}(\alpha_{ij}, M_j, \varepsilon_{h,ij}) \\ G_5(\alpha_{ij}, M_j, \varepsilon_{h,ij}) \\ G_6(\alpha_{ij}, M_j, \varepsilon_{h,ij}) \\ B_{ij} \end{bmatrix}$$

[113] $$\boldsymbol{H}_i = \begin{bmatrix} \boldsymbol{G}_{i1} & \boldsymbol{F}_{i1} & \mathbf{0} & \dots & \mathbf{0} \\ \boldsymbol{G}_{i2} & \mathbf{0} & \boldsymbol{F}_{i2} & \dots & \mathbf{0} \\ \vdots & \vdots & \vdots & & \vdots \\ \boldsymbol{G}_{i\,l_i} & \mathbf{0} & \mathbf{0} & \dots & \boldsymbol{F}_{i\,l_i} \end{bmatrix} \qquad \dim(\boldsymbol{H}_i) = \left(\sum_{j=1}^{l_i} n_j\right) \times (1 + 8l_i)$$

[114] $$\boldsymbol{z}_i = \begin{bmatrix} I_{yy}(m_i) \\ \boldsymbol{C}_{\boldsymbol{P},i1} \\ \boldsymbol{C}_{\boldsymbol{P},i2} \\ \vdots \\ \boldsymbol{C}_{\boldsymbol{P},il_i} \end{bmatrix} \qquad \dim(\boldsymbol{z}_i) = (1 + 8l_i) \times 1$$

[115] $$\boldsymbol{O}_i = \begin{bmatrix} 0 \\ 0 \\ \vdots \\ 0 \end{bmatrix} \qquad \dim(\boldsymbol{O}_i) = \left(\sum_{j=1}^{l_i} n_j\right) \times 1$$

[116] $$\boldsymbol{z}_i = (\boldsymbol{H}_i{}^T \boldsymbol{H}_i)^{-1} \boldsymbol{H}_i{}^T \boldsymbol{O}_i$$

[117] $$I_{yy}(m_i) = \boldsymbol{z}_i[1]$$

Repeating the maneuvers for different values of the actual mass would render the variation of $I_{yy}$ with $m$ as $I_{yy} = f(m_i)$ for $i = 1,...,k$

Now, to isolate lateral dynamics, it is assumed that a new pitch rate-*on-elevator* control loop is active to ensure $q \equiv 0$. If a steady level flight is held at given Mach $M$ and actual mass m, which requires certain known AOA $\alpha_0$ ($q \equiv \dot{\alpha} \equiv 0$) and trim level $\varepsilon_{h,0}$, then expressions [68] and [69] further reduce to:

[118] $$\frac{1}{2}\kappa p_0 \delta M^2 S b_w C_{R,0} = -T_0 E_1 - M_{T,0} = -W_{MTOW}\delta C_{T,0} E_1 - m_{MTOW} b_w{}^2 N_{s,0}{}^2 C_{M_T}$$

[119] $$\frac{1}{2}\kappa p_0 \delta M^2 S b_w C_{Y,0} = -T_0 E_3 + M_{T,0}\varepsilon = -W_{MTOW}\delta C_{T,0} E_3 + m_{MTOW} b_w{}^2 N_{s,0}{}^2 C_{M_T}\varepsilon$$

where:

[120] $$C_{R,0} = C_R\left(\alpha_0, 0, M_0, 0,0,0,0,0, \varepsilon_{h,0}, 0,0,0\right)$$

[121] $$C_{Y,0} = C_Y\left(\alpha_0, 0, M_0, 0,0,0,0,0, \varepsilon_{h,0}, 0,0,0\right)$$

If the ailerons are actuated, an aerodynamic roll moment appears, which breaks the balance and results in roll acceleration; expression [68] reduces in that case to:

[122] $$\frac{1}{2}\kappa p_0 \delta M^2 S b_w C_R\left(\alpha, \beta, M, 0, \hat{\dot{\beta}}, \hat{p}, 0, \hat{r}, \varepsilon_{h,0}, 0,0,0\right) = I_{xx}(m)\dot{p} - I_{xz}(m)\dot{r} - TE_1 - M_T == I_{xx}(m)\dot{p} - I_{xz}(m)\dot{r} - W_{MTOW}\delta C_T(\delta, \theta, M, \varepsilon_T)E_1 - m_{MTOW} b_w{}^2 N_s{}^2 C_{M_T}$$

Close enough to the balanced flight condition and, as long as $\varepsilon_a$ and $\varepsilon_r$ are held null and, $\varepsilon_{h,0}$ is held constant, the aerodynamic roll moment coefficient can be approximated by a Taylor expansion in the form:

[123] $$C_R\left(\alpha, \beta, M, 0, \hat{\dot{\beta}}, \hat{p}, 0, \hat{r}, \varepsilon_{h,0}, 0,0,0\right) = C_{R,0} + C_{R,\alpha}\Delta\alpha + C_{R,\beta}\beta + C_{R_A,M}\Delta M + C_{R,\hat{\dot{\beta}}}\hat{\dot{\beta}} + +C_{R,\hat{p}}\hat{p} + C_{R,\hat{r}}\hat{r}$$

with:

[124] $$C_{R,\hat{\dot{\beta}}}\hat{\dot{\beta}} = C_{R,\hat{\dot{\beta}}}\frac{\dot{\beta} b_w}{2v_{TAS}} = C_{R,\hat{\dot{\beta}}}\frac{b_w}{2a_0}\frac{\dot{\beta}}{M} = C_{R,\dot{\beta}}\frac{\dot{\beta}}{M} \qquad C_{R,\dot{\beta}} = C_{R,\hat{\dot{\beta}}}\frac{b_w}{2a_0}$$

[125] $$C_{R,\hat{p}}\hat{p} = C_{R,\hat{p}}\frac{p b_w}{2v_{TAS}} = C_{R,\hat{p}}\frac{b_w}{2a_0}\frac{p}{M} = C_{R,p}\frac{p}{M} \qquad C_{P,p} = C_{P,\hat{p}}\frac{b_w}{2a_0}$$

[126] $$C_{R,\hat{r}}\hat{r} = C_{R,\hat{r}}\frac{r b_w}{2v_{TAS}} = C_{R,\hat{r}}\frac{b_w}{2a_0}\frac{r}{M} = C_{R,r}\frac{r}{M} \qquad C_{P,r} = C_{P,\hat{r}}\frac{b_w}{2a_0}$$

Analogously, if the rudder is actuated from the balanced condition, an aerodynamic yaw moment appears, which breaks the balance and results in yaw acceleration; expression [70] reduces in that case to:

$$[127]\quad \frac{1}{2}\kappa p_0 \delta M^2 S b_w C_Y\left(\alpha,\beta,M,0,\hat{\dot{\beta}},\hat{p},0,\hat{r},\varepsilon_{h,0},0{,}0{,}0\right) = -I_{xz}(m)\dot{p} + I_{zz}(m)\dot{r} - TE_3 + M_T\varepsilon = -I_{xz}(m)\dot{p} + I_{zz}(m)\dot{r} - W_{MTOW}\delta C_T(\delta,\theta,M,\varepsilon_T)E_3 + m_{MTOW}{b_w}^2{N_s}^2C_{M_T}\varepsilon$$

Again, close enough to the balanced flight condition and, as long as $\varepsilon_a$ and $\varepsilon_r$ are held null and, $\varepsilon_{h,0}$ is held constant, the aerodynamic yaw moment coefficient can be approximated by a Taylor expansion in the form:

$$[128]\quad C_Y(\beta,\hat{p},\hat{r},\varepsilon_a,\varepsilon_r) = C_{Y,0} + C_{Y,\alpha}\Delta\alpha + C_{Y,\beta}\beta + C_{Y_A,M}\Delta M + C_{Y,\hat{\dot{\beta}}}\hat{\dot{\beta}} + C_{Y,\hat{p}}\hat{p} + C_{Y,\hat{r}}\hat{r}$$

with:

$$[129]\quad C_{Y,\hat{\dot{\beta}}}\hat{\dot{\beta}} = C_{Y,\hat{\dot{\beta}}}\frac{\dot{\beta}b_w}{2v_{TAS}} = C_{Y,\hat{\dot{\beta}}}\frac{b_w}{2a_0}\frac{\dot{\beta}}{M} = C_{Y,\dot{\beta}}\frac{\dot{\beta}}{M} \qquad C_{Y,\dot{\beta}} = C_{Y,\hat{\dot{\beta}}}\frac{b_w}{2a_0}$$

$$[130]\quad C_{Y,\hat{p}}\hat{p} = C_{Y,\hat{p}}\frac{pb_w}{2v_{TAS}} = C_{Y,\hat{p}}\frac{b_w}{2a_0}\frac{p}{M} = C_{Y,p}\frac{p}{M} \qquad C_{Y,p} = C_{Y,\hat{p}}\frac{b_w}{2a_0}$$

$$[131]\quad C_{Y,\hat{r}}\hat{r} = C_{Y,\hat{r}}\frac{rb_w}{2v_{TAS}} = C_{Y,\hat{r}}\frac{b_w}{2a_0}\frac{r}{M} = C_{Y,r}\frac{r}{M} \qquad C_{Y,r} = C_{Y,\hat{r}}\frac{b_w}{2a_0}$$

In both cases:

$$[132]\quad C_T(\delta,\theta,M,\varepsilon_{T,0}) = C_{T,0}(\delta,\theta,M_0,\varepsilon_{T,0}) + C_{T,M}(\delta,\theta,M_0,\varepsilon_{T,0})\Delta M$$

Expressions [122] and [127] along with the respective coefficients from [123], [128] and [132] govern the lateral-directional motion in the cases described, regardless that the perturbation that triggers such motion comes from ailerons or rudder actuations as rolling and yawing motions are coupled.

It is assumed that perturbation of the steady flight condition with a lateral-directional command (typically a so-called *doublet*) by means of either ailerons or rudder and then return the given control surface back to and hold it at the null position so the amplitude of the resulting oscillatory motion (in general, a combination of the so-called *roll*, *Dutch roll* and *spiral* response modes) is small enough to allow approximating $C_R$ and $C_Y$ by, respectively expressions [123] and [128]:

$$[133]\quad \frac{1}{2}\kappa p_0\delta M^2 S b_w\left(C_{R,0} + C_{R,\alpha}\Delta\alpha + C_{R,\beta}\beta + C_{R_A,M}\Delta M + C_{R,\dot{\beta}}\frac{\dot{\beta}}{M} + C_{R,p}\frac{p}{M} + C_{R,r}\frac{r}{M}\right) = I_{xx}(m)\dot{p} - I_{xz}(m)\dot{r} - W_{MTOW}\delta\left(C_{T,0} + C_{T,M}\Delta M\right)E_1 - m_{MTOW}{b_w}^2{N_{s,0}}^2C_{M_T}$$

$$[134]\quad \frac{1}{2}\kappa p_0\delta M^2 S b_w\left(C_{Y,0} + C_{Y,\alpha}\Delta\alpha + C_{Y,\beta}\beta + C_{Y_A,M}\Delta M + C_{Y,\dot{\beta}}\frac{\dot{\beta}}{M} + C_{Y,p}\frac{p}{M} + C_{Y,r}\frac{r}{M}\right) = -I_{xz}(m)\dot{p} + I_{zz}(m)\dot{r} - W_{MTOW}\delta\left(C_{T,0} + C_{T,M}\Delta M\right)E_3 + m_{MTOW}{b_w}^2{N_{s,0}}^2C_{M_T}\varepsilon$$

If expressions [84], [85] and [86] are taken into account:

$$[135]\quad \frac{1}{2}\kappa p_0\delta\left({M_0}^2 + 2M_0\Delta M\right)Sb_wC_{R,0} + \frac{1}{2}\kappa p_0\delta M^2 S b_w\left(C_{R,\alpha}\Delta\alpha + C_{R,\beta}\beta + C_{R_A,M}\Delta M + C_{R,\dot{\beta}}\frac{\dot{\beta}}{M} + C_{R,p}\frac{p}{M} + C_{R,r}\frac{r}{M}\right) = I_{xx}(m)\dot{p} - I_{xz}(m)\dot{r} - W_{MTOW}\delta\left(C_{T,0} + C_{T,M}\Delta M\right)E_1 - m_{MTOW}{b_w}^2{N_{s,0}}^2C_{M_T}$$

[136] $\frac{1}{2}\kappa p_0\delta\left(M_0{}^2 + 2M_0\Delta M\right)Sb_w C_{Y,0} + \frac{1}{2}\kappa p_0\delta M^2 Sb_w\left(C_{Y,\alpha}\Delta\alpha + C_{Y,\beta}\beta + C_{Y_A,M}\Delta M + C_{Y,\dot\beta}\frac{\dot\beta}{M} + C_{Y,p}\frac{p}{M} + C_{Y,r}\frac{r}{M}\right) = -I_{xz}(m)\dot p + I_{zz}(m)\dot r - W_{MTOW}\delta\left(C_{T,0} + C_{T,M}\Delta M\right)E_3 + m_{MTOW}b_w{}^2 N_{s,0}{}^2 C_{M_T}\varepsilon$

Bearing in mind expressions [118] and [119], the lateral-directional moments balance yields:

[137] $\kappa p_0\delta M_0\Delta M Sb_w C_{R,0} + \frac{1}{2}\kappa p_0\delta M^2 Sb_w\left(C_{R,\alpha}\Delta\alpha + C_{R,\beta}\beta + C_{R_A,M}\Delta M + C_{R,\dot\beta}\frac{\dot\beta}{M} + C_{R,p}\frac{p}{M} + C_{R,r}\frac{r}{M}\right) = I_{xx}(m)\dot p - I_{xz}(m)\dot r - W_{MTOW}\delta C_{T,M}\Delta M E_1$

[138] $\kappa p_0\delta M_0\Delta M Sb_w C_{Y,0} + \frac{1}{2}\kappa p_0\delta M^2 Sb_w\left(C_{Y,\alpha}\Delta\alpha + C_{Y,\beta}\beta + C_{Y_A,M}\Delta M + C_{Y,\dot\beta}\frac{\dot\beta}{M} + C_{Y,p}\frac{p}{M} + C_{Y,r}\frac{r}{M}\right) = -I_{xz}(m)\dot p + I_{zz}(m)\dot r - W_{MTOW}\delta C_{T,M}\Delta M E_3$

[139] $\kappa p_0\delta M_0 Sb_w C_{R,0}\Delta M + \frac{1}{2}\kappa p_0\delta Sb_w\left(M^2 C_{R,\alpha}\Delta\alpha + M^2 C_{R,\beta}\beta + M^2 C_{R_A,M}\Delta M + MC_{R,\dot\beta}\dot\beta + MC_{R,p}p + MC_{R,r}r\right) = I_{xx}(m)\dot p - I_{xz}(m)\dot r - W_{MTOW}\delta C_{T,M}\Delta M E_1$

[140] $\kappa p_0\delta M_0 Sb_w C_{Y,0}\Delta M + \frac{1}{2}\kappa p_0\delta Sb_w\left(M^2 C_{Y,\alpha}\Delta\alpha + M^2 C_{Y,\beta}\beta + M^2 C_{Y_A,M}\Delta M + MC_{Y,\dot\beta}\dot\beta + MC_{Y,p}p + MC_{Y,r}r\right) = -I_{xz}(m)\dot p + I_{zz}(m)\dot r - W_{MTOW}\delta C_{T,M}\Delta M E_3$

[141] $\kappa p_0\delta M_0 Sb_w C_{R,0}\Delta M + \frac{1}{2}\kappa p_0\delta Sb_w\left(M^2 C_{R,\alpha}\Delta\alpha + M^2 C_{R,\beta}\beta + M^2 C_{R_A,M}\Delta M + MC_{R,\dot\beta}\dot\beta + MC_{R,p}p + MC_{R,r}r\right) = I_{xx}(m)\dot p - I_{xz}(m)\dot r - W_{MTOW}\delta C_{T,M}\Delta M E_1$

[142] $\kappa p_0\delta M_0 Sb_w C_{Y,0}\Delta M + \frac{1}{2}\kappa p_0\delta Sb_w\left(M^2 C_{Y,\alpha}\Delta\alpha + M^2 C_{Y,\beta}\beta + M^2 C_{Y_A,M}\Delta M + MC_{Y,\dot\beta}\dot\beta + MC_{Y,p}p + MC_{Y,r}r\right) = -I_{xz}(m)\dot p + I_{zz}(m)\dot r - W_{MTOW}\delta C_{T,M}\Delta M E_3$

Taking into account approximation [90]:

[143] $\frac{1}{2}\kappa p_0\delta Sb_w\left(2M_0 C_{R,0} + \frac{W_{MTOW}C_{T,M}E_1}{\frac{1}{2}\kappa p_0 Sc_w}\right)\Delta M + \frac{1}{2}\kappa p_0\delta Sb_w\left(M^2 C_{R,\alpha}\Delta\alpha + M^2 C_{R,\beta}\beta + M_0{}^2\left(1 + 2\frac{\Delta M}{M_0}\right)C_{R_A,M}\Delta M + MC_{R,\dot\beta}\dot\beta + MC_{R,p}p + MC_{R,r}r\right) = I_{xx}(m)\dot p - I_{xz}(m)\dot r$

[144] $\frac{1}{2}\kappa p_0\delta Sb_w\left(2M_0 C_{Y,0} + \frac{W_{MTOW}C_{T,M}E_3}{\frac{1}{2}\kappa p_0 Sc_w}\right)\Delta M + \frac{1}{2}\kappa p_0\delta Sb_w\left(M^2 C_{Y,\alpha}\Delta\alpha + M^2 C_{Y,\beta}\beta + M_0{}^2\left(1 + 2\frac{\Delta M}{M_0}\right)C_{Y_A,M}\Delta M + MC_{Y,\dot\beta}\dot\beta + MC_{Y,p}p + MC_{Y,r}r\right) = -I_{xz}(m)\dot p + I_{zz}(m)\dot r$

[145] $$C_{R,M} = 2\frac{C_{R,0}}{M_0} + C_{R_A,M} + \frac{W_{MTOW}C_{T,M}E_1}{\frac{1}{2}\kappa p_0 S c_w {M_0}^2}$$

[146] $$C_{Y,M} = 2\frac{C_{Y,0}}{M_0} + C_{Y_A,M} + \frac{W_{MTOW}C_{T,M}E_3}{\frac{1}{2}\kappa p_0 S c_w {M_0}^2}$$

[147] $$\frac{1}{2}\kappa p_0 \delta S b_w\left({M_0}^2 C_{R,M}\Delta M + M^2 C_{R,\alpha}\Delta\alpha + M^2 C_{R,\beta}\beta + 2M_0 C_{R_A,M}\Delta M^2 + M C_{R,\dot{\beta}}\dot{\beta} + M C_{R,p} p + M C_{R,r} r\right) = I_{xx}(m)\dot{p} - I_{xz}(m)\dot{r}$$

[148] $$\frac{1}{2}\kappa p_0 \delta S b_w\left({M_0}^2 C_{Y,M}\Delta M + M^2 C_{Y,\alpha}\Delta\alpha + M^2 C_{Y,\beta}\beta + 2M_0 C_{R_A,M}\Delta M^2 + M C_{Y,\dot{\beta}}\dot{\beta} + M C_{Y,p} p + M C_{Y,r} r\right) = -I_{xz}(m)\dot{p} + I_{zz}(m)\dot{r}$$

[149] $$\frac{1}{2}\kappa p_0 \delta S b_w\left[{M_0}^2 C_{R,M}\Delta M + {M_0}^2\left(1 + 2\frac{\Delta M}{M_0}\right) C_{R,\alpha}\Delta\alpha + {M_0}^2\left(1 + 2\frac{\Delta M}{M_0}\right) C_{R,\beta}\beta + 2M_0 C_{R_A,M}\Delta M^2 + (M_0 + \Delta M) C_{R,\dot{\beta}}\dot{\beta} + (M_0 + \Delta M) C_{R,p} p + (M_0 + \Delta M) C_{R,r} r\right] = I_{xx}(m)\dot{p} - I_{xz}(m)\dot{r}$$

[150] $$\frac{1}{2}\kappa p_0 \delta S b_w\left[{M_0}^2 C_{Y,M}\Delta M + {M_0}^2\left(1 + 2\frac{\Delta M}{M_0}\right) C_{Y,\alpha}\Delta\alpha + {M_0}^2\left(1 + 2\frac{\Delta M}{M_0}\right) C_{Y,\beta}\beta + 2M_0 C_{R_A,M}\Delta M^2 + (M_0 + \Delta M) C_{Y,\dot{\beta}}\dot{\beta} + (M_0 + \Delta M) C_{Y,p} p + (M_0 + \Delta M) C_{Y,r} r\right] = -I_{xz}(m)\dot{p} + I_{zz}(m)\dot{r}$$

[151] $$\frac{1}{2}\kappa p_0 \delta S b_w {M_0}^2\left[C_{R,\alpha}\Delta\alpha + C_{R,\beta}\beta + C_{R,M}\Delta M + \frac{C_{R,\dot{\beta}}}{M_0}\dot{\beta} + \frac{C_{R,p}}{M_0} p + \frac{C_{R,r}}{M_0} r + \left(2\frac{C_{R,\alpha}}{M_0}\Delta\alpha + 2\frac{C_{R,\beta}\beta}{M_0}\beta + 2\frac{C_{R_A,M}}{M_0}\Delta M + \frac{C_{R,\dot{\beta}}}{{M_0}^2}\dot{\beta} + \frac{C_{R,p}}{{M_0}^2} p + \frac{C_{R,r}}{{M_0}^2} r\right)\Delta M\right] = I_{xx}(m)\dot{p} - I_{xz}(m)\dot{r}$$

[152] $$\frac{1}{2}\kappa p_0 \delta S b_w {M_0}^2\left[C_{Y,\alpha}\Delta\alpha + C_{Y,\beta}\beta + C_{Y,M}\Delta M + \frac{C_{Y,\dot{\beta}}}{M_0}\dot{\beta} + \frac{C_{Y,p}}{M_0} p + \frac{C_{Y,r}}{M_0} r + \left(2\frac{C_{Y,\alpha}}{M_0}\Delta\alpha + 2\frac{C_{Y,\beta}\beta}{M_0}\beta + 2\frac{C_{Y_A,M}}{M_0}\Delta M + \frac{C_{Y,\dot{\beta}}}{{M_0}^2}\dot{\beta} + \frac{C_{Y,p}}{{M_0}^2} p + \frac{C_{Y,r}}{{M_0}^2} r\right)\Delta M\right] = -I_{xz}(m)\dot{p} + I_{zz}(m)\dot{r}$$

Expressions [147] and [148] constitute a linear observer for the unknowns $\{C_{R,M}, C_{R,\alpha}, C_{R,\beta}, C_{RA,M}, C_{R,\dot{\beta}}, C_{R,p}, C_{R,r}, C_{Y,M}, C_{Y,\alpha}, C_{Y,\beta}, C_{YA,M}, C_{Y,\dot{\beta}}, C_{Y,p}, C_{Y,r}\}$ and $\{I_{xx}(m), I_{xz}(m), I_{zz}(m)\}$ valid for any Mach and actual mass. However, roll and yaw accelerations *p* and *r* and the derivative of the AOS, $\beta$ are not typically native observables, which means numerical derivation should be required. To avoid the deriving noisy signals, a better idea is to integrate the known signals in [147] and [148] over time. Again, one option consists of neglecting the influence of $\dot{\beta}$, which yields:

[153] $$\frac{1}{2}\kappa p_0 \delta S b_w\left({M_0}^2 C_{R,M}\Delta M + M^2 C_{R,\alpha}\Delta\alpha + M^2 C_{R,\beta}\beta + 2M_0 C_{R_A,M}\Delta M^2 + M C_{R,p} p + M C_{R,r} r\right) = I_{xx}(m)\dot{p} - I_{xz}(m)\dot{r}$$

$$[154]\quad \frac{1}{2}\kappa p_0 \delta S b_w \left( {M_0}^2 C_{Y,M} \Delta M + M^2 C_{Y,\alpha} \Delta\alpha + M^2 C_{Y,\beta} \beta + 2 M_0 C_{R_A,M} \Delta M^2 + M C_{Y,p} p + M C_{Y,r} r \right) = -I_{xz}(m)\dot{p} + I_{zz}(m)\dot{r}$$

$$[155]\quad \begin{aligned} f^1 &= \int \Delta M dt \\ f^2 &= \int M^2 \Delta\alpha dt \\ f^3 &= \int M^2 \beta dt \\ f^4 &= \int \Delta M^2 dt \\ f^5 &= \int M p dt \\ f^6 &= \int M r dt \end{aligned}$$

$$[156]\quad \frac{1}{2}\kappa p_0 \delta S b_w \left( {M_0}^2 C_{R,M} f^1 + C_{R,\alpha} f^2 + C_{R,\beta} f^3 + 2 M_0 C_{R_A,M} f^4 + C_{R,p} f^5 + C_{R,r} f^6 \right) = I_{xx}(m)\dot{p} - I_{xz}(m)\dot{r} + A$$

$$[157]\quad \frac{1}{2}\kappa p_0 \delta S b_w \left( {M_0}^2 C_{Y,M} f^1 + C_{Y,\alpha} f^2 + C_{Y,\beta} f^3 + 2 M_0 C_{R_A,M} f^4 + C_{Y,p} f^5 + C_{Y,r} f^6 \right) = -I_{xz}(m)\dot{p} + I_{zz}(m)\dot{r} + C$$

Expressions [156] and [157] constitute a linear observer for the unknowns $\{C_{R,M}, C_{R,\alpha}, C_{R,\beta}, C_{RA,M}, C_{R,p}, C_{R,r}, A, C_{Y,M}, C_{Y,\alpha}, C_{Y,\beta}, C_{YA,M}, C_{Y,p}, C_{Y,r}, C\}$ and $\{I_{xx}(m), I_{xz}(m), I_{zz}(m)\}$ valid for any Mach and actual mass, where $A$ and $C$ are integration constants.

A second possibility consists on computing $\int M\dot{\beta}$ in expressions [147] and [148] as:

$$[158]\quad \int M\dot{\beta} = \int M\beta - \int \dot{M}\beta \qquad \text{[Expression for } \dot{M} \text{ TBD]}$$

The third possibility consists of eliminating the dependency with $\dot{\beta}$ in [147] and [148][93] through, substituting expression [315] obtained from the linearization of the equations of linear motion, i.e.:

[159]

$$F_1 = C_{R,M} - C_{R,\dot{\beta}} \frac{C_{y,M}}{C_{Q,\dot{\beta}}}$$

$$F_2 = C_{R,\alpha} - C_{R,\dot{\beta}} \frac{C_{Q,\alpha}}{C_{Q,\dot{\beta}}}$$

$$F_3 = C_{R,\beta} - C_{R,\dot{\beta}} \frac{C_{Q,\beta}}{C_{Q,\dot{\beta}}}$$

$$F_4 = 2\left(C_{R_A,M} - C_{R,\dot{\beta}} \frac{C_{Q,M}}{C_{Q,\dot{\beta}}}\right)$$

$$F_5 = C_{R,p} - C_{R,\dot{\beta}} \frac{C_{Q,p}}{C_{Q,\dot{\beta}}}$$

$$F_6 = C_{R,r} - C_{R,\dot{\beta}} \frac{C_{Q,r}}{C_{Q,\dot{\beta}}}$$

$$F_7 = -C_{R,\dot{\beta}} \frac{C_{D,\alpha}}{C_{Q,\dot{\beta}}}$$

$$F_8 = -C_{R,\dot{\beta}} \frac{C_{D,\beta}}{C_{Q,\dot{\beta}}}$$

$$F_9 = -C_{R,\dot{\beta}} \frac{C_{D,M}}{C_{Q,\dot{\beta}}}$$

$$F_{10} = -C_{R,\dot{\beta}} \frac{C_{D,p}}{C_{Q,\dot{\beta}}}$$

$$F_{11} = -C_{R,\dot{\beta}} \frac{C_{D,r}}{C_{Q,\dot{\beta}}}$$

$$F_{12} = C_{R,\dot{\beta}} \frac{1}{C_{Q,\dot{\beta}}} b_w$$

[160]

$$G_1 = C_{Y,M} - C_{Y,\dot{\beta}} \frac{C_{y,M}}{C_{Q,\dot{\beta}}}$$

$$G_2 = C_{Y,\alpha} - C_{Y,\dot{\beta}} \frac{C_{Q,\alpha}}{C_{Q,\dot{\beta}}}$$

$$G_3 = C_{Y,\beta} - C_{Y,\dot{\beta}} \frac{C_{Q,\beta}}{C_{Q,\dot{\beta}}}$$

$$G_4 = 2\left(C_{Y_A,M} - C_{Y,\dot{\beta}} \frac{C_{Q,M}}{C_{Q,\dot{\beta}}}\right)$$

$$G_5 = C_{Y,p} - C_{Y,\dot{\beta}} \frac{C_{Q,p}}{C_{Q,\dot{\beta}}}$$

$$G_6 = C_{Y,r} - C_{Y,\dot{\beta}} \frac{C_{Q,r}}{C_{Q,\dot{\beta}}}$$

$$G_7 = -C_{Y,\dot{\beta}} \frac{C_{D,\alpha}}{C_{Q,\dot{\beta}}}$$

$$G_8 = -C_{Y,\dot{\beta}} \frac{C_{D,\beta}}{C_{Q,\dot{\beta}}}$$

$$G_9 = -C_{Y,\dot{\beta}} \frac{C_{D,M}}{C_{Q,\dot{\beta}}}$$

$$G_{10} = -C_{Y,\dot{\beta}} \frac{C_{D,p}}{C_{Q,\dot{\beta}}}$$

$$G_{11} = -C_{Y,\dot{\beta}} \frac{C_{D,r}}{C_{Q,\dot{\beta}}}$$

$$G_{12} = C_{Y,\dot{\beta}} \frac{1}{C_{Q,\dot{\beta}}} b_w$$

[161] $$\frac{1}{2}\kappa p_0 \delta S b_w \left( {M_0}^2 F_1 \Delta M + F_2 M^2 \Delta\alpha + F_3 M^2 \beta + M_0 F_4 \Delta M^2 + F_5 M p + F_6 M r + F_7 M^2 \beta \Delta\alpha + F_8 M^2 \beta^2 + F_9 M^2 \beta \Delta M + F_{10} M p \beta + F_{11} M r \beta \right) = I_{xx}(m)\dot{p} - I_{xz}(m)\dot{r} + m_0 F_{12} \Delta a_2^{BFS}$$

[162] $$\frac{1}{2}\kappa p_0 \delta S b_w \left( {M_0}^2 G_1 \Delta M + G_2 M^2 \Delta\alpha + G_3 M^2 \beta + M_0 G_4 \Delta M^2 + G_5 M p + G_6 M r + G_7 M^2 \beta \Delta\alpha + G_8 M^2 \beta^2 + G_9 M^2 \beta \Delta M + G_{10} M p \beta + G_{11} M r \beta \right) = -I_{xz}(m)\dot{p} + I_{zz}(m)\dot{r} + m_0 G_{12} \Delta a_2^{BFS}$$

[163] $$\begin{aligned} f^7 &= \int M^2 \beta \Delta\alpha dt \\ f^8 &= \int M^2 \beta^2 dt \\ f^9 &= \int M^2 \beta \Delta M dt \\ f^{10} &= \int M p \beta dt \\ f^{11} &= \int M r \beta dt \\ f^{12} &= \int \Delta a_2^{BFS} dt \end{aligned}$$

Which allows rewriting expressions [161] and [162] as:

[164] $$\frac{1}{2}\kappa p_0 \delta S b_w \left( {M_0}^2 F_1 f^1 + F_2 f^2 + F_3 f^3 + M_0 F_4 f^4 + F_5 f^5 + F_6 f^6 + F_7 f^7 + F_8 f^8 + F_9 f^9 + F_{10} f^{10} + F_{11} f^{11} \right) = I_{xx}(m) p - I_{xz}(m) r + m_0 F_{12} f^{12} + A$$

[165] $$\frac{1}{2}\kappa p_0 \delta S b_w \left( {M_0}^2 G_1 f^1 + G_2 f^2 + G_3 f^3 + M_0 G_4 f^4 + G_5 f^5 + G_6 f^6 + G_7 f^7 + G_8 f^8 + G_9 f^9 + G_{10} f^{10} + G_{11} f^{11} \right) = -I_{xz}(m) p + I_{zz}(m) r + m_0 G_{12} f^{12} + C$$

where {A, C} are integration constants.

Expressions [164] and [165] constitute a linear observer for the unknowns $\{F_1,...,F_{12},A,G_1,...,G_{12},C\}$ and $\{I_{xx}(m),I_{xz}(m),I_{zz}(m)\}$ valid for any Mach and actual mass. Thus by performing both experiments (i.e. the ailerons and rudder doublets) for different cases of Mach at the trim condition and actual mass, an overdetermined linear observation system is obtained that allows estimating the mentioned unknowns. In effect, if it is considered a case for the identification of $\{I_{xx}(m),I_{xz}(m),I_{zz}(m)\}$ for the combination $\{m_i,M_j\}$, i.e., at the trim condition at Mach $M_j$ ($j$ = 1,...,$l_j$) with actual mass $m_i$ ($i$ = 1,...,$k$) through aileron perturbation (expression [164]). For each case of $M_j$, $n_j$ samples of the response to a lateral perturbation are recorded. Thus:

[166] $$\boldsymbol{H}_{ij} = \begin{bmatrix} -\frac{p_{j1}}{\frac{1}{2}\kappa p_0 \delta S b_w} & \frac{r_{j1}}{\frac{1}{2}\kappa p_0 \delta S b_w} & 0 & {M_j}^2 f_{j1}^1 & f_{j1}^2 & f_{j1}^3 & M_j f_{j1}^4 & f_{j1}^5 & f_{j1}^6 & f_{j1}^7 & f_{j1}^8 & f_{j1}^9 & f_{j1}^{10} & f_{j1}^{11} & -\frac{m_i f_{j1}^{12}}{\frac{1}{2}\kappa p_0 \delta S b_w} & -\frac{1}{\frac{1}{2}\kappa p_0 \delta S b_w} & 0 \\ -\frac{p_{j2}}{\frac{1}{2}\kappa p_0 \delta S b_w} & \frac{r_{j2}}{\frac{1}{2}\kappa p_0 \delta S b_w} & 0 & {M_j}^2 f_{j2}^1 & f_{j2}^2 & f_{j2}^3 & M_j f_{j2}^4 & f_{j2}^5 & f_{j2}^6 & f_{j2}^7 & f_{j2}^8 & f_{j2}^9 & f_{j2}^{10} & f_{j2}^{11} & -\frac{m_i f_{j2}^{12}}{\frac{1}{2}\kappa p_0 \delta S b_w} & -\frac{1}{\frac{1}{2}\kappa p_0 \delta S b_w} & 0 \\ \vdots & \vdots & \vdots & \vdots & \vdots & \vdots & \vdots & \vdots & \vdots & \vdots & \vdots & \vdots & \vdots & \vdots & \vdots & \vdots & \vdots \\ -\frac{p_{jn_j}}{\frac{1}{2}\kappa p_0 \delta S b_w} & \frac{r_{jn_j}}{\frac{1}{2}\kappa p_0 \delta S b_w} & 0 & {M_j}^2 f_{jn_j}^1 & f_{jn_j}^2 & f_{jn_j}^3 & M_j f_{jn_j}^4 & f_{jn_j}^5 & f_{jn_j}^6 & f_{jn_j}^7 & f_{jn_j}^8 & f_{jn_j}^9 & f_{jn_j}^{10} & f_{jn_j}^{11} & -\frac{m_i f_{jn_j}^{12}}{\frac{1}{2}\kappa p_0 \delta S b_w} & -\frac{1}{\frac{1}{2}\kappa p_0 \delta S b_w} & 0 \end{bmatrix}$$

[167]
$$\boldsymbol{z}_{ij} = \begin{bmatrix} I_{xx}(m_i) \\ I_{xz}(m_i) \\ I_{zz}(m_i) \\ F_1(\alpha_{ij}, M_{ij}, \varepsilon_{h,ij}) \\ F_2(\alpha_{ij}, M_{ij}, \varepsilon_{h,ij}) \\ F_3(\alpha_{ij}, M_{ij}, \varepsilon_{h,ij}) \\ F_4(\alpha_{ij}, M_{ij}, \varepsilon_{h,ij}) \\ F_5(\alpha_{ij}, M_{ij}, \varepsilon_{h,ij}) \\ F_7(\alpha_{ij}, M_{ij}, \varepsilon_{h,ij}) \\ F_8(\alpha_{ij}, M_{ij}, \varepsilon_{h,ij}) \\ F_9(\alpha_{ij}, M_{ij}, \varepsilon_{h,ij}) \\ F_{10}(\alpha_{ij}, M_{ij}, \varepsilon_{h,ij}) \\ F_{11}(\alpha_{ij}, M_{ij}, \varepsilon_{h,ij}) \\ F_{12}(\alpha_{ij}, M_{ij}, \varepsilon_{h,ij}) \\ A_{ij} \\ B_{ij} \end{bmatrix}$$

[168]
$$\boldsymbol{O}_{ij} = \begin{bmatrix} 0 \\ 0 \\ \vdots \\ 0 \end{bmatrix}$$

[169]
$$\boldsymbol{F}_{ij} = \begin{bmatrix} {M_j}^2 f_{j1}^1 & f_{j1}^2 & f_{j1}^3 & M_j f_{j1}^4 & f_{j1}^5 & f_{j1}^6 & f_{j1}^7 & f_{j1}^8 & f_{j1}^9 & f_{j1}^{10} & f_{j1}^{11} & -\frac{m_i f_{j1}^{12}}{\frac{1}{2}\kappa p_0 \delta S b_w} & -\frac{1}{\frac{1}{2}\kappa p_0 \delta S b_w} & 0 \\ {M_j}^2 f_{j2}^1 & f_{j2}^2 & f_{j2}^3 & M_j f_{j2}^4 & f_{j2}^5 & f_{j2}^6 & f_{j2}^7 & f_{j2}^8 & f_{j2}^9 & f_{j2}^{10} & f_{j2}^{11} & -\frac{m_i f_{j2}^{12}}{\frac{1}{2}\kappa p_0 \delta S b_w} & -\frac{1}{\frac{1}{2}\kappa p_0 \delta S b_w} & 0 \\ \vdots & \vdots & \vdots & \vdots & \vdots & \vdots & \vdots & \vdots & \vdots & \vdots & \vdots & \vdots & \vdots & \vdots \\ {M_j}^2 f_{jn_j}^1 & f_{jn_j}^2 & f_{jn_j}^3 & M_j f_{jn_j}^4 & f_{jn_j}^5 & f_{jn_j}^6 & f_{jn_j}^7 & f_{jn_j}^8 & f_{jn_j}^9 & f_{jn_j}^{10} & f_{jn_j}^{11} & -\frac{m_i f_{jn_j}^{12}}{\frac{1}{2}\kappa p_0 \delta S b_w} & -\frac{1}{\frac{1}{2}\kappa p_0 \delta S b_w} & 0 \end{bmatrix}$$

[170]
$$\boldsymbol{G}_{ij} = \frac{1}{\frac{1}{2}\kappa p_0 \delta S b_w} \begin{bmatrix} -p_{j1} & r_{j1} & 0 \\ -p_{j2} & r_{j2} & 0 \\ \vdots & \vdots & \vdots \\ -p_{jn_j} & r_{jn_j} & 0 \end{bmatrix}$$

[171] $$\boldsymbol{C}_{\boldsymbol{R},ij} = \begin{bmatrix} F_1(\alpha_{ij}, M_{ij}, \varepsilon_{h,ij}) \\ F_2(\alpha_{ij}, M_{ij}, \varepsilon_{h,ij}) \\ F_3(\alpha_{ij}, M_{ij}, \varepsilon_{h,ij}) \\ F_4(\alpha_{ij}, M_{ij}, \varepsilon_{h,ij}) \\ F_5(\alpha_{ij}, M_{ij}, \varepsilon_{h,ij}) \\ F_7(\alpha_{ij}, M_{ij}, \varepsilon_{h,ij}) \\ F_8(\alpha_{ij}, M_{ij}, \varepsilon_{h,ij}) \\ F_9(\alpha_{ij}, M_{ij}, \varepsilon_{h,ij}) \\ F_{10}(\alpha_{ij}, M_{ij}, \varepsilon_{h,ij}) \\ F_{11}(\alpha_{ij}, M_{ij}, \varepsilon_{h,ij}) \\ F_{12}(\alpha_{ij}, M_{ij}, \varepsilon_{h,ij}) \\ A_{ij} \\ B_{ij} \end{bmatrix}$$

It is considered the same case for the identification of $\{I_{xx}(m), I_{xz}(m), I_{zz}(m)\}$ for the combination $\{m_i, M_j\}$, i.e., at the trim condition at Mach $M_j$ ($j$ = 1,...,$l_i$) with actual mass $m_i$ ($i$ = 1,...,$k$) through ruder perturbation (expression [165]). For each case of $M_j$, $h_j$ samples of the response to a lateral perturbation are recorded. Thus:

[172] $$\boldsymbol{H}_{ij} = \begin{bmatrix} 0 & \frac{p_{j1}}{\frac{1}{2}\kappa p_0 \delta S b_w} & -\frac{r_{j1}}{\frac{1}{2}\kappa p_0 \delta S b_w} & {M_j}^2 f_{j1}^1 & f_{j1}^2 & f_{j1}^3 & M_j f_{j1}^4 & f_{j1}^5 & f_{j1}^6 & f_{j1}^7 & f_{j1}^8 & f_{j1}^9 & f_{j1}^{10} & f_{j1}^{11} & -\frac{m_i f_{j1}^{12}}{\frac{1}{2}\kappa p_0 \delta S b_w} & 0 & -\frac{1}{\frac{1}{2}\kappa p_0 \delta S b_w} \\ 0 & \frac{p_{j2}}{\frac{1}{2}\kappa p_0 \delta S b_w} & -\frac{r_{j2}}{\frac{1}{2}\kappa p_0 \delta S b_w} & {M_j}^2 f_{j2}^1 & f_{j2}^2 & f_{j2}^3 & M_j f_{j2}^4 & f_{j2}^5 & f_{j2}^6 & f_{j2}^7 & f_{j2}^8 & f_{j2}^9 & f_{j2}^{10} & f_{j2}^{11} & -\frac{m_i f_{j2}^{12}}{\frac{1}{2}\kappa p_0 \delta S b_w} & 0 & -\frac{1}{\frac{1}{2}\kappa p_0 \delta S b_w} \\ \vdots & \vdots & \vdots & \vdots & \vdots & \vdots & \vdots & \vdots & \vdots & \vdots & \vdots & \vdots & \vdots & \vdots & \vdots & \vdots & \vdots \\ 0 & \frac{p_{jh_j}}{\frac{1}{2}\kappa p_0 \delta S b_w} & -\frac{r_{jh_j}}{\frac{1}{2}\kappa p_0 \delta S b_w} & {M_j}^2 f_{jh_j}^1 & f_{jh_j}^2 & f_{jh_j}^3 & M_j f_{jh_j}^4 & f_{jh_j}^5 & f_{jh_j}^6 & f_{jh_j}^7 & f_{jh_j}^8 & f_{jh_j}^9 & f_{jh_j}^{10} & f_{jh_j}^{11} & -\frac{m_i f_{jh_j}^{12}}{\frac{1}{2}\kappa p_0 \delta S b_w} & 0 & -\frac{1}{\frac{1}{2}\kappa p_0 \delta S b_w} \end{bmatrix}$$

[173] $$\boldsymbol{z}_{ij} = \begin{bmatrix} I_{xx}(m_i) \\ I_{xz}(m_i) \\ I_{zz}(m_i) \\ G_1(\alpha_{ij}, M_{ij}, \varepsilon_{h,ij}) \\ G_2(\alpha_{ij}, M_{ij}, \varepsilon_{h,ij}) \\ G_3(\alpha_{ij}, M_{ij}, \varepsilon_{h,ij}) \\ G_4(\alpha_{ij}, M_{ij}, \varepsilon_{h,ij}) \\ G_5(\alpha_{ij}, M_{ij}, \varepsilon_{h,ij}) \\ G_6(\alpha_{ij}, M_{ij}, \varepsilon_{h,ij}) \\ G_7(\alpha_{ij}, M_{ij}, \varepsilon_{h,ij}) \\ G_8(\alpha_{ij}, M_{ij}, \varepsilon_{h,ij}) \\ G_9(\alpha_{ij}, M_{ij}, \varepsilon_{h,ij}) \\ G_{10}(\alpha_{ij}, M_{ij}, \varepsilon_{h,ij}) \\ G_{11}(\alpha_{ij}, M_{ij}, \varepsilon_{h,ij}) \\ G_{12}(\alpha_{ij}, M_{ij}, \varepsilon_{h,ij}) \\ A_{ij} \\ B_{ij} \end{bmatrix}$$

[174] $$\boldsymbol{O}_{ij} = \begin{bmatrix} 0 \\ 0 \\ \vdots \\ 0 \end{bmatrix}$$

[175] $$\boldsymbol{J}_{ij} = \begin{bmatrix} {M_j}^2 f_{j1}^1 & f_{j1}^2 & f_{j1}^3 & M_j f_{j1}^4 & f_{j1}^5 & f_{j1}^6 & f_{j1}^7 & f_{j1}^8 & f_{j1}^9 & f_{j1}^{10} & f_{j1}^{11} & -\frac{m_i f_{j1}^{12}}{\frac{1}{2}\kappa p_0 \delta S b_w} & 0 & -\frac{1}{\frac{1}{2}\kappa p_0 \delta S b_w} \\ {M_j}^2 f_{j2}^1 & f_{j2}^2 & f_{j2}^3 & M_j f_{j2}^4 & f_{j2}^5 & f_{j2}^6 & f_{j2}^7 & f_{j2}^8 & f_{j2}^9 & f_{j2}^{10} & f_{j2}^{11} & -\frac{m_i f_{j2}^{12}}{\frac{1}{2}\kappa p_0 \delta S b_w} & 0 & -\frac{1}{\frac{1}{2}\kappa p_0 \delta S b_w} \\ \vdots & \vdots & \vdots & \vdots & \vdots & \vdots & \vdots & \vdots & \vdots & \vdots & \vdots & \vdots & \vdots & \vdots \\ {M_j}^2 f_{jh_j}^1 & f_{jh_j}^2 & f_{jh_j}^3 & M_j f_{jh_j}^4 & f_{jh_j}^5 & f_{jh_j}^6 & f_{jh_j}^7 & f_{jh_j}^8 & f_{jh_j}^9 & f_{jh_j}^{10} & f_{jh_j}^{11} & -\frac{m_i f_{jh_j}^{12}}{\frac{1}{2}\kappa p_0 \delta S b_w} & 0 & -\frac{1}{\frac{1}{2}\kappa p_0 \delta S b_w} \end{bmatrix}$$

[176] $$\boldsymbol{K}_{ij} = \frac{\mathbf{1}}{\frac{1}{2}\kappa p_0 \delta S b_w} \begin{bmatrix} 0 & p_{j1} & -r_{j1} \\ 0 & p_{j2} & -r_{j2} \\ \vdots & \vdots & \vdots \\ 0 & p_{jh_j} & -r_{jh_j} \end{bmatrix}$$

[177] $$\boldsymbol{C}_{\boldsymbol{Y},ij} = \begin{bmatrix} G_1(\alpha_{ij}, M_{ij}, \varepsilon_{h,ij}) \\ G_2(\alpha_{ij}, M_{ij}, \varepsilon_{h,ij}) \\ G_3(\alpha_{ij}, M_{ij}, \varepsilon_{h,ij}) \\ G_4(\alpha_{ij}, M_{ij}, \varepsilon_{h,ij}) \\ G_5(\alpha_{ij}, M_{ij}, \varepsilon_{h,ij}) \\ G_6(\alpha_{ij}, M_{ij}, \varepsilon_{h,ij}) \\ G_7(\alpha_{ij}, M_{ij}, \varepsilon_{h,ij}) \\ G_8(\alpha_{ij}, M_{ij}, \varepsilon_{h,ij}) \\ G_9(\alpha_{ij}, M_{ij}, \varepsilon_{h,ij}) \\ G_{10}(\alpha_{ij}, M_{ij}, \varepsilon_{h,ij}) \\ G_{11}(\alpha_{ij}, M_{ij}, \varepsilon_{h,ij}) \\ G_{12}(\alpha_{ij}, M_{ij}, \varepsilon_{h,ij}) \\ A_{ij} \\ B_{ij} \end{bmatrix}$$

[178] $$\boldsymbol{H}_i = \begin{bmatrix} \boldsymbol{G}_{i1} & \boldsymbol{F}_{i1} & \mathbf{0} & \dots & \mathbf{0} & \mathbf{0} & \mathbf{0} & \dots & \mathbf{0} \\ \boldsymbol{G}_{i2} & \mathbf{0} & \boldsymbol{F}_{i2} & \dots & \mathbf{0} & \mathbf{0} & \mathbf{0} & \dots & \mathbf{0} \\ \vdots & \vdots & \vdots & & \vdots & \vdots & \vdots & & \vdots \\ \boldsymbol{G}_{i\,l_i} & \mathbf{0} & \mathbf{0} & \dots & \boldsymbol{F}_{i\,l_i} & \mathbf{0} & \mathbf{0} & \dots & \mathbf{0} \\ \boldsymbol{K}_{i1} & \mathbf{0} & \mathbf{0} & \dots & \mathbf{0} & \boldsymbol{J}_{i1} & \mathbf{0} & \dots & \mathbf{0} \\ \boldsymbol{K}_{i2} & \mathbf{0} & \mathbf{0} & \dots & \mathbf{0} & \mathbf{0} & \boldsymbol{J}_{i2} & \dots & \mathbf{0} \\ \vdots & \vdots & \vdots & & \vdots & \vdots & \vdots & & \vdots \\ \boldsymbol{K}_{il_i} & \mathbf{0} & \mathbf{0} & \dots & \mathbf{0} & \mathbf{0} & \mathbf{0} & \dots & \boldsymbol{J}_{i\,l_i} \end{bmatrix} \quad \dim(\boldsymbol{H}_i) = \left(\sum_{\boldsymbol{j=1}}^{l_i} n_j + \sum_{\boldsymbol{j=1}}^{l_i} h_j\right) \times (3 + 14 l_i)$$

[179] $$\boldsymbol{z}_i = \begin{bmatrix} I_{xx}(m_i) \\ I_{xz}(m_i) \\ I_{zz}(m_i) \\ \boldsymbol{C}_{\boldsymbol{R},i1} \\ \boldsymbol{C}_{\boldsymbol{R},i2} \\ \vdots \\ \boldsymbol{C}_{\boldsymbol{R},il_i} \\ \boldsymbol{C}_{\boldsymbol{Y},i1} \\ \boldsymbol{C}_{\boldsymbol{Y},i2} \\ \vdots \\ \boldsymbol{C}_{\boldsymbol{Y},il_i} \end{bmatrix} \quad \dim(\boldsymbol{z}_i) = (3 + 14 l_i) \times 1$$

[180] $$\boldsymbol{O}_i = \begin{bmatrix} 0 \\ 0 \\ \vdots \\ 0 \end{bmatrix} \quad \dim(\boldsymbol{O}_i) = \left( \sum_{\boldsymbol{j=1}}^{l_i} n_j + \sum_{\boldsymbol{j=1}}^{l_i} h_j \right) \times 1$$

[181] $$\boldsymbol{z}_i = (\boldsymbol{H}_i{}^T \boldsymbol{H}_i)^{-1} \boldsymbol{H}_i{}^T \boldsymbol{O}_i$$

[182] $$I_{xx}(m_i) = \boldsymbol{z}_i[1]$$

[183] $$I_{xz}(m_i) = \boldsymbol{z}_i[2]$$

[184] $$I_{zz}(m_i) = \boldsymbol{z}_i[3]$$

Repeating the process for different values of the actual mass would render the variation of $\{I_{xx}(m), I_{xz}(m), I_{zz}(m)\}$ with $m$ for $i$ = 1,...,$k$

Now, referring back to the balance condition governed by expressions [73], [118] and [119] for the identification cases considered:

[185] $$\frac{1}{2} \kappa p_0 \delta M_{ij}{}^2 S b_w C_{R,0}\left(\alpha_{ij}, M_{ij}, \varepsilon_{h,ij}\right) = -T_{ij} E_1 - M_{T,ij} = -T_{ij} E_1 - m_{MTOW} b_w{}^2 N_{s,ij}{}^2 C_{M_T}$$

[186] $$\frac{1}{2} \kappa p_0 \delta M_{ij}{}^2 S c_w C_{P,0}\left(\alpha_{ij}, M_{ij}, \varepsilon_{h,ij}\right) = -T_{ij} E_2 + M_{T,ij} \upsilon = -T_{ij} E_2 + m_{MTOW} b_w{}^2 N_{s,ij}{}^2 C_{M_T} \upsilon$$

[187] $$\frac{1}{2} \kappa p_0 \delta M_{ij}{}^2 S b_w C_{Y,0}\left(\alpha_{ij}, M_{ij}, \varepsilon_{h,ij}\right) = -T_{ij} E_3 + M_{T,ij} \varepsilon = -T_{ij} E_3 + m_{MTOW} b_w{}^2 N_{s,ij}{}^2 C_{M_T} \varepsilon$$

with $T_{ij}$ for the different flight conditions given by the thrust model already known and $M_T$ given by expression [64].

Expressions [185], [186] and [187] contain 4 more unknowns than equations. To reduce the system encompassed by [185], [186] and [187] to an overdetermined system, it is introduced a Taylor expansion for $C_{R,0}$, $C_{P,0}$ and $C_{Y,0}$ in the form (approximations of higher orders could be employed, if necessary):

[188] $$C_{R,0}\left(\alpha_{ij}, M_{ij}, \varepsilon_{h,ij}\right) = r_0 + r_{\alpha 1} \alpha_{ij} + r_{M1} M_{ij} + r_{\varepsilon_h 1} \varepsilon_{h,ij}$$

[189] $$C_{P,0}\left(\alpha_{ij}, M_{ij}, \varepsilon_{h,ij}\right) = p_0 + p_{\alpha 1} \alpha_{ij} + p_{M1} M_{ij} + p_{\varepsilon_h 1} \varepsilon_{h,ij}$$

[190] $$C_{Y,0}\left(\alpha_{ij}, M_{ij}, \varepsilon_{h,ij}\right) = y_0 + y_{\alpha 1}\alpha_{ij} + y_{M1}M_{ij} + y_{\varepsilon_h 1}\varepsilon_{h,ij}$$

which renders the following linear observation system for $\{r_0, r_{\alpha 1}, r_{M1}, r_{\varepsilon h1}, p_0, p_{\alpha 1}, p_{M1}, p_{\varepsilon h1}, y_0, y_{\alpha 1}, y_{M1}, y_{\varepsilon h1}\}$ and $\{E_1, E_2, E_3, C_{M_T}\}$:

[191] $$\boldsymbol{H}_i = \begin{bmatrix}
\frac{T_{i1}}{\frac{1}{2}\kappa p_0 \delta S b_w} & 0 & 0 & \frac{m_{MTOW}{b_w}^2{N_{s,i1}}^2}{\frac{1}{2}\kappa p_0 \delta S c_w} & {M_{i1}}^2 & {M_{i1}}^2\alpha_{i1} & {M_{i1}}^3 & {M_{i1}}^2\varepsilon_{h,i1} & 0 & 0 & 0 & 0 & 0 & 0 & 0 & 0 \\
\frac{T_{i2}}{\frac{1}{2}\kappa p_0 \delta S b_w} & 0 & 0 & \frac{m_{MTOW}{b_w}^2{N_{s,i2}}^2}{\frac{1}{2}\kappa p_0 \delta S c_w} & {M_{i2}}^2 & {M_{i2}}^2\alpha_{i2} & {M_{i2}}^3 & {M_{i2}}^2\varepsilon_{h,i2} & 0 & 0 & 0 & 0 & 0 & 0 & 0 & 0 \\
\vdots & \vdots & \vdots & \vdots & \vdots & \vdots & \vdots & \vdots & \vdots & \vdots & \vdots & \vdots & \vdots & \vdots & \vdots & \vdots \\
\frac{T_{il_i}}{\frac{1}{2}\kappa p_0 \delta S b_w} & 0 & 0 & \frac{m_{MTOW}{b_w}^2{N_{s,il_i}}^2}{\frac{1}{2}\kappa p_0 \delta S c_w} & {M_{il_i}}^2 & {M_{il_i}}^2\alpha_{il_i} & {M_{il_i}}^3 & {M_{il_i}}^2\varepsilon_{h,il_i} & 0 & 0 & 0 & 0 & 0 & 0 & 0 & 0 \\
0 & \frac{T_{i1}}{\frac{1}{2}\kappa p_0 \delta S b_w} & 0 & -\frac{m_{MTOW}{b_w}^2{N_{s,i1}}^2\upsilon}{\frac{1}{2}\kappa p_0 \delta S c_w} & 0 & 0 & 0 & 0 & {M_{i1}}^2 & {M_{i1}}^2\alpha_{i1} & {M_{i1}}^3 & {M_{i1}}^2\varepsilon_{h,i1} & 0 & 0 & 0 & 0 \\
0 & \frac{T_{i2}}{\frac{1}{2}\kappa p_0 \delta S b_w} & 0 & -\frac{m_{MTOW}{b_w}^2{N_{s,i2}}^2\upsilon}{\frac{1}{2}\kappa p_0 \delta S c_w} & 0 & 0 & 0 & 0 & {M_{i2}}^2 & {M_{i2}}^2\alpha_{i2} & {M_{i2}}^3 & {M_{i2}}^2\varepsilon_{h,i2} & 0 & 0 & 0 & 0 \\
\vdots & \vdots & \vdots & \vdots & \vdots & \vdots & \vdots & \vdots & \vdots & \vdots & \vdots & \vdots & \vdots & \vdots & \vdots & \vdots \\
0 & \frac{T_{il_i}}{\frac{1}{2}\kappa p_0 \delta S b_w} & 0 & -\frac{m_{MTOW}{b_w}^2{N_{s,il_i}}^2\upsilon}{\frac{1}{2}\kappa p_0 \delta S c_w} & 0 & 0 & 0 & 0 & {M_{il_i}}^2 & {M_{il_i}}^2\alpha_{il_i} & {M_{il_i}}^3 & {M_{il_i}}^2\varepsilon_{h,il_i} & 0 & 0 & 0 & 0 \\
0 & 0 & \frac{T_{i1}}{\frac{1}{2}\kappa p_0 \delta S b_w} & -\frac{m_{MTOW}{b_w}^2{N_{s,i1}}^2\varepsilon}{\frac{1}{2}\kappa p_0 \delta S c_w} & 0 & 0 & 0 & 0 & 0 & 0 & 0 & 0 & {M_{i1}}^2 & {M_{i1}}^2\alpha_{i1} & {M_{i1}}^3 & {M_{i1}}^2\varepsilon_{h,i1} \\
0 & 0 & \frac{T_{i1}}{\frac{1}{2}\kappa p_0 \delta S b_w} & -\frac{m_{MTOW}{b_w}^2{N_{s,i2}}^2\varepsilon}{\frac{1}{2}\kappa p_0 \delta S c_w} & 0 & 0 & 0 & 0 & 0 & 0 & 0 & 0 & {M_{i2}}^2 & {M_{i2}}^2\alpha_{i2} & {M_{i2}}^3 & {M_{i2}}^2\varepsilon_{h,i2} \\
\vdots & \vdots & \vdots & \vdots & \vdots & \vdots & \vdots & \vdots & \vdots & \vdots & \vdots & \vdots & \vdots & \vdots & \vdots & \vdots \\
0 & 0 & \frac{T_{il_i}}{\frac{1}{2}\kappa p_0 \delta S b_w} & -\frac{m_{MTOW}{b_w}^2{N_{s,il_i}}^2\varepsilon}{\frac{1}{2}\kappa p_0 \delta S c_w} & 0 & 0 & 0 & 0 & 0 & 0 & 0 & 0 & {M_{il_i}}^2 & {M_{il_i}}^2\alpha_{il_i} & {M_{il_i}}^3 & {M_{il_i}}^2\varepsilon_{h,il_i}
\end{bmatrix}$$

[192] $$\boldsymbol{z} = \begin{bmatrix} E_1 \\ E_2 \\ E_3 \\ C_{M_T} \\ r_0 \\ r_{\alpha 1} \\ r_{M1} \\ r_{\varepsilon_h 1} \\ p_0 \\ p_{\alpha 1} \\ p_{M1} \\ p_{\varepsilon_h 1} \\ y_0 \\ y_{\alpha 1} \\ y_{M1} \\ y_{\varepsilon_h 1} \end{bmatrix} \qquad \dim(\boldsymbol{z}) = 16 \times 1$$

[193] $$\boldsymbol{O}_i = \begin{bmatrix} 0 \\ 0 \\ \vdots \\ 0 \end{bmatrix} \qquad \dim(\boldsymbol{O}_i) = 3l_i \times 1$$

[194] $$\boldsymbol{H} = \begin{bmatrix} \boldsymbol{H}_1 \\ \boldsymbol{H}_2 \\ \vdots \\ \boldsymbol{H}_k \end{bmatrix} \qquad \dim(\boldsymbol{H}) = \boldsymbol{3}kl_i \times 16$$

[195] $$\boldsymbol{O} = \begin{bmatrix} \boldsymbol{O}_1 \\ \boldsymbol{O}_2 \\ \vdots \\ \boldsymbol{O}_k \end{bmatrix} \qquad \dim(\boldsymbol{O}) = 3kl_i \times 1$$

[196] $$\boldsymbol{z} = (\boldsymbol{H}^T\boldsymbol{H})^{-1}\boldsymbol{H}^T\boldsymbol{O}$$

[197] $$E_1 = \boldsymbol{z}[1]$$

[198] $$E_2 = \boldsymbol{z}[2]$$

[199] $$E_3 = \boldsymbol{z}[3]$$

[200] $$C_{M_T} = \boldsymbol{z}[4]$$

Step **250** for determination of the aerodynamic moments model

Once the parameters of the propulsive models have been identified, expression [53] can be used again, this time as a direct observer for the aerodynamic moment coefficients as follows:

[201] $$\begin{bmatrix} \frac{1}{2}\kappa p_0 \delta M^2 S b_w C_R \\ \frac{1}{2}\kappa p_0 \delta M^2 S c_w C_P \\ \frac{1}{2}\kappa p_0 \delta M^2 S b_w C_Y \end{bmatrix} = \begin{bmatrix} I_{xx} & 0 & -I_{xz} \\ 0 & I_{yy} & 0 \\ -I_{xz} & 0 & I_{zz} \end{bmatrix} \begin{bmatrix} \dot{p} - D_9 pq + D_{10} qr \\ \dot{q} + D_{11}(p^2 - r^2) + D_{12} pr \\ \dot{r} - D_{13} pq + D_{14} qr \end{bmatrix} - \begin{bmatrix} R_P \\ P_P \\ Y_P \end{bmatrix}$$

[202] $$\begin{bmatrix} R_P \\ P_P \\ Y_P \end{bmatrix} = T \begin{bmatrix} E_1 \\ E_2 \\ E_3 \end{bmatrix} + M_T \begin{bmatrix} 1 \\ -\upsilon \\ -\varepsilon \end{bmatrix}$$

Expression [201] allows the estimation of the aerodynamic moment coefficients $C_R$, $C_P$ and $C_Y$ in terms of their dependency variables through flight testing, for which the respective domains have to be swept, which can be done manually and or with the help of control loops such as AOS-on-rudder, bank-on-ailerons and q-on-elevator.

In the general case:

[203] $$C_R = C_R\left(\alpha, \beta, M, \hat{\dot{\alpha}}, \hat{\dot{\beta}}, \hat{p}, \hat{q}, \hat{r}, \varepsilon_h, \varepsilon_a, \varepsilon_r, \varepsilon_e\right)$$

[204] $$C_P = C_P\left(\alpha, \beta, M, \hat{\dot{\alpha}}, \hat{\dot{\beta}}, \hat{p}, \hat{q}, \hat{r}, \varepsilon_h, \varepsilon_a, \varepsilon_r, \varepsilon_e\right)$$

[205] $$C_Y = C_Y\left(\alpha, \beta, M, \hat{\dot{\alpha}}, \hat{\dot{\beta}}, \hat{p}, \hat{q}, \hat{r}, \varepsilon_h, \varepsilon_a, \varepsilon_r, \varepsilon_e\right)$$

Typical symmetry assumptions render:

[206] $$C_R = C_R\left(\alpha, \beta, M, \hat{\dot{\alpha}}, \hat{\dot{\beta}}, \hat{p}, \hat{r}, \varepsilon_a, \varepsilon_r\right)$$

[207] $$C_P = C_P\left(\alpha, \beta, M, \hat{\dot{\alpha}}, \hat{\dot{\beta}}, \hat{q}, \varepsilon_h, \varepsilon_e, \varepsilon_r\right)$$

[208] $$C_Y = C_Y\left(\alpha, \beta, M, \hat{\dot{\alpha}}, \hat{\dot{\beta}}, \hat{p}, \hat{r}, \varepsilon_a, \varepsilon_r\right)$$

Additionally, for uncompressible aerodynamics and small AOS the main dependencies of the aerodynamics coefficients under the quasi-steady state and typical symmetry assumptions remain:

[209] $$C_R = C_R\left(\beta, \hat{\dot{\beta}}, \hat{p}, \hat{r}, \varepsilon_a, \varepsilon_r\right)$$

[210] $$C_P = C_P\left(\alpha, \hat{\dot{\alpha}}, \hat{q}, \varepsilon_h, \varepsilon_e, \varepsilon_r\right)$$

[211] $$C_Y = C_Y\left(\beta, \hat{\dot{\beta}}, \hat{p}, \hat{r}, \varepsilon_a, \varepsilon_r\right)$$

Finally, for quasi-steady flight:

[212] $$C_R = C_R(\beta, \hat{p}, \hat{r}, \varepsilon_a, \varepsilon_r)$$

[213] $$C_P = C_P(\alpha, \hat{q}, \varepsilon_h, \varepsilon_e, \varepsilon_r)$$

[214] $$C_Y = C_Y(\beta, \hat{p}, \hat{r}, \varepsilon_a, \varepsilon_r)$$

For fixed-wing UAVs flying at moderate speeds, in quasi-steady coordinated flight, the aerodynamic model of interest is:

[215] $$C_L = C_L(\alpha, \hat{q}, \varepsilon_h, \varepsilon_e)$$

[216] $$C_Q = C_Q(\beta, \hat{p}, \hat{r}, \varepsilon_a, \varepsilon_r)$$

[217] $$C_D = C_D(\alpha, \hat{q}, \varepsilon_h, \varepsilon_e)$$

[218] $$C_R = C_R(\beta, \hat{p}, \hat{r}, \varepsilon_a, \varepsilon_r)$$

[219] $$C_P = C_P(\alpha, \hat{q}, \varepsilon_h, \varepsilon_e, \varepsilon_r)$$

[220] $$C_Y = C_Y(\beta, \hat{p}, \hat{r}, \varepsilon_a, \varepsilon_r)$$

The propulsive model is characterized by:

[221] $$C_T(\delta, \theta, M, \varepsilon_T)$$

[222] $$\{\varepsilon, \upsilon\}$$

[223] $\{E_1, E_2, E_3\}$

[224] $C_{M_T}$

The mass and inertia properties are characterized by:

[225] $C_F = C_F(\delta, \theta, \varepsilon_T)$

[226] $I_{xx} = I_{xx}(m)$

[227] $I_{yy} = I_{yy}(m)$

[228] $I_{zz} = I_{zz}(m)$

[229] $I_{xz} = I_{xz}(m)$

Based on the afore described approach, an automated flight test procedure may be implemented that obtains an APM with the help of several basic control loops:

- AOS-on-rudder
- Altitude-on-bank
- Speed-on-elevator
- AOA-on-elevator
- Pitch rate-on-elevator

Once the propulsive forces and moments model are well identified, the aerodynamic model may be continuously identified while-on-the-flight, populating the respective n-dimensional hypercubes allocated to each aerodynamic coefficient (cell-mapping) continuously averaging the new value estimated for each cell with the previously existing one. To that end, an acceptable tradeoff between the range and discretization step of each dependency variable and available runtime memory must be achieved.

A measure of the goodness of the LS fit in every linear observation problem considered above can be obtained through the RMS (Root Mean Square) error:

[230] $\boldsymbol{e} = \boldsymbol{Hz} - \boldsymbol{O}$

[231] $SSE = \boldsymbol{e}^T\boldsymbol{e}$

Sum of Square Errors

[232] $RMS = \sqrt{\frac{SSE}{\dim(e)}}$

Root Mean Square

**Linearization of the equations of motion (linear motion of the CoG)**

Linear motion equations in BFS:

[233] $$\begin{bmatrix} L\sin\alpha + Q\sin\beta\cos\alpha - D\cos\beta\cos\alpha \\ -D\sin\beta - Q\cos\beta \\ -L\cos\alpha + Q\sin\beta\sin\alpha - D\cos\beta\sin\alpha \end{bmatrix} + T\begin{bmatrix} 1 \\ -\upsilon \\ -\varepsilon \end{bmatrix} = m\begin{bmatrix} a_1^{BFS} \\ a_2^{BFS} \\ a_3^{BFS} \end{bmatrix}$$

Longitudinal motion with AOS-on-rudder to ensure coordinated flight:

[234] $$\dot{\beta} \equiv \beta \equiv 0$$

[235] $$p \equiv r \equiv 0$$

[236] $$\begin{aligned} L\sin\alpha - D\cos\alpha + T &= ma_1^{BFS} \\ -L\cos\alpha - D\sin\alpha - T\varepsilon &= ma_3^{BFS} \end{aligned}$$

[237] $$\begin{aligned} &\frac{1}{2}\kappa p_0\delta M^2 S[C_L\sin\alpha - C_D\cos\alpha] + W_{MTOW}\delta C_T = ma_1^{BFS} \\ &-\frac{1}{2}\kappa p_0\delta M^2 S[C_L\cos\alpha + C_D\sin\alpha] - W_{MTOW}\delta C_T\varepsilon = ma_3^{BFS} \end{aligned}$$

Close enough to the balanced flight condition and, as long as $\varepsilon_e$ is held null, $\varepsilon_a$ and $\varepsilon_r$ are close to null and $\varepsilon_{h,0}$ is held constant, the aerodynamic lift and drag coefficients can be approximated by the respective Taylor expansions in the form:

[238] $$C_L(\alpha, 0, M, \hat{\dot{\alpha}}, 0{,}0, \hat{q}, 0, \varepsilon_{h,0}, 0{,}0{,}0) = C_L(\alpha, M, \hat{\dot{\alpha}}, \hat{q}) = C_{L,0} + C_{L,\alpha}\Delta\alpha + C_{L,M}\Delta M + C_{L,\hat{\dot{\alpha}}}\hat{\dot{\alpha}} + C_{L,\hat{q}}\hat{q} = C_{L,0} + \Delta C_L$$

[239] $$C_D(\alpha, 0, M, \hat{\dot{\alpha}}, 0{,}0, \hat{q}, 0, \varepsilon_{h,0}, 0{,}0{,}0) = C_D(\alpha, M, \hat{\dot{\alpha}}, \hat{q}) = C_{D,0} + C_{D,\alpha}\Delta\alpha + C_{D,M}\Delta M + C_{D,\hat{\dot{\alpha}}}\hat{\dot{\alpha}} + C_{D,\hat{q}}\hat{q} = C_{D,0} + \Delta C_D$$

[240] $$C_{L,\hat{\dot{\alpha}}}\hat{\dot{\alpha}} = C_{L,\hat{\dot{\alpha}}}\frac{\dot{\alpha}c_W}{2v_{TAS}} = C_{L,\hat{\dot{\alpha}}}\frac{c_W}{2a_0}\frac{\dot{\alpha}}{M} = C_{L,\dot{\alpha}}\frac{\dot{\alpha}}{M} \qquad C_{L,\dot{\alpha}} = C_{L,\hat{\dot{\alpha}}}\frac{c_W}{2a_0}$$

[241] $$C_{L,\hat{q}}\hat{q} = C_{L,\hat{q}}\frac{qc_W}{2v_{TAS}} = C_{L,\hat{q}}\frac{c_W}{2a_0}\frac{q}{M} = C_{L,q}\frac{q}{M} \qquad C_{L,q} = C_{L,\hat{q}}\frac{c_W}{2a_0}$$

[242] $$C_{D,\hat{\dot{\alpha}}}\hat{\dot{\alpha}} = C_{D,\hat{\dot{\alpha}}}\frac{\dot{\alpha}c_W}{2v_{TAS}} = C_{D,\hat{\dot{\alpha}}}\frac{c_W}{2a_0}\frac{\dot{\alpha}}{M} = C_{D,\dot{\alpha}}\frac{\dot{\alpha}}{M} \qquad C_{D,\dot{\alpha}} = C_{L,\hat{\dot{\alpha}}}\frac{c_W}{2a_0}$$

[243] $$C_{D,\hat{q}}\hat{q} = C_{D,\hat{q}}\frac{qc_W}{2v_{TAS}} = C_{D,\hat{q}}\frac{c_W}{2a_0}\frac{q}{M} = C_{D,q}\frac{q}{M} \qquad C_{D,q} = C_{D,\hat{q}}\frac{c_W}{2a_0}$$

[244] $$C_L(\alpha, M, \hat{\dot{\alpha}}, \hat{q}) = C_{L,0} + C_{L,\alpha}\Delta\alpha + C_{L,M}\Delta M + C_{L,\dot{\alpha}}\frac{\dot{\alpha}}{M} + C_{L,q}\frac{q}{M}$$

[245] $$C_D(\alpha, M, \hat{\alpha}, \hat{q}) = C_{D,0} + C_{D,\alpha}\Delta\alpha + C_{D,M}\Delta M + C_{D,\dot{\alpha}}\frac{\dot{\alpha}}{M} + C_{D,q}\frac{q}{M}$$

As for the thrust coefficient, assuming level flight at the trim condition and the fact that the throttle level does not change:

[246] $$C_T(\delta, \theta, M, \varepsilon_{T,0}) = C_{T,0}(\delta, \theta, M_0, \varepsilon_{T,0}) + C_{T,M}(\delta, \theta, M_0, \varepsilon_{T,0})\Delta M$$

At the balanced flight condition:

[247] $$\begin{array}{l} \frac{1}{2}\kappa p_0 \delta {M_0}^2 S[C_{L,0}\sin\alpha_0 - C_{D,0}\cos\alpha_0] + W_{MTOW}\delta C_{T,0} = m_0 a_{1,0}^{BFS} \\ -\frac{1}{2}\kappa p_0 \delta {M_0}^2 S[C_{L,0}\cos\alpha_0 + C_{D,0}\sin\alpha_0] - W_{MTOW}\delta C_{T,0}\varepsilon = m_0 a_{3,0}^{BFS} \end{array}$$

And close enough to the balanced flight condition:

[248] $$\begin{array}{l} \frac{1}{2}\kappa p_0 \delta M^2 S(C_L\sin\alpha - C_D\cos\alpha) + W_{MTOW}\delta C_T = m_0(a_{1,0}^{BFS} + \Delta a_1^{BFS}) \\ -\frac{1}{2}\kappa p_0 \delta M^2 S(C_L\cos\alpha + C_D\sin\alpha) - W_{MTOW}\delta C_T\varepsilon = m_0(a_{3,0}^{BFS} + \Delta a_3^{BFS}) \end{array}$$

[249] $$\begin{array}{l} \Delta a_1^{BFS} = a_1^{BFS} - a_{1,0}^{BFS} \\ \Delta a_3^{BFS} = a_3^{BFS} - a_{3,0}^{BFS} \end{array}$$

[250] $$\begin{array}{l} C_L\sin(\alpha_0 + \Delta\alpha) - C_D\cos(\alpha_0 + \Delta\alpha) = C_L(\sin\alpha_0\cos\Delta\alpha + \cos\alpha_0\sin\Delta\alpha) - C_D(\cos\alpha_0\cos\Delta\alpha - \sin\alpha_0\sin\Delta\alpha) \\ C_L\cos(\alpha_0 + \Delta\alpha) + C_D\sin(\alpha_0 + \Delta\alpha) = C_L(\cos\alpha_0\cos\Delta\alpha - \sin\alpha_0\sin\Delta\alpha) + C_D(\sin\alpha_0\cos\Delta\alpha + \cos\alpha_0\sin\Delta\alpha) \end{array}$$

[251] $$\Delta\alpha \ll 1$$

[252] $$\begin{array}{l} C_L\sin(\alpha_0 + \Delta\alpha) - C_D\cos(\alpha_0 + \Delta\alpha) \approx \\ \approx C_L(\sin\alpha_0 + \cos\alpha_0\Delta\alpha) - C_D(\cos\alpha_0 - \sin\alpha_0\Delta\alpha) = C_L\sin\alpha_0 - C_D\cos\alpha_0 + (C_L\cos\alpha_0 + C_D\sin\alpha_0)\Delta\alpha \\ C_L\cos(\alpha_0 + \Delta\alpha) + C_D\sin(\alpha_0 + \Delta\alpha) \approx C_L(\cos\alpha_0 - \sin\alpha_0\Delta\alpha) + C_D(\sin\alpha_0 + \cos\alpha_0\Delta\alpha) = \\ = C_L\cos\alpha_0 + C_D\sin\alpha_0 - (C_L\sin\alpha_0 - C_D\cos\alpha_0)\Delta\alpha \end{array}$$

[253] $$\begin{array}{l} C_L\sin(\alpha_0 + \Delta\alpha) - C_D\cos(\alpha_0 + \Delta\alpha) + C_L\cos(\alpha_0 + \Delta\alpha) + C_D\sin(\alpha_0 + \Delta\alpha) = \\ = C_L\sin\alpha_0 - C_D\cos\alpha_0 + (C_L\cos\alpha_0 + C_D\sin\alpha_0)\Delta\alpha + C_L\cos\alpha_0 + C_D\sin\alpha_0 - (C_L\sin\alpha_0 - C_D\cos\alpha_0)\Delta\alpha \\ C_L\sin(\alpha_0 + \Delta\alpha) - C_D\cos(\alpha_0 + \Delta\alpha) - C_L\cos(\alpha_0 + \Delta\alpha) - C_D\sin(\alpha_0 + \Delta\alpha) = \\ = C_L\sin\alpha_0 - C_D\cos\alpha_0 + (C_L\cos\alpha_0 + C_D\sin\alpha_0)\Delta\alpha - C_L\cos\alpha_0 - C_D\sin\alpha_0 + (C_L\sin\alpha_0 - C_D\cos\alpha_0)\Delta\alpha \end{array}$$

[254] $$\begin{array}{l} C_L\sin(\alpha_0 + \Delta\alpha) - C_D\cos(\alpha_0 + \Delta\alpha) + C_L\cos(\alpha_0 + \Delta\alpha) + C_D\sin(\alpha_0 + \Delta\alpha) = \\ = \sin\alpha_0 C_L(1 - \Delta\alpha) - \cos\alpha_0 C_D(1 - \Delta\alpha) + \cos\alpha_0 C_L(1 + \Delta\alpha) + \sin\alpha_0 C_D(1 + \Delta\alpha) \\ C_L\sin(\alpha_0 + \Delta\alpha) - C_D\cos(\alpha_0 + \Delta\alpha) - C_L\cos(\alpha_0 + \Delta\alpha) - C_D\sin(\alpha_0 + \Delta\alpha) = \\ = \sin\alpha_0 C_L(1 + \Delta\alpha) - \cos\alpha_0 C_D(1 + \Delta\alpha) - \cos\alpha_0 C_L(1 - \Delta\alpha) - \sin\alpha_0 C_D(1 - \Delta\alpha) \end{array}$$

[255] $$\Delta\alpha \ll 1$$

[256]
$$C_L\sin(\alpha_0+\Delta\alpha)-C_D\cos(\alpha_0+\Delta\alpha)+C_L\cos(\alpha_0+\Delta\alpha)+C_D\sin(\alpha_0+\Delta\alpha)\approx$$
$$\approx\sin\alpha_0 C_L-\cos\alpha_0 C_D+\cos\alpha_0 C_L+\sin\alpha_0 C_D$$
$$C_L\sin(\alpha_0+\Delta\alpha)-C_D\cos(\alpha_0+\Delta\alpha)-C_L\cos(\alpha_0+\Delta\alpha)-C_D\sin(\alpha_0+\Delta\alpha)\approx$$
$$\approx\sin\alpha_0 C_L-\cos\alpha_0 C_D-\cos\alpha_0 C_L-\sin\alpha_0 C_D$$

[257]
$$\frac{1}{2}\kappa p_0\delta M^2 S(\sin\alpha_0 C_L-\cos\alpha_0 C_D+\cos\alpha_0 C_L+\sin\alpha_0 C_D)+W_{MTOW}\delta C_T(1+\varepsilon)=m_0\left(a_{1,0}^{BFS}-a_{3,0}^{BFS}+\Delta a_1^{BFS}-\Delta a_3^{BFS}\right)$$
$$\frac{1}{2}\kappa p_0\delta M^2 S(\sin\alpha_0 C_L-\cos\alpha_0 C_D-\cos\alpha_0 C_L-\sin\alpha_0 C_D)+W_{MTOW}\delta C_T(1-\varepsilon)=m_0\left(a_{1,0}^{BFS}+a_{3,0}^{BFS}+\Delta a_1^{BFS}+\Delta a_3^{BFS}\right)$$

[258]
$$\frac{1}{2}\kappa p_0\delta M^2 S(\sin\alpha_0 C_L-\cos\alpha_0 C_D)+W_{MTOW}\delta C_T=m_0\left(a_{1,0}^{BFS}+\Delta a_1^{BFS}\right)$$
$$-\frac{1}{2}\kappa p_0\delta M^2 S(\cos\alpha_0 C_L+\sin\alpha_0 C_D)-W_{MTOW}\delta C_T\varepsilon=m_0\left(a_{3,0}^{BFS}+\Delta a_3^{BFS}\right)$$

[259]
$$\frac{1}{2}\kappa p_0\delta M^2 S\left[\sin\alpha_0\left(C_{L,0}+\Delta C_L\right)-\cos\alpha_0\left(C_{D,0}+\Delta C_D\right)\right]+W_{MTOW}\delta\left(C_{T,0}+C_{T,M}\Delta M\right)=m_0\left(a_{1,0}^{BFS}+\Delta a_1^{BFS}\right)$$
$$-\frac{1}{2}\kappa p_0\delta M^2 S\left[\cos\alpha_0\left(C_{L,0}+\Delta C_L\right)+\sin\alpha_0\left(C_{D,0}+\Delta C_D\right)\right]-W_{MTOW}\delta\left(C_{T,0}+C_{T,M}\Delta M\right)\varepsilon=m_0\left(a_{3,0}^{BFS}+\Delta a_3^{BFS}\right)$$

[260]
$$\frac{1}{2}\kappa p_0\delta M^2 S\left(\sin\alpha_0 C_{L,0}-\cos\alpha_0 C_{D,0}\right)+\frac{1}{2}\kappa p_0\delta M^2 S(\sin\alpha_0\Delta C_L-\cos\alpha_0\Delta C_D)+W_{MTOW}\delta\left(C_{T,0}+C_{T,M}\Delta M\right)=m_0\left(a_{1,0}^{BFS}+\Delta a_1^{BFS}\right)$$
$$-\frac{1}{2}\kappa p_0\delta M^2 S\left(\cos\alpha_0 C_{L,0}+\sin\alpha_0 C_{D,0}\right)-\frac{1}{2}\kappa p_0\delta M^2 S(\cos\alpha_0\Delta C_L+\sin\alpha_0\Delta C_D)-W_{MTOW}\delta\left(C_{T,0}+C_{T,M}\Delta M\right)\varepsilon=m_0\left(a_{3,0}^{BFS}+\Delta a_3^{BFS}\right)$$

[261]
$$M^2=(M_0+\Delta M)^2={M_0}^2+2M_0\Delta M+\Delta M^2={M_0}^2\left[1+2\frac{\Delta M}{M_0}+\left(\frac{\Delta M}{M_0}\right)^2\right]$$

[262]
$$\frac{\Delta M}{M_0}\ll 1$$

[263]
$$M^2\approx{M_0}^2\left(1+2\frac{\Delta M}{M_0}\right)$$

[264]
$$\frac{1}{2}\kappa p_0\delta S\left({M_0}^2+2M_0\Delta M\right)\left(\sin\alpha_0 C_{L,0}-\cos\alpha_0 C_{D,0}\right)+\frac{1}{2}\kappa p_0\delta SM^2(\sin\alpha_0\Delta C_L-\cos\alpha_0\Delta C_D)+W_{MTOW}\delta\left(C_{T,0}+C_{T,M}\Delta M\right)=$$
$$=m_0\left(a_{1,0}^{BFS}+\Delta a_1^{BFS}\right)$$
$$-\frac{1}{2}\kappa p_0\delta S\left({M_0}^2+2M_0\Delta M\right)\left(\cos\alpha_0 C_{L,0}+\sin\alpha_0 C_{D,0}\right)-\frac{1}{2}\kappa p_0\delta SM^2(\cos\alpha_0\Delta C_L+\sin\alpha_0\Delta C_D)-W_{MTOW}\delta\left(C_{T,0}+C_{T,M}\Delta M\right)\varepsilon=$$
$$=m_0\left(a_{3,0}^{BFS}+\Delta a_3^{BFS}\right)$$

Bearing in mind [247]:

[265]
$$\kappa p_0\delta SM_0\Delta M\left(\sin\alpha_0 C_{L,0}-\cos\alpha_0 C_{D,0}\right)+\frac{1}{2}\kappa p_0\delta SM^2(\sin\alpha_0\Delta C_L-\cos\alpha_0\Delta C_D)+W_{MTOW}\delta C_{T,M}\Delta M=m_0\Delta a_1^{BFS}$$
$$-\kappa p_0\delta SM_0\Delta M\left(\cos\alpha_0 C_{L,0}+\sin\alpha_0 C_{D,0}\right)-\frac{1}{2}\kappa p_0\delta SM^2(\cos\alpha_0\Delta C_L+\sin\alpha_0\Delta C_D)-W_{MTOW}\delta C_{T,M}\Delta M\varepsilon=m_0\Delta a_3^{BFS}$$

[266]
$$\kappa p_0\delta SM_0\left(\sin\alpha_0 C_{L,0}-\cos\alpha_0 C_{D,0}\right)\Delta M+$$
$$+\frac{1}{2}\kappa p_0\delta M^2 S\left[\sin\alpha_0\left(C_{L,\alpha}\Delta\alpha+C_{L,M}\Delta M+C_{L,\dot\alpha}\frac{\dot\alpha}{M}+C_{L,q}\frac{q}{M}\right)-\cos\alpha_0\left(C_{D,\alpha}\Delta\alpha+C_{D,M}\Delta M+C_{D,\dot\alpha}\frac{\dot\alpha}{M}+C_{D,q}\frac{q}{M}\right)\right]+$$
$$+W_{MTOW}\delta C_{T,M}\Delta M=m_0\Delta a_1^{BFS}$$
$$-\kappa p_0\delta SM_0\left(\cos\alpha_0 C_{L,0}+\sin\alpha_0 C_{D,0}\right)\Delta M-$$
$$-\frac{1}{2}\kappa p_0\delta M^2 S\left[\cos\alpha_0\left(C_{L,\alpha}\Delta\alpha+C_{L,M}\Delta M+C_{L,\dot\alpha}\frac{\dot\alpha}{M}+C_{L,q}\frac{q}{M}\right)+\sin\alpha_0\left(C_{D,\alpha}\Delta\alpha+C_{D,M}\Delta M+C_{D,\dot\alpha}\frac{\dot\alpha}{M}+C_{D,q}\frac{q}{M}\right)\right]-$$
$$-W_{MTOW}\delta C_{T,M}\Delta M\varepsilon=m_0\Delta a_3^{BFS}$$

[267] $$M^2\Delta M = (M_0+\Delta M)^2\Delta M = \left({M_0}^2 + 2M_0\Delta M + \Delta M^2\right)\Delta M = {M_0}^2\left[1 + 2\frac{\Delta M}{M_0} + \left(\frac{\Delta M}{M_0}\right)^2\right]\Delta M \approx {M_0}^2\left(1 + 2\frac{\Delta M}{M_0}\right)\Delta M$$

[268] $$\begin{aligned} C_{X,M} &= \frac{2}{M_0}\left(\sin\alpha_0\, C_{L,0} - \cos\alpha_0\, C_{D,0}\right) + \left(\sin\alpha_0\, C_{L,M} - \cos\alpha_0\, C_{D,M}\right) + \frac{W_{MTOW}C_{T,M}}{\frac{1}{2}\kappa p_0 S {M_0}^2} \\ C_{Z,M} &= \frac{2}{M_0}\left(\cos\alpha_0\, C_{L,0} + \sin\alpha_0\, C_{D,0}\right) + \left(\cos\alpha_0\, C_{L,M} + \sin\alpha_0\, C_{D,M}\right) + \frac{W_{MTOW}C_{T,M}}{\frac{1}{2}\kappa p_0 S {M_0}^2}\varepsilon \end{aligned}$$

[269] $$\begin{aligned} &\tfrac{1}{2}\kappa p_0 \delta S {M_0}^2 C_{X,M}\Delta M + \\ &+\tfrac{1}{2}\kappa p_0\delta S\left[M^2\left(\sin\alpha_0\, C_{L,\alpha} - \cos\alpha_0\, C_{D,\alpha}\right)\Delta\alpha + 2M_0\left(\sin\alpha_0\, C_{L,M} - \cos\alpha_0\, C_{D,M}\right)\Delta M^2 + M\left(\sin\alpha_0\, C_{L,\dot\alpha} - \cos\alpha_0\, C_{D,\dot\alpha}\right)\dot\alpha + M\left(\sin\alpha_0\, C_{L,q} - \cos\alpha_0\, C_{D,q}\right)q\right] = \\ &= m_0\Delta a_1^{BFS} \\ &-\tfrac{1}{2}\kappa p_0 \delta S {M_0}^2 C_{Z,M}\Delta M - \\ &-\tfrac{1}{2}\kappa p_0\delta S\left[M^2\left(\cos\alpha_0\, C_{L,\alpha} + \sin\alpha_0\, C_{D,\alpha}\right)\Delta\alpha + 2M_0\left(\cos\alpha_0\, C_{L,M} + \sin\alpha_0\, C_{D,M}\right)\Delta M^2 + M\left(\cos\alpha_0\, C_{L,\dot\alpha} + \sin\alpha_0\, C_{D,\dot\alpha}\right)\dot\alpha + M\left(\cos\alpha_0\, C_{L,q} + \sin\alpha_0\, C_{D,q}\right)q\right] = \\ &= m_0\Delta a_3^{BFS} \end{aligned}$$

[270] $$\begin{aligned} C_{X,\alpha} &= \sin\alpha_0\, C_{L,\alpha} - \cos\alpha_0\, C_{D,\alpha} \\ C_{Z,\alpha} &= \cos\alpha_0\, C_{L,\alpha} + \sin\alpha_0\, C_{D,\alpha} \end{aligned}$$

[271] $$\begin{aligned} C_{X,\Delta M} &= \sin\alpha_0\, C_{L,M} - \cos\alpha_0\, C_{D,M} \\ C_{Z,\Delta M} &= \cos\alpha_0\, C_{L,M} + \sin\alpha_0\, C_{D,M} \end{aligned}$$

[272] $$\begin{aligned} C_{X,\dot\alpha} &= \sin\alpha_0\, C_{L,\dot\alpha} - \cos\alpha_0\, C_{D,\dot\alpha} \\ C_{Z,\dot\alpha} &= \cos\alpha_0\, C_{L,\dot\alpha} + \sin\alpha_0\, C_{D,\dot\alpha} \end{aligned}$$

[273] $$\begin{aligned} C_{X,q} &= \sin\alpha_0\, C_{L,q} - \cos\alpha_0\, C_{D,q} \\ C_{Z,q} &= \cos\alpha_0\, C_{L,q} + \sin\alpha_0\, C_{D,q} \end{aligned}$$

[274] $$\begin{aligned} &\frac{1}{2}\kappa p_0\delta S\left({M_0}^2 C_{X,M}\Delta M + M^2 C_{X,\alpha}\Delta\alpha + 2M_0 C_{X,\Delta M}\Delta M^2 + M C_{X,\dot\alpha}\dot\alpha + M C_{X,q}q\right) = m_0\Delta a_1^{BFS} \\ &-\frac{1}{2}\kappa p_0\delta S\left({M_0}^2 C_{Z,M}\Delta M + M^2 C_{Z,\alpha}\Delta\alpha + 2M_0 C_{Z,\Delta M}\Delta M^2 + M C_{Z,\dot\alpha}\dot\alpha + M C_{Z,q}q\right) = m_0\Delta a_3^{BFS} \end{aligned}$$

[275] $$\begin{aligned} &\frac{1}{2}\kappa p_0\delta S\left[{M_0}^2 C_{X,M}\Delta M + {M_0}^2\left(1 + 2\frac{\Delta M}{M_0}\right)C_{X,\alpha}\Delta\alpha + 2M_0 C_{X,\Delta M}\Delta M^2 + (M_0+\Delta M)C_{X,\dot\alpha}\dot\alpha + (M_0+\Delta M)C_{X,q}q\right] = m_0\Delta a_1^{BFS} \\ &-\frac{1}{2}\kappa p_0\delta S\left[{M_0}^2 C_{Z,M}\Delta M + {M_0}^2\left(1 + 2\frac{\Delta M}{M_0}\right)C_{Z,\alpha}\Delta\alpha + 2M_0 C_{Z,\Delta M}\Delta M^2 + (M_0+\Delta M)C_{Z,\dot\alpha}\dot\alpha + (M_0+\Delta M)C_{Z,q}q\right] = m_0\Delta a_3^{BFS} \end{aligned}$$

[276] $$\begin{aligned} &\frac{1}{2}\kappa p_0\delta S{M_0}^2\left[C_{X,\alpha}\Delta\alpha + C_{X,M}\Delta M + \frac{C_{X,\dot\alpha}}{M_0}\dot\alpha + \frac{C_{X,q}}{M_0}q + \left(2\frac{C_{X,\alpha}}{M_0}\Delta\alpha + 2\frac{C_{X,\Delta M}}{M_0}\Delta M + \frac{C_{X,\dot\alpha}}{{M_0}^2}\dot\alpha + \frac{C_{X,q}}{{M_0}^2}q\right)\Delta M\right] = m_0\Delta a_1^{BFS} \\ &-\frac{1}{2}\kappa p_0\delta S{M_0}^2\left[C_{Z,\alpha}\Delta\alpha + C_{Z,M}\Delta M + \frac{C_{Z,\dot\alpha}}{M_0}\dot\alpha + \frac{C_{Z,q}}{M_0}q + \left(2\frac{C_{Z,\alpha}}{M_0}\Delta\alpha + 2\frac{C_{Z,\Delta M}}{M_0}\Delta M + \frac{C_{Z,\dot\alpha}}{{M_0}^2}\dot\alpha + \frac{C_{Z,q}}{{M_0}^2}q\right)\Delta M\right] = m_0\Delta a_3^{BFS} \end{aligned}$$

[277] $$\begin{aligned} &\frac{1}{2}\kappa p_0\delta S C_{Z,\dot\alpha}\left({M_0}^2 C_{X,M}\Delta M + M^2 C_{X,\alpha}\Delta\alpha + 2M_0 C_{X,\Delta M}\Delta M^2 + M C_{X,\dot\alpha}\dot\alpha + M C_{X,q}q\right) = m_0 C_{Z,\dot\alpha}\Delta a_1^{BFS} \\ &-\frac{1}{2}\kappa p_0\delta S C_{X,\dot\alpha}\left({M_0}^2 C_{Z,M}\Delta M + M^2 C_{Z,\alpha}\Delta\alpha + 2M_0 C_{Z,\Delta M}\Delta M^2 + M C_{Z,\dot\alpha}\dot\alpha + M C_{Z,q}q\right) = m_0 C_{X,\dot\alpha}\Delta a_3^{BFS} \end{aligned}$$

[278]
$$\frac{1}{2}\kappa p_0 \delta S\left[{M_0}^2\left(C_{Z,\dot\alpha}C_{X,M} - C_{X,\dot\alpha}C_{Z,M}\right)\Delta M + M^2\left(C_{Z,\dot\alpha}C_{X,\alpha} - C_{X,\dot\alpha}C_{Z,\alpha}\right)\Delta\alpha + 2M_0\left(C_{Z,\dot\alpha}C_{X,\Delta M} - C_{X,\dot\alpha}C_{Z,\Delta M}\right)\Delta M^2 + M\left(C_{Z,\dot\alpha}C_{X,q} - C_{X,\dot\alpha}C_{Z,q}\right)q\right] = \\ = m_0\left(C_{Z,\dot\alpha}\Delta a_1^{BFS} + C_{X,\dot\alpha}\Delta a_3^{BFS}\right)$$
$$\frac{1}{2}\kappa p_0 \delta S\left[{M_0}^2\left(C_{Z,\dot\alpha}C_{X,M} + C_{X,\dot\alpha}C_{Z,M}\right)\Delta M + M^2\left(C_{Z,\dot\alpha}C_{X,\alpha} + C_{X,\dot\alpha}C_{Z,\alpha}\right)\Delta\alpha + 2M_0\left(C_{Z,\dot\alpha}C_{X,\Delta M} + C_{X,\dot\alpha}C_{Z,\Delta M}\right)\Delta M^2 + 2MC_{X,\dot\alpha}C_{Z,\dot\alpha}\dot\alpha + M\left(C_{Z,\dot\alpha}C_{X,q} + C_{X,\dot\alpha}C_{Z,q}\right)q\right] = \\ = m_0\left(C_{Z,\dot\alpha}\Delta a_1^{BFS} - C_{X,\dot\alpha}\Delta a_3^{BFS}\right)$$

[279]
$$\begin{aligned} C_1 &= C_{Z,\dot\alpha}C_{X,M} - C_{X,\dot\alpha}C_{Z,M} \\ C_2 &= C_{Z,\dot\alpha}C_{X,\alpha} - C_{X,\dot\alpha}C_{Z,\alpha} \\ C_3 &= C_{Z,\dot\alpha}C_{X,\Delta M} - C_{X,\dot\alpha}C_{Z,\Delta M} \\ C_4 &= C_{Z,\dot\alpha}C_{X,q} - C_{X,\dot\alpha}C_{Z,q} \\ D_1 &= C_{Z,\dot\alpha}C_{X,M} + C_{X,\dot\alpha}C_{Z,M} \\ D_2 &= C_{Z,\dot\alpha}C_{X,\alpha} + C_{X,\dot\alpha}C_{Z,\alpha} \\ D_3 &= C_{Z,\dot\alpha}C_{X,\Delta M} + C_{X,\dot\alpha}C_{Z,\Delta M} \\ D_4 &= C_{Z,\dot\alpha}C_{X,q} + C_{X,\dot\alpha}C_{Z,q} \\ D_5 &= 2C_{X,\dot\alpha}C_{Z,\dot\alpha} \end{aligned}$$

[280]
$$\frac{1}{2}\kappa p_0 \delta S\left({M_0}^2 C_1 \Delta M + M^2 C_2 \Delta\alpha + 2M_0 C_3 \Delta M^2 + MC_4 q\right) = m_0\left(C_{Z,\dot\alpha}\Delta a_1^{BFS} + C_{X,\dot\alpha}\Delta a_3^{BFS}\right)$$
$$\frac{1}{2}\kappa p_0 \delta S\left({M_0}^2 D_1 \Delta M + M^2 D_2 \Delta\alpha + 2M_0 D_3 \Delta M^2 + MD_4 \dot\alpha + MD_5 q\right) = m_0\left(C_{Z,\dot\alpha}\Delta a_1^{BFS} - C_{X,\dot\alpha}\Delta a_3^{BFS}\right)$$

[281]
$$\frac{1}{2}\kappa p_0 \delta S D_3\left({M_0}^2 C_1 \Delta M + M^2 C_2 \Delta\alpha + 2M_0 C_3 \Delta M^2 + MC_4 q\right) = m_0 D_3\left(C_{Z,\dot\alpha}\Delta a_1^{BFS} + C_{X,\dot\alpha}\Delta a_3^{BFS}\right)$$
$$\frac{1}{2}\kappa p_0 \delta S C_3\left({M_0}^2 D_1 \Delta M + M^2 D_2 \Delta\alpha + 2M_0 D_3 \Delta M^2 + MD_4 q + MD_5 \dot\alpha\right) = m_0 C_3\left(C_{Z,\dot\alpha}\Delta a_1^{BFS} - C_{X,\dot\alpha}\Delta a_3^{BFS}\right)$$

[282]
$$\frac{1}{2}\kappa p_0 \delta S\left[{M_0}^2(C_1D_3 - C_3D_1)\Delta M + M^2(C_2D_3 - C_3D_2)\Delta\alpha + M(C_4D_3 - C_3D_4)q - MC_3D_5\dot\alpha\right] = \\ m_0\left[\Delta a_1^{BFS} C_{Z,\dot\alpha}(D_3 - C_3) + \Delta a_3^{BFS} C_{X,\dot\alpha}(D_3 + C_3)\right]$$

[283]
$$\begin{aligned} F_1 &= C_1D_3 - C_3D_1 \\ F_2 &= C_2D_3 - C_3D_2 \\ F_3 &= C_4D_3 - C_3D_4 \\ F_4 &= C_3D_5 \\ F_5 &= C_{Z,\dot\alpha}(D_3 - C_3) = 2C_{Z,\dot\alpha}C_{X,\dot\alpha}C_{Z,\Delta M} \\ F_6 &= C_{X,\dot\alpha}(D_3 + C_3) = 2C_{X,\dot\alpha}C_{Z,\dot\alpha}C_{X,\Delta M} \end{aligned}$$

[284]
$$\frac{1}{2}\kappa p_0 \delta S\left({M_0}^2 F_1 \Delta M + M^2 F_2 \Delta\alpha + MF_3 q - MF_4\dot\alpha\right) = m_0\left(F_5\Delta a_1^{BFS} + F_6\Delta a_3^{BFS}\right)$$

[285]
$$\frac{1}{2}\kappa p_0 \delta S M F_4 \dot\alpha \frac{C_{P,\dot\alpha}}{C_{P,\dot\alpha}} = \frac{1}{2}\kappa p_0 \delta S\left({M_0}^2 F_1 \Delta M + M^2 F_2 \Delta\alpha + MF_3 q\right) - m_0\left(F_5\Delta a_1^{BFS} + F_6\Delta a_3^{BFS}\right) = \\ \frac{1}{2}\kappa p_0 \delta S\left[{M_0}^2 F_1 \Delta M + M^2 F_2 \Delta\alpha + MF_3 q - \frac{m_0}{\frac{1}{2}\kappa p_0 \delta S}\left(F_5\Delta a_1^{BFS} + F_6\Delta a_3^{BFS}\right)\right]$$

[286]
$$M\dot\alpha = \frac{1}{F_4}\left[{M_0}^2 F_1 \Delta M + M^2 F_2 \Delta\alpha + MF_3 q - \frac{m_0}{\frac{1}{2}\kappa p_0 \delta S}\left(F_5\Delta a_1^{BFS} + F_6\Delta a_3^{BFS}\right)\right]$$

Lateral-directional motion with pitch rate-on-elevator to ensure $q \equiv \dot\alpha \equiv 0$:

$$[287]\quad -D\sin\beta - Q\cos\beta - Tv = ma_2^{BFS}$$

Close enough to the balanced flight condition and, as $\varepsilon_e$ is held close to null, $\varepsilon_a$ and $\varepsilon_r$ are held null and $\varepsilon_{h,0}$ is held constant, the aerodynamic drag and side-force coefficients can be approximated by the respective Taylor expansions in the form:

$$[288]\quad C_D\left(\alpha,\beta,M,0,\hat{\dot{\beta}},\hat{p},0,\hat{r},\varepsilon_{h,0},0{,}0{,}0\right) = C_D\left(\alpha,\beta,M,\hat{\dot{\beta}},\hat{p},\hat{r}\right) = C_{D,0} + C_{D,\alpha}\Delta\alpha + C_{D,\beta}\beta + C_{D,M}\Delta M + C_{D,\hat{\dot{\beta}}}\hat{\dot{\beta}} + C_{D,\hat{p}}\hat{p} + C_{D,\hat{r}}\hat{r} = C_{D,0} + \Delta C_D$$

$$[289]\quad C_Q\left(\alpha,\beta,M,0,\hat{\dot{\beta}},\hat{p},0,\hat{r},\varepsilon_{h,0},0{,}0{,}0\right) = C_Q\left(\alpha,\beta,M,\hat{\dot{\beta}},\hat{p},\hat{r}\right) = C_{Q,0} + C_{Q,\alpha}\Delta\alpha + C_{Q,\beta}\beta + C_{Q,M}\Delta M + C_{Q,\hat{\dot{\beta}}}\hat{\dot{\beta}} + C_{Q,\hat{p}}\hat{p} + C_{Q,\hat{r}}\hat{r} = C_{Q,0} + \Delta C_Q$$

$$[290]\quad C_{D,\hat{\dot{\beta}}}\hat{\dot{\beta}} = C_{D,\hat{\dot{\beta}}}\frac{\dot{\beta}b_w}{2v_{TAS}} = C_{D,\hat{\dot{\beta}}}\frac{b_w}{2a_0}\frac{\dot{\beta}}{M} = C_{D,\dot{\beta}}\frac{\dot{\beta}}{M} \qquad C_{D,\dot{\beta}} = C_{D,\hat{\dot{\beta}}}\frac{b_w}{2a_0}$$

$$[291]\quad C_{Q,\hat{\dot{\beta}}}\hat{\dot{\beta}} = C_{Q,\hat{\dot{\beta}}}\frac{\dot{\beta}b_w}{2v_{TAS}} = C_{Q,\hat{\dot{\beta}}}\frac{b_w}{2a_0}\frac{\dot{\beta}}{M} = C_{Q,\dot{\beta}}\frac{\dot{\beta}}{M} \qquad C_{Q,\dot{\beta}} = C_{Q,\hat{\dot{\beta}}}\frac{b_w}{2a_0}$$

$$[292]\quad C_{D,\hat{p}}\hat{p} = C_{D,\hat{p}}\frac{qb_w}{2v_{TAS}} = C_{D,\hat{p}}\frac{b_w}{2a_0}\frac{p}{M} = C_{D,p}\frac{p}{M} \qquad C_{D,p} = C_{D,\hat{p}}\frac{b_w}{2a_0}$$

$$[293]\quad C_{D,\hat{r}}\hat{r} = C_{D,\hat{r}}\frac{qb_w}{2v_{TAS}} = C_{D,\hat{r}}\frac{b_w}{2a_0}\frac{r}{M} = C_{D,r}\frac{r}{M} \qquad C_{D,r} = C_{D,\hat{r}}\frac{b_w}{2a_0}$$

$$[294]\quad C_{Q,\hat{p}}\hat{p} = C_{Q,\hat{p}}\frac{qb_w}{2v_{TAS}} = C_{Q,\hat{p}}\frac{b_w}{2a_0}\frac{p}{M} = C_{Q,p}\frac{p}{M} \qquad C_{Q,p} = C_{Q,\hat{p}}\frac{b_w}{2a_0}$$

$$[295]\quad C_{Q,\hat{r}}\hat{r} = C_{Q,\hat{r}}\frac{qb_w}{2v_{TAS}} = C_{Q,\hat{r}}\frac{b_w}{2a_0}\frac{r}{M} = C_{Q,r}\frac{r}{M} \qquad C_{Q,r} = C_{Q,\hat{r}}\frac{b_w}{2a_0}$$

$$[296]\quad C_D\left(\alpha,\beta,M,\hat{\dot{\beta}},\hat{p},\hat{r}\right) = C_{D,0} + C_{D,\alpha}\Delta\alpha + C_{D,\beta}\beta + C_{D,M}\Delta M + C_{D,\dot{\beta}}\frac{\dot{\beta}}{M} + C_{D,p}\frac{p}{M} + C_{D,r}\frac{r}{M}$$

$$[297]\quad C_Q\left(\alpha,\beta,M,\hat{\dot{\beta}},\hat{p},\hat{r}\right) = C_{Q,0} + C_{Q,\alpha}\Delta\alpha + C_{Q,\beta}\beta + C_{Q,M}\Delta M + C_{Q,\dot{\beta}}\frac{\dot{\beta}}{M} + C_{Q,p}\frac{p}{M} + C_{Q,r}\frac{r}{M}$$

As for the thrust coefficient, expression [246] still applies.

At the balanced flight condition:

$$[298]\quad \frac{1}{2}\kappa p_0\delta {M_0}^2 SC_{Q,0} - W_{MTOW}\delta C_{T,0}v = m_0 a_{2,0}^{BFS}$$

And close enough to the balanced flight condition:

[299] $$\frac{1}{2}\kappa p_0 \delta M^2 S\left(-C_D \sin\beta - C_Q \cos\beta\right) - W_{MTOW}\delta C_T \upsilon = m_0\left(a_{2,0}^{BFS} + \Delta a_2^{BFS}\right)$$

[300] $$\Delta a_2^{BFS} = a_2^{BFS} - a_{2,0}^{BFS}$$

[301] $$\frac{1}{2}\kappa p_0 \delta M^2 S\left[-\left(C_{D,0} + \Delta C_D\right)\sin\beta - \left(C_{Q,0} + \Delta C_Q\right)\cos\beta\right] - W_{MTOW}\delta\left(C_{T,0} + C_{T,M}\Delta M\right)\upsilon = m_0\left(a_{2,0}^{BFS} + \Delta a_2^{BFS}\right)$$

Bearing in mind [298]:

[302] $$\frac{1}{2}\kappa p_0 \delta M^2 S\left(-\Delta C_D \sin\beta - \Delta C_Q \cos\beta\right) - W_{MTOW}\delta C_{T,M}\upsilon\Delta M = m_0 \Delta a_2^{BFS}$$

[303] $$\beta \ll 1$$

[304] $$\frac{1}{2}\kappa p_0 \delta M^2 S\left(-\Delta C_D \beta - \Delta C_Q\right) - W_{MTOW}\delta C_{T,M}\upsilon\Delta M = m_0 \Delta a_2^{BFS}$$

[305] $$\frac{1}{2}\kappa p_0 \delta M^2 S\left[-\left(C_{D,\alpha}\Delta\alpha + C_{D,\beta}\beta + C_{D,M}\Delta M + C_{D,\dot{\beta}}\frac{\dot{\beta}}{M} + C_{D,p}\frac{p}{M} + C_{D,r}\frac{r}{M}\right)\beta - \left(C_{Q,\alpha}\Delta\alpha + C_{Q,\beta}\beta + C_{Q,M}\Delta M + C_{Q,\dot{\beta}}\frac{\dot{\beta}}{M} + C_{Q,p}\frac{p}{M} + C_{Q,r}\frac{r}{M}\right)\right] - W_{MTOW}\delta C_{T,M}\Delta M\upsilon = m_0 \Delta a_2^{BFS}$$

[306] $$\frac{1}{2}\kappa p_0 \delta M^2 S\left[-\frac{\dot{\beta}}{M}\left(C_{D,\dot{\beta}}\beta + C_{Q,\dot{\beta}}\right) - \left(C_{D,\alpha}\Delta\alpha + C_{D,\beta}\beta + C_{D,M}\Delta M + C_{D,p}\frac{p}{M} + C_{D,r}\frac{r}{M}\right)\beta - \left(C_{Q,\alpha}\Delta\alpha + C_{Q,\beta}\beta + C_{Q,M}\Delta M + C_{Q,p}\frac{p}{M} + C_{Q,r}\frac{r}{M}\right)\right] - W_{MTOW}\delta C_{T,M}\Delta M\upsilon = m_0 \Delta a_2^{BFS}$$

[307] $$M\dot{\beta} = -\frac{1}{C_{D,\dot{\beta}}\beta + C_{Q,\dot{\beta}}}\left[M^2\left[\left(C_{D,\alpha}\Delta\alpha + C_{D,\beta}\beta + C_{D,M}\Delta M + C_{D,p}\frac{p}{M} + C_{D,r}\frac{r}{M}\right)\beta + \left(C_{Q,\alpha}\Delta\alpha + C_{Q,\beta}\beta + C_{Q,M}\Delta M + C_{Q,p}\frac{p}{M} + C_{Q,r}\frac{r}{M}\right)\right] + \frac{W_{MTOW}C_{T,M}}{\frac{1}{2}\kappa p_0 S}\upsilon\Delta M + \frac{m_0}{\frac{1}{2}\kappa p_0 \delta}\Delta a_2^{BFS}\right]$$

[308] $$\frac{1}{C_{D,\dot{\beta}}\beta + C_{Q,\dot{\beta}}} = \frac{1}{C_{Q,\dot{\beta}}\left(1 + \frac{C_{D,\dot{\beta}}}{C_{Q,\dot{\beta}}}\beta\right)}$$

[309] $$|k| = \left|\frac{C_{D,\dot{\beta}}}{C_{Q,\dot{\beta}}}\right| < 1$$

Side force changes faster with a variation of AOS than drag does

[310] $$\frac{1}{C_{D,\dot{\beta}}\beta + C_{Q,\dot{\beta}}} = \frac{1}{C_{Q,\dot{\beta}}(1 + k\beta)} \approx \frac{1}{C_{Q,\dot{\beta}}}(1 - k\beta) \approx \frac{1}{C_{Q,\dot{\beta}}}$$

Taylor expansion

[311] $$M\dot{\beta} = -\frac{1}{C_{Q,\dot{\beta}}}\left[M^2\left[\left(C_{D,\alpha}\Delta\alpha + C_{D,\beta}\beta + C_{D,M}\Delta M + C_{D,p}\frac{p}{M} + C_{D,r}\frac{r}{M}\right)\beta + \left(C_{Q,\alpha}\Delta\alpha + C_{Q,\beta}\beta + C_{Q,M}\Delta M + C_{Q,p}\frac{p}{M} + C_{Q,r}\frac{r}{M}\right)\right] + \frac{W_{MTOW}C_{T,M}}{\frac{1}{2}\kappa p_0 S}\upsilon\Delta M + \frac{m_0}{\frac{1}{2}\kappa p_0 \delta}\Delta a_2^{BFS}\right]$$

[312] $$M\dot{\beta} = -\frac{1}{C_{Q,\dot{\beta}}}\left[\left(M^2C_{D,\alpha}\Delta\alpha + M^2C_{D,\beta}\beta + M^2C_{D,M}\Delta M + MC_{D,p}p + MC_{D,r}r\right)\beta + \left(M^2C_{Q,\alpha}\Delta\alpha + M^2C_{Q,\beta}\beta + M^2C_{Q,M}\Delta M + MC_{Q,p}p + MC_{Q,r}r\right) + \frac{W_{MTOW}C_{T,M}}{\frac{1}{2}\kappa p_0 S}\upsilon\Delta M + \frac{m_0}{\frac{1}{2}\kappa p_0 \delta}\Delta a_2^{BFS}\right]$$

Taking into account [263]:

[313] $$M\dot{\beta} = -\frac{1}{C_{Q,\dot{\beta}}}\left[M^2C_{D,\alpha}\Delta\alpha\beta + M^2C_{D,\beta}\beta^2 + M^2C_{D,M}\Delta M\beta + MC_{D,p}p\beta + MC_{D,r}r\beta + M^2C_{Q,\alpha}\Delta\alpha + M^2C_{Q,\beta}\beta + {M_0}^2\left(1 + 2\frac{\Delta M}{M_0}\right)C_{Q,M}\Delta M + MC_{Q,p}p + MC_{Q,r}r + \frac{W_{MTOW}C_{T,M}}{\frac{1}{2}\kappa p_0 S}\upsilon\Delta M + \frac{m_0}{\frac{1}{2}\kappa p_0 \delta}\Delta a_2^{BFS}\right]$$

[314] $$C_{y,M} = C_{Q,M} + \frac{W_{MTOW}C_{T,M}}{\frac{1}{2}\kappa p_0 S {M_0}^2}\upsilon$$

[315] $$M\dot{\beta} = -\frac{1}{C_{Q,\dot{\beta}}}\left(C_{D,\alpha}M^2\beta\Delta\alpha + C_{D,\beta}M^2\beta^2 + C_{D,M}M^2\beta\Delta M + C_{D,p}Mp\beta + C_{D,r}Mr\beta + C_{Q,\alpha}M^2\Delta\alpha + C_{Q,\beta}M^2\beta + {M_0}^2C_{y,M}\Delta M + 2M_0C_{Q,M}\Delta M^2 + C_{Q,p}Mp + C_{Q,r}Mr + \frac{m_0}{\frac{1}{2}\kappa p_0 \delta}\Delta a_2^{BFS}\right)$$

As these teachings show, a manufacturer of a fixed-wings AV can inexpensively generate an accurate APM of its aircraft. This APM may be employed for flight planning, simulation or design. Advantageously, the APM may continually be fine-tune and refine, should the payload or any other aspect of the AV geometry or mass configuration change.

These and other features, functions, and advantages that have been discussed can be achieved independently in various embodiments or may be combined in yet other embodiments.

## Claims

**1.** A computer-implemented method for modelling performance of a fixed-wing aerial vehicle (AV) with six degrees of freedom, sequentially comprising the steps of:

- collecting a first data set from a plurality of fuel consumption modelling measures (212) and determining a fuel consumption model (210) as a function of air density, temperature and throttle level based on the first data set;
- collecting a second data set from a plurality of thrust modelling maneuvers (222) in coordinated flight conditions comprising angle of sideslip-on-rudder, holding barometric altitude through an altitude-on-bank control loop, and speed-on-elevator control loop holding a throttle level constant and determining a thrust model (220) based on the second data set;
- collecting a third data set from a plurality of aerodynamic forces modelling maneuvers (232) and determining aerodynamic forces model (230) based on the third data set and on the thrust model previously determined;
- collecting a fourth data set from a plurality of propulsive moments modelling maneuvers (242) and inertia matrix modelling maneuvers (243) and determining propulsive moments model and inertia matrix (240) based on the fourth data set;
- collecting a fifth data set from a plurality of aerodynamics moments modelling maneuvers (252) and determining aerodynamics moments model (250) based on the fifth data set;

wherein modelling measures and modelling maneuvers are performed to modify an influence on the AV (100) of one or more variables of a model to be determined.

**2.** The computer-implemented method of claim 1, further comprising a step of measuring variables of a model with a state estimator (320) of the AV (100) and air data system (310) of the AV (100).

3. The computer-implemented method of claim 1 or 2, wherein determining a model further comprises applying a least square estimate to a collected data set.

4. The computer-implemented method of any claims 1 to 3, further comprising a step of configuring a flight control system to automatically perform modelling maneuvers in flight.

5. The computer-implemented method of any of claims 1 to 4, wherein modelling maneuvers (222,232,242,252) comprise at least one of the following control loops: AOS-on-rudder, altitude-on-bank speed-on-elevator, AOA-on-elevator, pitch rate-on-elevator and bank-on-ailerons.

6. The computer-implemented method of any claims 1 to 5, wherein fuel consumption modelling measures (212) are performed for a plurality of values of air density, outside air temperature (OAT) and throttle level.

7. The computer-implemented method of any claims 1 to 6, wherein thrust modelling maneuvers (222) are performed for a plurality of values of barometric altitude, mass variation and throttle level under a condition of coordinated flight.

8. The computer-implemented method of claim 7, wherein thrust modelling maneuvers (222) comprise an altitude-on-bank control loop and a speed-on-elevator control loop.

9. The computer-implemented method of any claims 1 to 8, wherein aerodynamic forces modelling maneuvers (232) comprise AOA-on-elevator, AOS-on-rudder and speed-on-elevator control loops.

10. The computer-implemented method of any claims 1 to 9, wherein propulsive moments modelling maneuvers (242) comprise AOS-on-rudder and bank-on-ailerons control loops under a condition of coordinated flight.

11. The computer-implemented method of any claims 1 to 10, wherein aerodynamic moments modelling maneuvers (252) comprise AOS-on-rudder, bank-on-ailerons and q-on-elevator control loops.

12. A system for modelling performance of a fixed-wing aerial vehicle (AV) with six degrees of freedom, the system comprising:

a collecting unit (330) configured to collect data from a plurality of modelling measures and modelling maneuvers;
a processing unit (340) configured to communicate with a collecting unit (330), wherein the processing unit (340) is further configured to sequentially process:

- a first data set from a plurality of fuel consumption modelling measures (212) and to determine a fuel consumption model (210) as a function of air density, temperature and throttle level based on the first data set;
- a second data set from a plurality of thrust modelling maneuvers (222) in coordinated flight conditions comprising angle of sideslip-on-rudder, holding barometric altitude through an altitude-on-bank control loop, and speed-on-elevator control loop holding a throttle level constant and to determine a thrust model (220) based on the second data set;
- a third data set from a plurality of aerodynamic forces modelling maneuvers (232) and to determine aerodynamic forces model (230) based on the third data set and on the thrust model previously determined;
- a fourth data set from a plurality of propulsive moments modelling maneuvers (242) and inertia matrix modelling maneuvers (243) and to determine propulsive moments model and inertia matrix (240) based on the fourth data set;
- a fifth data set from a plurality of aerodynamics moments modelling maneuvers (252) and to determine aerodynamics moments model (250) based on the fifth data set;

wherein modelling measures and modelling maneuvers are performed to modify an influence on the AV (100) of one or more variables of a model to be determined.

13. The system of claim 12, wherein the collecting unit (330) is further configured to instruct a state estimator (320) and air data system (310) to read out sensors values of the AV (100) during modelling maneuvers.

14. The system of claim 12 or 13, wherein the processing unit (340) is further configured to instruct a flight control system to automatically perform modelling maneuvers in flight.

**15.** A computer program product for modelling performance of a fixed-wing aerial vehicle (AV) with six degrees of freedom comprising computer code instructions that, when executed by a processor, causes the processor to perform the method of any of claims 1 to 11.

## Patentansprüche

**1.** Computerimplementiertes Verfahren zum Modellieren der Leistung eines Festflügel-Luftfahrzeugs (AV) mit sechs Freiheitsgraden, das nacheinander folgende Schritte umfasst:

- Sammeln eines ersten Datensatzes aus einer Vielzahl von Kraftstoffverbrauchsmodelliermessungen (212) und Bestimmen eines Kraftstoffverbrauchsmodells (210) als Funktion von Luftdichte, Temperatur und Drosselklappenniveau basierend auf dem ersten Datensatz;
- Sammeln eines zweiten Datensatzes aus einer Vielzahl von Schubmodelliermanövern (222) in koordinierten Flugbedingungen, umfassend den Winkel des Seitengleitflugs mit Seitenruder, das Einhalten der barometrischen Höhe durch einen Höhe-mit-Schräglage-Regelkreis und einen Geschwindigkeit-mit-Höhenruder-Regelkreis, der einen Drosselklappenniveau konstant hält und Bestimmen eines Schubmodells (220) basierend auf dem zweiten Datensatz;
- Sammeln eines dritten Datensatzes aus einer Vielzahl von aerodynamischen Kraftmodelliermanövern (232) und Bestimmen eines aerodynamischen Kraftmodells (230) basierend auf dem dritten Datensatz und dem zuvor bestimmten Schubmodell;
- Sammeln eines vierten Datensatzes aus einer Vielzahl von Vortriebsmoment-Modelliermanövern (242) und Trägheitsmatrix-Modelliermanövern (243) und Bestimmen von Vortriebsmoment-Modell und Trägheitsmatrix (240) basierend auf dem vierten Datensatz;
- Sammeln eines fünften Datensatzes aus einer Vielzahl von aerodynamischen Momentenmodelliermanövern (252) und Bestimmen eines aerodynamischen Momentenmodells (250) basierend auf dem fünften Datensatz;

wobei Modelliermessungen und Modelliermanöver durchgeführt werden, um einen Einfluss auf das AV (100) von einer oder mehreren Variablen eines zu bestimmenden Modells zu modifizieren.

**2.** Computerimplementiertes Verfahren nach Anspruch 1, ferner umfassend einen Schritt zum Messen von Variablen eines Modells mit einem Zustandsschätzer (320) des AV (100) und des Luftdatensystems (310) des AV (100).

**3.** Computerimplementiertes Verfahren nach Anspruch 1 oder 2, wobei das Bestimmen eines Modells ferner das Anwenden einer kleinsten-Quadrate-Schätzung auf einen gesammelten Datensatz umfasst.

**4.** Computerimplementiertes Verfahren nach einem der Ansprüche 1 bis 3, ferner umfassend einen Schritt zum Ausbilden eines Flugsteuerungssystems, um automatisch Modelliermanöver während des Fluges durchzuführen.

**5.** Computerimplementiertes Verfahren nach einem der Ansprüche 1 bis 4, wobei die Modelliermanöver (222, 232, 242, 252) mindestens einen der folgenden Regelkreise umfassen: AOS mit Seitenruder, Höhe mit Schräglage Geschwindigkeit mit Höhenruder, AOA mit Höhenruder, Nickgeschwindigkeit mit Höhenruder und Schräglage mit Querruder.

**6.** Computerimplementiertes Verfahren nach einem der Ansprüche 1 bis 5, wobei Kraftstoffverbrauchsmodelliermessungen (212) für eine Vielzahl von Werten der Luftdichte, der Außenlufttemperatur (OAT) und des Drosselklappenniveaus durchgeführt werden.

**7.** Computerimplementiertes Verfahren nach einem der Ansprüche 1 bis 6, wobei Schubmodelliermanöver (222) für eine Vielzahl von Werten der barometrischen Höhe, der Massenvariation und des Drosselklappenniveaus unter einer Bedingung eines koordinierten Fluges durchgeführt werden.

**8.** Computerimplementiertes Verfahren nach Anspruch 7, wobei die Schubmodelliermanöver (222) einen Höhe-mit-Schräglage-Regelkreis und einen Geschwindigkeit-mit-Höhenruder-Regelkreis umfassen.

**9.** Computerimplementiertes Verfahren nach einem der Ansprüche 1 bis 8, wobei die aerodynamischen Kraftmodelliermanöver (232) AOA-mit-Höhenruder-, AOS-mit-Seitenruder- und Geschwindigkeit-mit-Höhenruder-Regelkreise umfassen.

**10.** Computerimplementiertes Verfahren nach einem der Ansprüche 1 bis 9, wobei die Vortriebsmoment-Modelliermanöver (242) AOS-mit-Seitenruder- und Schräglage-mit-Querruder-Regelkreise unter der Bedingung eines koordinierten Fluges umfassen.

**11.** Computerimplementiertes Verfahren nach einem der Ansprüche 1 bis 10, wobei aerodynamische Momentmodelliermanöver (252) AOS-mit-Seitenruder-, Schräglage-mit-Querruder- und q-mit-Höhenruder-Regelkreise umfassen.

**12.** System zur Modellierung der Leistung eines Festflügel-Luftfahrzeugs (AV) mit sechs Freiheitsgraden, wobei das System Folgendes umfasst:

- eine Sammeleinheit (330), die ausgebildet ist, um Daten aus einer Vielzahl von Modelliermessungen und Modelliermanövern zu sammeln;
- eine Verarbeitungseinheit (340), die ausgebildet ist, um mit einer Sammeleinheit (330) zu kommunizieren, wobei die Verarbeitungseinheit (340) ferner ausgebildet ist, um sequentiell Folgendes zu verarbeiten:
- einen ersten Datensatz aus einer Vielzahl von Kraftstoffverbrauchsmodelliermessungen (212) und zum Bestimmen eines Kraftstoffverbrauchsmodells (210) als Funktion von Luftdichte, Temperatur und Drosselklappenniveau basierend auf dem ersten Datensatz;
- einen zweiten Datensatz aus einer Vielzahl von Schubmodelliermanövern (222) in koordinierten Flugbedingungen, umfassend den Winkel des Seitengleitflugs mit Seitenruder, das Einhalten der barometrischen Höhe durch einen Höhe-mit-Schräglage-Regelkreis und einen Geschwindigkeit-mit-Höhenruder-Regelkreis, der einen Drosselklappenniveau konstant hält und zum Bestimmen eines Schubmodells (220) basierend auf dem zweiten Datensatz;
- einen dritten Datensatz aus einer Vielzahl von aerodynamischen Kraftmodelliermanövern (232) und zum Bestimmen eines aerodynamischen Kraftmodells (230) basierend auf dem dritten Datensatz und dem zuvor bestimmten Schubmodell;
- einen vierten Datensatz aus einer Vielzahl von Vortriebsmoment-Modelliermanövern (242) und Trägheitsmatrix-Modelliermanövern (243) und zum Bestimmen von Vortriebsmoment-Modell und Trägheitsmatrix (240) basierend auf dem vierten Datensatz;
- einen fünften Datensatz aus einer Vielzahl von aerodynamischen Momentenmodelliermanövern (252) und zum Bestimmen eines aerodynamischen Momentenmodells (250) basierend auf dem fünften Datensatz;

wobei Modelliermessungen und Modelliermanöver durchgeführt werden, um einen Einfluss auf das AV (100) von einer oder mehreren Variablen eines zu bestimmenden Modells zu modifizieren.

**13.** System nach Anspruch 12, wobei die Sammeleinheit (330) ferner ausgebildet ist, um einen Zustandsschätzer (320) und ein Luftdatensystem (310) anzuweisen, Sensorwerte des AV (100) während Modelliermanövern auszulesen.

**14.** System nach Anspruch 12 oder 13, wobei die Verarbeitungseinheit (340) ferner ausgebildet ist, um ein Flugsteuerungssystem anzuweisen, automatisch Modelliermanöver während des Fluges durchzuführen.

**15.** Computerprogrammprodukt zur Modellierung der Leistung eines Festflügel-Luftfahrzeugs (AV) mit sechs Freiheitsgraden, umfassend Computercodeanweisungen, die, wenn sie von einem Prozessor ausgeführt werden, den Prozessor veranlassen, das Verfahren nach einem der Ansprüche 1 bis 11 durchzuführen.

## Revendications

**1.** Procédé mis en oeuvre par ordinateur pour la modélisation de la performance d'un véhicule aérien à voilure fixe (VA) avec six degrés de liberté, comprenant successivement les étapes consistant à :

- collecter un premier ensemble de données à partir d'une pluralité de mesures de modélisation de consommation de carburant (212) et déterminer un modèle de consommation de carburant (210) en fonction de la masse volumique de l'air, de la température et du niveau d'accélération sur la base du premier ensemble de données ;
- collecter un deuxième ensemble de données à partir d'une pluralité de manoeuvres de modélisation de poussée (222) dans des conditions de vol coordonnées comprenant un angle de glissade-sur-gouverne, en maintenant l'altitude barométrique moyennant une boucle de commande de l'altitude-sur-assiette latérale et une boucle de commande de la vitesse-sur-gouverne de profondeur en maintenant un niveau d'accélération constant et déterminer un modèle de poussée (220) basé sur le deuxième ensemble de données ;
- collecter un troisième ensemble de données à partir d'une pluralité de manoeuvres de modélisation de forces aérodynamiques (232) et déterminer un modèle de forces aérodynamiques (230) sur la base du troisième ensemble de données et du modèle de poussée déterminé précédemment ;
- collecter un quatrième ensemble de données à partir d'une pluralité de manoeuvres de modélisation de moments propulsifs (242) et de manoeuvres de modélisation de matrice d'inertie (243) et déterminer un modèle de moments propulsifs et une matrice d'inertie (240) sur la base du quatrième ensemble de données ;
- collecter un cinquième ensemble de données à partir d'une pluralité de manoeuvres de modélisation de moments aérodynamiques (252) et déterminer un modèle de moments aérodynamiques (250) sur la base du cinquième ensemble de données ;

dans lequel les mesures de modélisation et les manoeuvres de modélisation sont réalisées pour modifier une influence sur le VA (100) d'une ou plusieurs variables d'un modèle à déterminer.

**2.** Procédé mis en oeuvre par ordinateur selon la revendication 1, comprenant en outre une étape consistant à mesurer des variables d'un modèle avec un estimateur d'état (320) du VA (100) et un système de données aériennes (310) du VA (100).

**3.** Procédé mis en oeuvre par ordinateur selon la revendication 1 ou 2, dans lequel la détermination d'un modèle comprend en outre l'application d'une estimation des moindres carrés à un ensemble de données collectées.

**4.** Procédé mis en oeuvre par ordinateur selon l'une quelconque des revendications 1 à 3, comprenant en outre une étape consistant à configurer un système de commande de vol pour réaliser automatiquement des manoeuvres de modélisation en vol.

**5.** Procédé mis en oeuvre par ordinateur selon l'une quelconque des revendications 1 à 4, dans lequel les manoeuvres de modélisation (222, 232, 242, 252) comprennent au moins l'une des boucles de commande suivantes : angle de glissade, AOS-sur-gouverne, altitude-sur-assiette latérale vitesse-sur-gouverne de profondeur, angle d'attaque, AOA-sur-gouverne de profondeur, taux de tangage-sur-gouverne de profondeur et assiette latérale-sur-ailerons.

**6.** Procédé mis en oeuvre par ordinateur selon l'une quelconque des revendications 1 à 5, dans lequel les mesures de modélisation de consommation de carburant (212) sont mises en oeuvre pour une pluralité de valeurs de masse volumique de l'air, de température de l'air extérieur (OAT) et de niveau d'accélération.

**7.** Procédé mis en oeuvre par ordinateur selon l'une quelconque des revendications 1 à 6, dans lequel les manoeuvres de modélisation de poussée (222) sont mises en oeuvre pour une pluralité de valeurs d'altitude barométrique, de variation massique et de niveau d'accélération dans une condition de vol coordonné.

**8.** Procédé mis en oeuvre par ordinateur selon la revendication 7, dans lequel les manoeuvres de modélisation de poussée (222) comprennent une boucle de commande d'altitude-sur-assiette latérale et une boucle de commande de vitesse-sur-gouverne de profondeur.

**9.** Procédé mis en oeuvre par ordinateur selon l'une quelconque des revendications 1 à 8, dans lequel les manoeuvres de modélisation de forces aérodynamiques (232) comprennent un AOA-sur-gouverne de profondeur, des boucles de commande de AOS-sur-gouverne, et de vitesse-sur-gouverne de profondeur.

**10.** Procédé mis en oeuvre par ordinateur selon l'une quelconque des revendications 1 à 9, dans lequel les manoeuvres de modélisation de moments propulsifs (242) comprennent des boucles de commande de AOS-sur-gouverne et d'assiette latérale-sur-ailerons dans une condition de vol coordonné.

**11.** Procédé mis en oeuvre par ordinateur selon l'une quelconque des revendications 1 à 10, dans lequel les manoeuvres de modélisation de moments aérodynamiques (252) comprennent des boucles de commande de AOS-sur-gouverne, d'assiette latérale-sur-ailerons et de q-sur-gouverne de profondeur.

**12.** Système de modélisation de la performance d'un véhicule aérien à voilure fixe (VA) avec six degrés de liberté, le système comprenant :

- une unité de collecte (330) configurée pour collecter des données à partir d'une pluralité de mesures de modélisation et de manoeuvres de modélisation ;
- une unité de traitement (340) configurée pour communiquer avec une unité de collecte (330), dans lequel l'unité de traitement (340) est configurée en outre pour traiter successivement :
- un premier ensemble de données à partir d'une pluralité de mesures de modélisation de consommation de carburant (212) et pour déterminer un modèle de consommation de carburant (210) en fonction de la masse volumique de l'air, de la température et du niveau d'accélération sur la base du premier ensemble de données ;
- un deuxième ensemble de données à partir d'une pluralité de manoeuvres de modélisation de poussée (222) dans des conditions de vol coordonnées comprenant un angle de glissade-sur-gouverne, en maintenant l'altitude barométrique moyennant une boucle de commande de l'altitude-sur-assiette latérale et une boucle de commande de la vitesse-sur-gouverne de profondeur en maintenant un niveau d'accélération constant et pour déterminer un modèle de poussée (220) sur la base du deuxième ensemble de données ;
- un troisième ensemble de données à partir d'une pluralité de manoeuvres de modélisation de forces aérodynamiques (232) et pour déterminer un modèle de forces aérodynamiques (230) sur la base du troisième ensemble de données et du modèle de poussée déterminé précédemment ;
- un quatrième ensemble de données à partir d'une pluralité de manoeuvres de modélisation de moments propulsifs (242) et de manoeuvres de modélisation de matrice d'inertie (243) et pour déterminer un modèle de moments propulsifs et une matrice d'inertie (240) sur la base du quatrième ensemble de données ;
- un cinquième ensemble de données à partir d'une pluralité de manoeuvres de modélisation de moments aérodynamiques (252) et pour déterminer un modèle de moments aérodynamiques (250) sur la base du cinquième ensemble de données ;

dans lequel les mesures de modélisation et les manoeuvres de modélisation sont réalisées pour modifier une influence sur le VA (100) d'une ou plusieurs variables d'un modèle à déterminer.

**13.** Système selon la revendication 12, dans lequel l'unité de collecte (330) est configurée en outre pour instruire un estimateur d'état (320) et un système de données aériennes (310) à lire des valeurs de capteurs du VA (100) pendant des manoeuvres de modélisation.

**14.** Système selon la revendication 12 ou 13, dans lequel l'unité de traitement (340) est configurée en outre pour instruire un système de commande de vol à réaliser automatiquement des manoeuvres de modélisation en vol.

**15.** Produit de programme informatique pour la modélisation de la performance d'un véhicule aérien à voilure fixe (VA) avec six degrés de liberté comprenant des instructions de code informatique qui, lorsqu'elles sont exécutées par un processeur, pousse le processeur à mettre en oeuvre le procédé selon l'une quelconque des revendications 1 à 11.

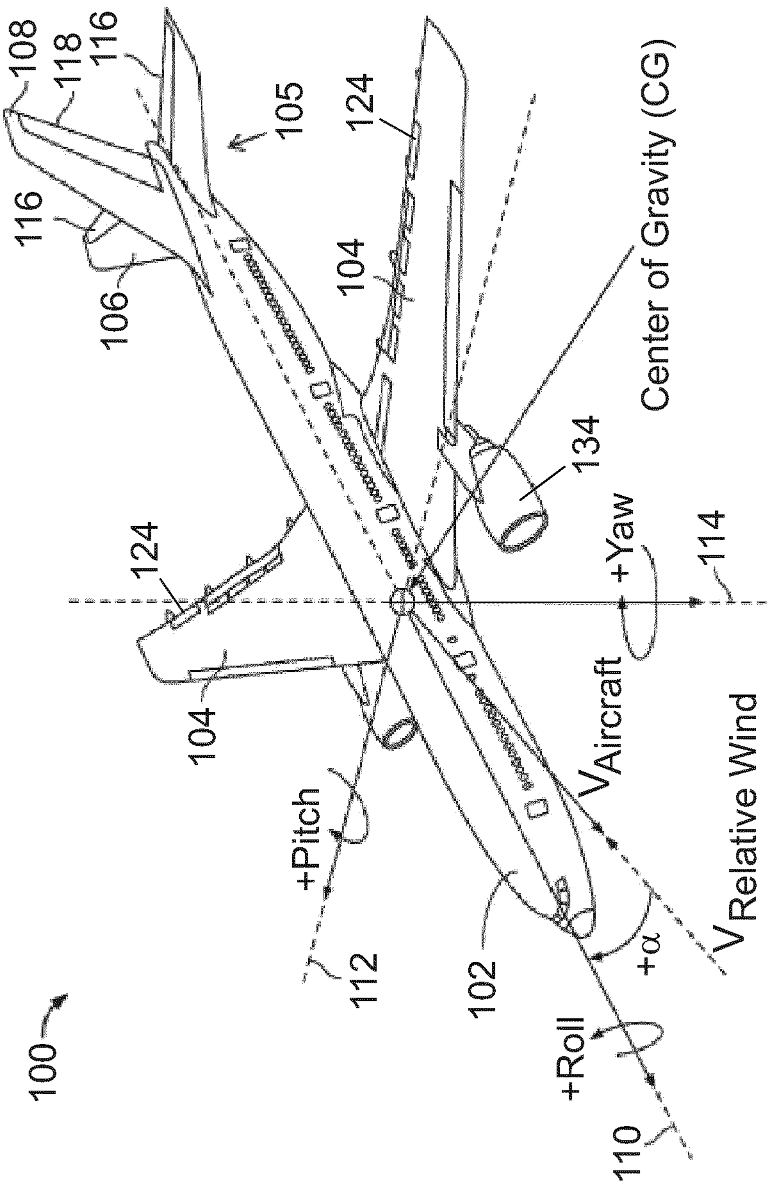
100
102
104
104
105
106
108
110
112
114
116
116
118
124
124
134
Center of Gravity (CG)
+Pitch
+Roll
+Yaw
$V_{Aircraft}$
$V_{Relative Wind}$
+α

Fig. 1

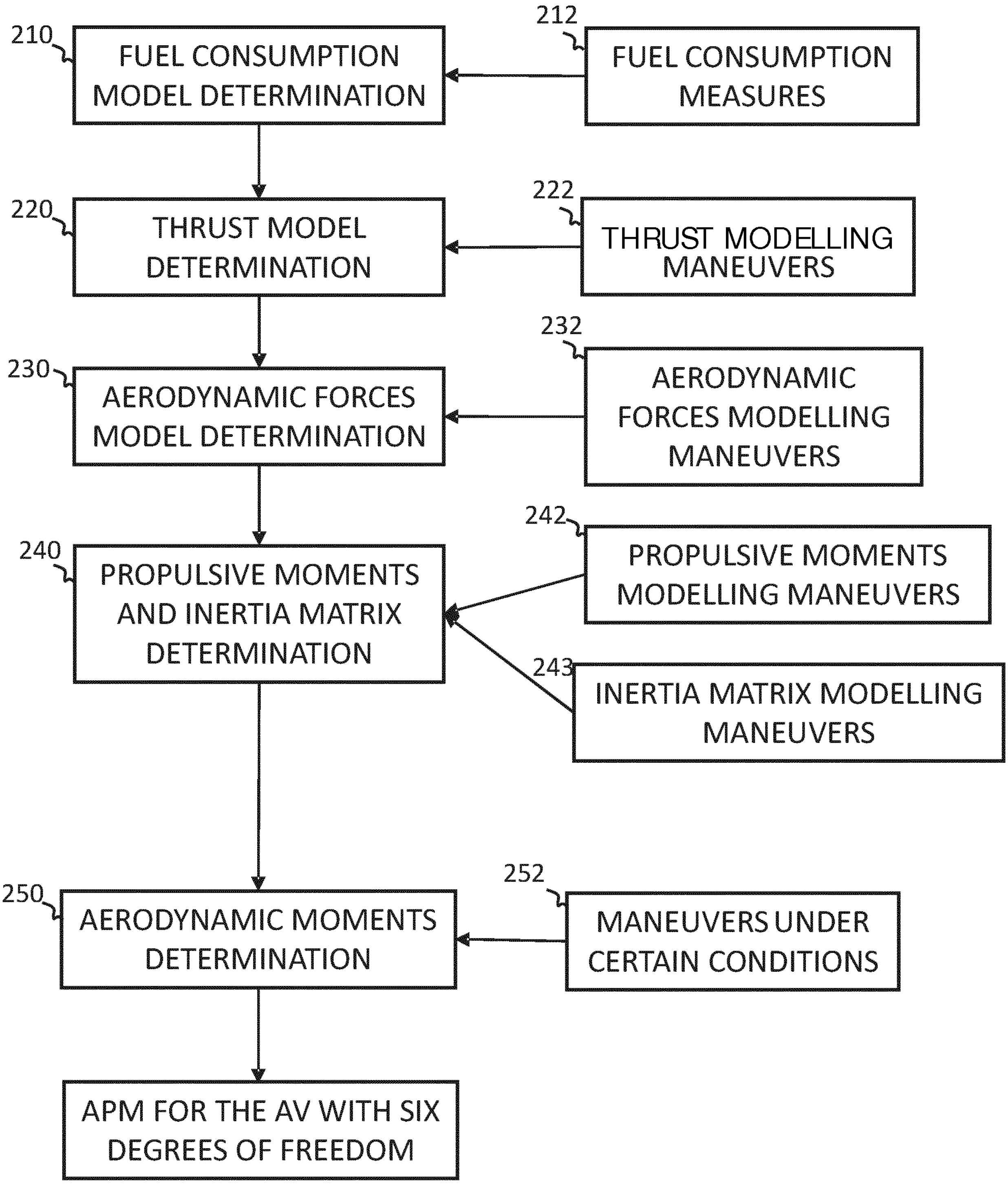
210
FUEL CONSUMPTION MODEL DETERMINATION
212
FUEL CONSUMPTION MEASURES
220
THRUST MODEL DETERMINATION
222
THRUST MODELLING MANEUVERS
230
AERODYNAMIC FORCES MODEL DETERMINATION
232
AERODYNAMIC FORCES MODELLING MANEUVERS
240
PROPULSIVE MOMENTS AND INERTIA MATRIX DETERMINATION
242
PROPULSIVE MOMENTS MODELLING MANEUVERS
243
INERTIA MATRIX MODELLING MANEUVERS
250
AERODYNAMIC MOMENTS DETERMINATION
252
MANEUVERS UNDER CERTAIN CONDITIONS
APM FOR THE AV WITH SIX DEGREES OF FREEDOM

Fig. 2

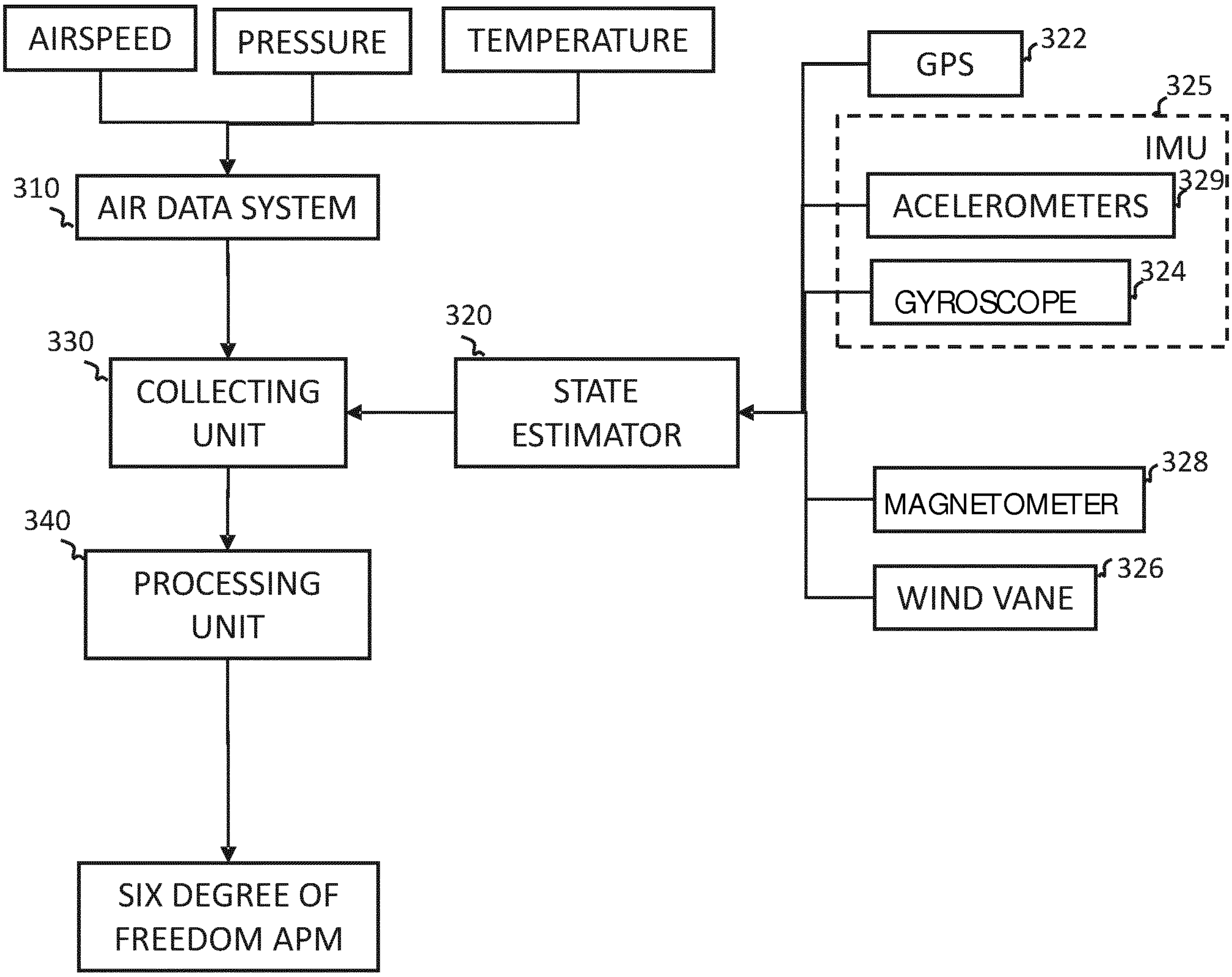
AIRSPEED
PRESSURE
TEMPERATURE
310
AIR DATA SYSTEM
330
COLLECTING UNIT
320
STATE ESTIMATOR
340
PROCESSING UNIT
SIX DEGREE OF FREEDOM APM
GPS
322
325
IMU
ACELEROMETERS
329
GYROSCOPE
324
MAGNETOMETER
328
WIND VANE
326

Fig. 3